# EUROPEAN PATENT APPLICATION

(11) **EP 4 852 683 A2**
(43) Date of publication of application: **09.12.2026**
(21) Application number: 26180894.3
(22) Date of filing: 26.05.2026
(51) Int. Cl.: H10K 59/80

(54) **LIGHT EMITTING DISPLAY DEVICE**

(30) Priority: 04.06.2025 KR 20250072828
(71) Applicant: Samsung Display Co., Ltd, Yongin-si, Gyeonggi-Do (KR)
(72) Inventor: Lee, Seon Uk, Yongin-si, Gyeonggi-do (KR); Lee, Jin Su, Yongin-si, Gyeonggi-do (KR); Kim, Rae-Young, Yongin-si, Gyeonggi-do (KR); Kim, Soodong, Yongin-si, Gyeonggi-do (KR); Choi, Kook Hyun, Yongin-si, Gyeonggi-do (KR); Choi, Yechan, Yongin-si, Gyeonggi-do (KR); Im, Choongyoul, Yongin-si, Gyeonggi-do (KR); Choi, Beohmrock, Yongin-si, Gyeonggi-do (KR)
(74) Representative: Gulde & Partner

(57) **Abstract**

A light emitting display device may include a substrate, an anode on the substrate, a pixel defining layer having a first opening and overlapping the anode, a light emitting layer within the first opening of the pixel defining layer, a cathode on the light emitting layer and the pixel defining layer, an encapsulation layer on the cathode, and a scattering layer on the encapsulation layer, including scattering particles, and including a scattering layer opening overlapping at least a portion of the first opening in a plan view, wherein a gap where the light emitting layer exposed by the first opening of the pixel defining layer overlaps the scattering layer in a three-color subpixel.

## Description

### BACKGROUND

### (a) Technical Field

Some example embodiments of the present disclosure relate to light emitting display devices.

### (b) Description of the Related Art

A display device displays images on a screen, and includes a liquid crystal display (LCD) or an organic light emitting diode (OLED) display. The display device is used for various electronic devices such as a portable phone, a GPS, a digital camera, an electronic book, a portable game device, or various terminals.

The display device such as the organic light emitting device may be folded or bent by using a flexible substrate.

In small electronic devices such as portable phones, optical elements such as cameras and optical sensors are formed in the bezel area around the display area, but as the size of the display screen is increased, the size of the peripheral area of the display area gradually decreases, and methods for allowing the camera and/or the optical sensor to be disposed on a rear surface of the display area are being developed.

### SUMMARY

A light emitting display device according to the independent claim is provided.

Some example embodiments of the present disclosure provide light emitting display devices for removing rainbow spots generated from a light emitting display device including a scattering layer.

Some example embodiments of the present disclosure provide light emitting display devices having constant luminance and/or colors irrespective of viewing angles.

Some example embodiments of the present disclosure provide light emitting display devices having constant reflectance and/or reflected colors with respect to positions.

An example embodiment of the present disclosure provides a light emitting display device that may include a substrate, an anode on the substrate, a pixel defining layer having a first opening, the first opening overlapping the anode, a light emitting layer within the first opening of the pixel defining layer, a cathode on the light emitting layer and the pixel defining layer, an encapsulation layer on the cathode, and a scattering layer on the encapsulation layer, the scattering layer may include scattering particles, the scattering layer may include a scattering layer opening, the scattering layer opening may overlap at least a portion of the first opening in a plan view, wherein a gap where the light emitting layer exposed by the first opening of the pixel defining layer may overlap the scattering layer in a three-color subpixel.

The scattering layer may cover a side wall of the pixel defining layer in a plan view.

The scattering layer opening may be in the first opening corresponding thereto in a plan view, and the first opening corresponding to the scattering layer opening may have a same planar shape as the scattering layer opening, a plurality of first openings including the first opening may be arranged at regular intervals.

The light emitting display device may further include a light blocking layer on the scattering layer, the light blocking layer including a second opening, and a color filter within the second opening of the light blocking layer.

The light emitting display device may further include a step-removing organic layer below the color filter, the step-removing organic layer including a transparent organic material, wherein the scattering layer opening and the first opening are within the second opening in a plan view, and a first thickness of a first portion of the color filter that overlaps the scattering layer opening in a plan view is equal to a second thickness of a second portion of the color filter that overlaps the first opening and the scattering layer.

The light emitting display device may further include a spacer above the pixel defining layer and below the cathode, wherein the spacer overlaps the light blocking layer in a plan view.

The light emitting display device may further include color filters corresponding to different colors, the color filters being on the scattering layer, wherein at least two of the color filters overlap in a light blocking region of the color filters, and one of the color filters is in a second opening of the light blocking region, the second opening overlapping the first opening in a plan view.

The light emitting display device may further include a step-removing organic layer below the color filter, the step-removing organic layer including a transparent organic material, wherein the scattering layer opening and the first opening are within the second opening in a plan view, and a first thickness of a first portion of each of the color filters that overlaps the scattering layer opening in a plan view and within the second opening is equal to a second thickness of a second portion of each of the color filters that overlaps the first opening and the scattering layer and is within the second opening.

The light emitting display device may further include a spacer above the pixel defining layer and below the cathode, wherein the spacer overlaps the light blocking region in a plan view.

Another example embodiment of the present disclosure provides a light emitting display device that may include a substrate, an anode on the substrate, a pixel defining layer having a first opening, the first opening overlapping the anode, a light emitting layer within the first opening of the pixel defining layer, a cathode on the light emitting layer and the pixel defining layer, an encapsulation layer on the cathode, a scattering layer on the encapsulation layer, the scattering layer may include scattering particles, the scattering layer may include a scattering layer opening, the scattering layer opening may overlap at least a portion of the first opening in a plan view, a step-removing organic layer on the scattering layer, the step-removing organic layer may include a transparent organic material, and color filters on the step-removing organic layer, wherein a first thickness of a first portion of each of the color filters that overlaps the scattering layer opening in a plan view may be equal to a second thickness of a second portion of each of the color filters that overlaps the first opening and the scattering layer in a plan view.

The light emitting display device may further include: a light blocking layer above the scattering layer and below the step-removing organic layer, the light blocking layer including a second opening, wherein one of the color filters overlaps the second opening of the light blocking layer in a plan view, the scattering layer opening is within the first opening in a plan view, and the scattering layer opening and the first opening are within the second opening in a plan view.

The light emitting display device may further include: a light blocking layer above the scattering layer and the step-removing organic layer and below the color filters, the light blocking layer including a second opening, wherein one of the color filters overlaps the second opening of the light blocking layer in a plan view, and the scattering layer opening is within the first opening in a plan view, and the scattering layer opening and the first opening are within the second opening in a plan view.

At least two of the color filters overlap each other in a light blocking region of each of the color filters, one of the color filters is in a second opening of the light blocking region, the second opening overlapping the first opening in a plan view is included, and the scattering layer opening is within the first opening in a plan view, and the scattering layer opening and the first opening are within the second opening in a plan view.

A plurality of gaps where the light emitting layer exposed by the first opening of the pixel defining layer overlaps the scattering layer in a plan view are same in the three-color subpixel.

A plurality of gaps where the light emitting layer exposed by the first opening of the pixel defining layer overlaps the scattering layer in a plan view are different from each other in the three-color subpixel.

Another example embodiment of the present disclosure provides an electronic device that may include a light emitting display device, wherein the light emitting display device may include a substrate, an anode on the substrate, a pixel defining layer having a first opening, the first opening overlapping the anode, a light emitting layer within the first opening of the pixel defining layer, a cathode on the light emitting layer and the pixel defining layer, an encapsulation layer on the cathode, and a scattering layer on the encapsulation layer, the scattering layer may include scattering particles, the scattering layer may include a scattering layer opening, the scattering layer opening may overlap at least a portion of the first opening in a plan view, and a plurality of gaps where the light emitting layer exposed by the first opening of the pixel defining layer overlaps the scattering layer in a plan view may be different from each other in the three-color subpixel.

The electronic device may further include a light blocking layer on the scattering layer, the light blocking layer including a second opening, and a color filter within the second opening of the light blocking layer.

The electronic device may further include a step-removing organic layer below the color filter, the step-removing organic layer including a transparent organic material, wherein the scattering layer opening and the first opening are within the second opening in a plan view, and a first thickness of a first portion of the color filter that overlaps the scattering layer opening in a plan view is equal to a second thickness of a second portion of the color filter that overlaps the first opening and the scattering layer in a plan view.

The electronic device may further include color filters corresponding to different colors, the color filters being on the scattering layer, wherein at least two of the color filters overlap in a light blocking region of each of the color filters, and one of the color filters is in a second opening of the light blocking region, the second opening overlapping the first opening in a plan view.

The electronic device may further include a step-removing organic layer below the color filters, the step-removing organic layer including a transparent organic material, wherein the scattering layer opening and the first opening are within the second opening in a plan view, and a first thickness of a first portion of the color filters that overlaps the scattering layer opening in a plan view and within the second opening is equal to a second thickness of a second portion of each of the color filters that overlaps the first opening and the scattering layer and is within the second opening.

According to the example embodiments, rainbow spots generated by interference of external light by the scattering layer and the anode may be removed by forming the opening in at least one scattering layer disposed within the display area of the light emitting display device.

According to the example embodiments, changes of luminance and/or colors may be varied by a desired (or alternatively, predetermined) level or below as the angle seen from the side changes by differently forming the overlapping degrees of the scattering layer and the light emitting layer as red, green, and/or blue.

According to the example embodiments, changes of reflectance and/or reflected colors occur according to the position in the light emitting display device by forming the step-removing organic layer on the lower portion of the color filter and allowing the constant thickness of the color filter.

According to the example embodiments, as a polarization plate is not used, luminance is not used when light is transmitted through the polarization plate, so the maximum luminance value of the light emitting display device is formed to be greater than 2500 nits, thereby providing the light emitting display device.

### BRIEF DESCRIPTION OF THE DRAWINGS

FIG. 1 shows a perspective view illustrating a use state of a display device according to an example embodiment.
FIG. 2 shows an exploded perspective view illustrating a display device according to an example embodiment.
FIG. 3 shows a cross-sectional view illustrating a display device according to an example embodiment.
FIG. 4 shows a block diagram illustrating a display device according to an example embodiment.
FIG. 5 shows a perspective view illustrating a light emitting display device according to another example embodiment.
FIG. 6 shows a top plan view illustrating an enlarged region of a light emitting display device according to an example embodiment.
FIG. 7 shows a top plan view illustrating a portion of a display panel according to an example embodiment.
FIG. 8 shows a cross-sectional view illustrating a display panel according to an example embodiment of FIG. 7.
FIG. 9 to FIG. 12 show characteristics of an example embodiment of FIG. 7 and FIG. 8.
FIG. 13 shows a cross-sectional view illustrating a display panel according to a modified example embodiment of FIG. 8.
FIG. 14 and FIG. 15 show cross-sectional views illustrating a display panel according to modified example embodiments of FIG. 8.
FIG. 16 shows a graph illustrating transmittance with respect to wavelengths of a color filter.
FIG. 17 and FIG. 18 show cross-sectional views illustrating a light emitting display device including the display panels of FIG. 8 and FIG. 15, respectively, according to some example embodiments.
FIG. 19 shows a cross-sectional view additionally illustrating the thickness of a color filter according to an example embodiment of FIG. 8.
FIG. 20 shows a top plan view illustrating a portion of a display panel according to another example embodiment.
FIG. 21 shows a cross-sectional view illustrating a display panel according to the example embodiment of FIG. 20.
FIG. 22 shows a table comparing characteristics according to the example embodiment of FIG. 20 and FIG. 21.
FIG. 23 to FIG. 26 show a cross-sectional view illustrating a display panel according to some modified example embodiments of FIG. 21.
FIG. 27 and FIG. 28 show cross-sectional views illustrating a light emitting display device according to an example embodiment of FIG. 21.
FIG. 29 shows a top plan view illustrating a portion of a display panel according to another example embodiment.
FIG. 30 to FIG. 34 show cross-sectional views illustrating a light emitting display device according to an example embodiment of FIG. 29.

### DETAILED DESCRIPTION

The present disclosure will be described more fully hereinafter with reference to the accompanying drawings, in which some example embodiments of the disclosure are shown. As those skilled in the art would realize, the described example embodiments may be modified in various different ways, all without departing from the spirit or scope of the present disclosure.

Parts that are irrelevant to the description will be omitted to clearly describe the present disclosure, and like elements will be designated by like reference numerals throughout the specification.

The size and thickness of each configuration shown in the drawings are arbitrarily shown to facilitate understanding and ease of description, but example embodiments of the present disclosure are not limited thereto. In the drawings, the thickness of layers, films, panels, regions, etc., are enlarged for clarity. The thicknesses of some layers and areas are exaggerated for convenience of explanation.

It should be understood that when an element such as a layer, film, region, or substrate is referred to as being "on" another element, it may be directly on the other element or intervening elements may also be present. In contrast, when an element is referred to as being "directly on" another element, there are no intervening elements present. The word "on" or "above" means disposed on or below the object portion, and does not necessarily mean disposed on the upper side of the object portion based on a gravitational direction.

Unless explicitly described to the contrary, the word "comprise," and variations such as "comprises" and "comprising," should be understood to imply the inclusion of stated elements but not the exclusion of any other elements.

The phrase "in a plan view" means viewing an object portion from the top, and the phrase "in a cross-sectional view" means viewing a cross-section of which the object portion is vertically cut from the side.

Throughout the specification, when it is stated that a part is "connected" to another part, the part may be directly connected to the other part, may be connected to the other part through a third part, or may be connected to the other part physically or electrically, and they may be referred to by different titles depending on positions or functions, but the portions that are substantially integrated into one body may be connected to each other.

When parts such as wires, layers, films, regions, plates, or constituent elements are said to extend in the "first direction or the second direction," this not only signifies a straight-line shape running straight in a corresponding direction, but also includes a structure generally extending in the first direction or the second direction, a structure bent on a desired (or alternatively, predetermined) portion, a zigzag-shaped structure, or a structure including a curved structure.

Electronic devices (e.g., mobile phones, TVs, monitors, laptop computers, etc.) including the display device and the display panel described in the present specification or electronic devices including the display device and the display panel manufactured by a manufacturing method described in the specification are not excluded from the claimed range of the present specification.

As used herein, expressions such as "one of," "one or more of," "any one of," "at least one of," "at least one among" and "at least one selected from" when preceding a list of elements, modify the entire list of elements and do not modify the individual elements of the list. Thus, for example, both "at least one of A, B, or C" and "at least one of A, B, and C" mean either A, B, C or any combination thereof. Likewise, A and/or B means A, B, or A and B.

While the term "same," "equal" or "identical" is used in description of example embodiments, it should be understood that some imprecisions may exist. Thus, when one element is referred to as being the same as another element, it should be understood that an element or a value is the same as another element within a desired manufacturing or operational tolerance range (e.g., ±10%).

When the term "about," "substantially" or "approximately" is used in this specification in connection with a numerical value, it is intended that the associated numerical value includes a manufacturing or operational tolerance (e.g., ±10%) around the stated numerical value. Moreover, when the word "about," "substantially" or "approximately" is used in connection with geometric shapes, it is intended that precision of the geometric shape is not required but that latitude for the shape is within the scope of the disclosure. Further, regardless of whether numerical values or shapes are modified as "about" or "substantially," it will be understood that these values and shapes should be construed as including a manufacturing or operational tolerance (e.g., ±10%) around the stated numerical values or shapes.

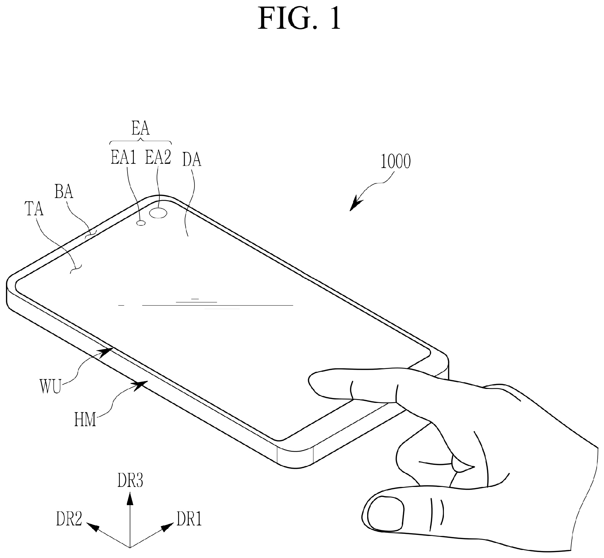

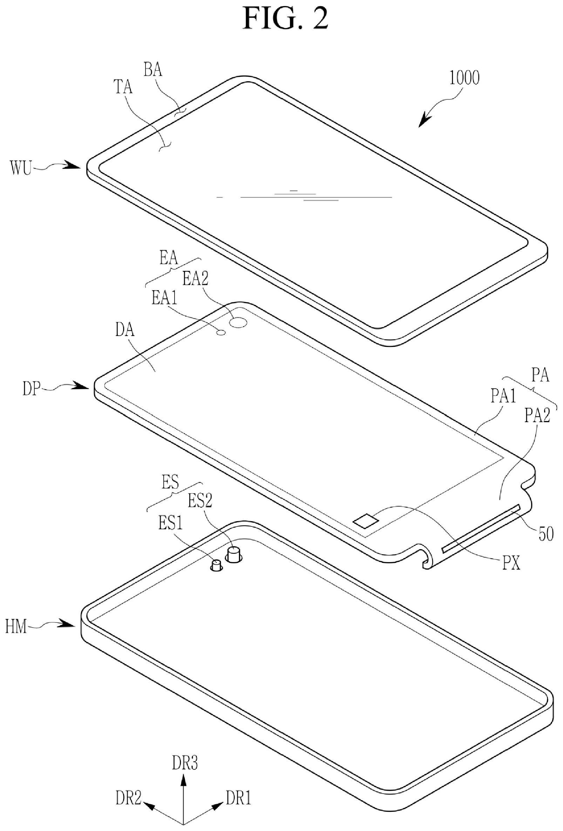

A structure of a display device will now be described with reference to FIG. 1 and FIG. 2.

FIG. 1 shows a perspective view on a use state of a display device according to an example embodiment, and FIG. 2 shows an exploded perspective view of a display device according to an example embodiment.

Referring to FIG. 1, the display device 1000 may display videos and still images, and may be used as a displaying screen of various types of products such as portable electronic devices including mobile phones, smartphones, tablet personal computers (PCs), mobile communication terminals, electronic purses, electronic books, portable multimedia players (PMPs), GPS, and ultra mobile PC (UMPCs), and televisions, laptops, monitors, billboards, and the internet of things (IOT). The display device 1000 may be used in the form of wearable devices such as smart watches, watch phones, glasses-type displays, or head mounted displays (HMDs). The display device 1000 may be used as a dashboard of a vehicle, a center information display (CID) disposed on a center fascia or the dashboard of the vehicle, a room mirror display replacing a side-view mirror of the vehicle, and a display disposed on a rear surface of a front seat for entertainment for a back seat of the vehicle. To facilitate comprehension and ease of description, FIG. 1 shows the display device 1000 being used as a smartphone.

The display device 1000 may display images on a display surface that is parallel to a first direction DR1 and a second direction DR2, toward a third direction DR3. The display surface for displaying images may correspond to a front surface of the display device 1000, and may correspond to a front surface of a cover window WU. The image may include videos and still images.

In the present example embodiment, the front surfaces (or upper surfaces) and the rear surfaces (or lower surfaces) of the members may be defined with respect to the direction in which images are displayed. The front surface may oppose the rear surface in the third direction DR3, and normal directions of the front surface and the rear surface may be parallel to the third direction DR3. A spaced distance between the front surface and the rear surface in the third direction DR3 may correspond to the thickness of the display panel in the third direction DR3.

The display device 1000 may sense an input (refer to a hand in FIG. 1) of a user applied from the outside. The input of the user may include various types of outside inputs such as the user's body parts, light, heat, or pressure. In an example embodiment, the user's input is shown as the user's hand applied to the front surface. However, example embodiments of the present disclosure are not limited thereto. The user's input may be provided in various forms, and the display device 1000 may sense the user's input applied to a lateral surface or a rear surface of the display device 1000 according to the structure of the display device 1000.

Referring to FIG. 1 and FIG. 2, the display device 1000 may include a cover window WU, a housing HM, a display panel DP, and an optical element ES. In an example embodiment, the cover window WU may be combined with the housing HM to configure an appearance of the display device 1000.

The cover window WU may include an insulation panel. For example, the cover window WU may be made of or include glass, plastic, or combinations thereof.

The front surface of the cover window WU may define a front surface of the display device 1000. A transmission area TA may be an optically transparent region. For example, the transmission area TA may have transmittance of visible rays of about 90% or more.

A blocking area BA may define a shape of the transmission area TA. The blocking area BA may be disposed near the transmission area TA and may surround the transmission area TA. The blocking area BA may have relatively low light transmittance compared to the transmission area TA. The blocking area BA may include a non-transparent material for blocking light. The blocking area BA may have a desired (or alternatively, predetermined) color. The blocking area BA may be defined by a bezel layer provided separately from the transparent substrate defining the transmission area TA, or may be defined by an ink layer formed by being inserted into or colored in the transparent substrate.

The display panel DP may include display pixels PX and a driver 50 to display images, and the display pixels PX may be disposed in a display area DA and a component area EA. The display panel DP may include a front surface including the display area DA and a peripheral area PA. In an example embodiment, the display area DA and the component area EA are regions where images are displayed, including pixels, and may be regions where a touch sensor is disposed on the upper side in the third direction DR3 of the pixels to detect external inputs.

The transmission area TA of the cover window WU may at least partly overlap the display area DA and the component area EA of the display panel DP. For example, the transmission area TA may overlap the front surface of the display area DA and the component area EA, or may overlap at least a portion of the display area DA and the component area EA. Accordingly, the user may recognize the image through the transmission area TA or may provide external inputs based on the image. However, example embodiments of the present disclosure are not limited thereto. For example, the region where the image is displayed and the region where the external input is detected may be separated from each other.

The peripheral area PA of the display panel DP may at least partly overlap the blocking area BA of the cover window WU. The peripheral area PA may be covered by the blocking area BA. The peripheral area PA may be adjacent to the display area DA and may surround the display area DA. The peripheral area PA may not display images, and driving circuits or driving wires for driving the display area DA may be arranged therein. The peripheral area PA may include a first peripheral area PA1 outside the display area DA, and a second peripheral area PA2 including the driver 50, connecting wires, and a bending area. In the example embodiment of FIG. 2, the first peripheral area PA1 is disposed on three sides of the display area DA, and the second peripheral area PA2 is disposed on the remaining one side of the display area DA.

In an example embodiment, the display panel DP may be assembled in a flat state in which the display area DA, the component area EA, and the peripheral area PA face the cover window WU. However, example embodiments of the present disclosure are not limited thereto. A portion of the peripheral area PA of the display panel DP may be bent. At this time, a portion of the peripheral area PA may be directed toward the rear surface of the display device 1000 so that the blocking area BA visible on the front surface of the display device 1000 may be reduced, and in FIG. 2, the second peripheral area PA2 may be bent and disposed on the rear surface of the display area DA, and may then be assembled.

Additionally, the component area EA of the display panel DP may include a first component area EA1 and a second component area EA2. The first component area EA1 and the second component area EA2 may be at least partly surrounded by the display area DA. The first component area EA1 and the second component area EA2 may be depicted as being spaced apart from each other, but are not limited thereto and may be at least partially connected. Optical elements (refer to ES in FIG. 2; also referred to as components) using infrared rays, visible rays, or sound may be disposed on lower portions of the first component area EA1 and the second component area EA2.

The display area DA (also referred to as the main display area) and the component area EA are formed with light emitting diodes and pixel circuit portions generating and transmitting light emitting current to the light emitting diodes. Here, one light emitting diode and one pixel circuit portion are referred to as a pixel PX. One pixel circuit portion and one light emitting diode may be formed one-to-one in the display area DA and the component area EA.

The first component area EA1 may include a transmitter for transmitting light and/or sound and a display portion including pixels. The transmitter may be disposed between adjacent pixels and may include a layer through which light and/or sound is transmitted. The transmitter may be disposed between adjacent pixels, and depending on some example embodiments, a layer transmitting no light such as a light blocking member may overlap the first component area EA1. The number of pixels per unit area (also referred to as resolution) of pixels included in the display area DA (also referred to as normal pixels) may be equal to the number of pixels per unit area of pixels included in the first component area EA1 (also referred to as first component pixels).

The second component area EA2 may include a region (also referred to as a light transmission area) made of a transparent layer that allows light to be transmitted therethrough, and the light transmission area may have a structure in which a conductive layer or a semiconductor layer is not disposed, and a layer including a light blocking material-for example, a pixel definition layer and/or a light blocking layer-includes an opening overlapping the position that corresponds to the second component area EA2, thereby not blocking light. The number of pixels per unit area of pixels included in the second component area EA2 (also referred to as a second component pixel) may be less than the number of pixels per unit area of normal pixels included in the display area DA. Thus, the resolution of the second component pixel may be lower than the resolution of the normal pixel.

The display panel DP may further include a touch sensor TS in addition to the display area DA including the display pixels PX. The display panel DP may be externally viewed by the user through the transmission area TA, including the pixel PX generating images. The touch sensor TS may be disposed on an upper portion of the pixel PX and may sense external inputs applied from the outside. The touch sensor TS may sense external inputs provided to the cover window WU.

Referring to FIG. 2, the second peripheral area PA2 may include a bending portion. The display area DA and the first peripheral area PA1 may be in a flat state substantially parallel to a plane defined by the first direction DR1 and the second direction DR2, and one side of the second peripheral area PA2 may extend from a flat state, to a bending state, and then to a flat state again. Thus, at least a portion of the second peripheral area PA2 may be assembled to be bent and disposed on the rear surface side of the display area DA. At least a portion of the second peripheral area PA2 overlaps the display area DA in the plane when assembled so that the blocking area BA of the display device 1000 may be reduced. However, example embodiments of the present disclosure are not limited thereto. For example, the second peripheral area PA2 may not be bent.

The driver 50 may be mounted on the second peripheral area PA2, may be mounted on the bending portion, or may be disposed on either side of the bending portion. The driver 50 may be provided in a chip form.

The driver 50 may be electrically connected to the display area DA and the component area EA and may transmit electrical signals to the pixels of the display area DA and the component area EA. For example, the driver 50 may provide data signals to the pixels PX disposed in the display area DA. In some example embodiments, the driver 50 may include a touch driving circuit and may be electrically connected to the touch sensor TS disposed in the display area DA and/or the component area EA. The driver 50 may include various circuits in addition to the circuits described above or may provide various electrical signals to the display area DA.

The display device 1000 may have a pad disposed at an end of the second peripheral area PA2, and may be electrically connected by the pad to a flexible printed circuit board FPCB including a driving chip. The driving chip disposed on the flexible printed circuit board FPCB may include various driving circuits for driving the display device 1000 and/or connectors for supplying power voltages. Depending on some example embodiments, a rigid printed circuit board (PCB) may be used instead of the flexible printed circuit board.

The optical element ES may be disposed on a lower portion of the display panel DP. The optical element ES may include a first optical element ES1 overlapping the first component area EA1 and a second optical element ES2 overlapping the second component area EA2. The first optical element ES1 may use infrared rays, and in this case, the first component area EA1 may have a light blocking member or other non-transparent layers overlapping the first component area EA1.

The first optical element ES1 may be replaced by an electronic element using light or sound, depending on some example embodiments. For example, instead of the first optical element ES1, it may be a sensor that receives and uses light such as an infrared sensor, a sensor that outputs and detects light or sound to measure distance or recognize fingerprints, a small lamp that outputs light, or a speaker that outputs sound. Electronic elements using light may use light with various wavelength bands, such as visible light, infrared rays, and ultraviolet rays.

The second optical element ES2 may be at least one of a camera, an infrared camera (IR camera), a dot projector, an infrared illuminator, or a time-of-flight sensor (ToF sensor).

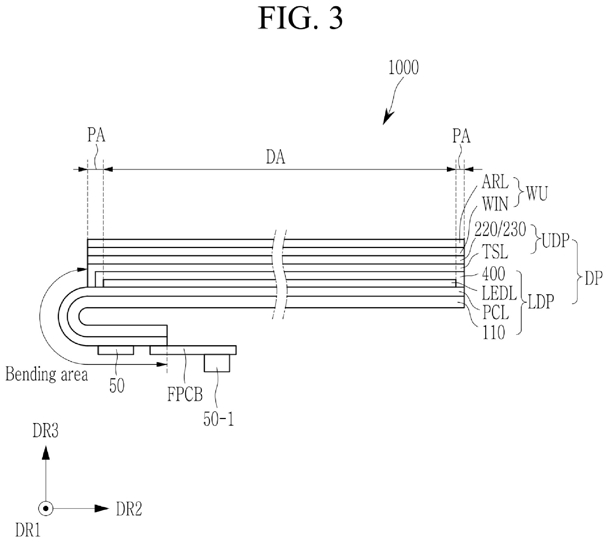

The light emitting display device described above may have a cross-sectional structure as shown in FIG. 3, and the cross-sectional structure will now be described with reference to FIG. 3.

FIG. 3 shows a cross-sectional view on a display device according to an example embodiment.

Referring to FIG. 3, the light emitting display device 1000 includes a display panel DP, which is largely divided into a lower panel layer LDP and an upper panel layer UDP, and a cover window WU disposed on the front surface of the display panel.

The lower panel layer LDP of the display panel DP may include a light emitting element layer LEDL in which light emitting diodes configuring a pixel PX are disposed on a substrate 110, and a pixel circuit layer PCL in which a pixel circuit portion for transmitting current to the light emitting diodes, which is disposed on the light emitting element layer LEDL, is disposed, and the pixel circuit layer PCL may be disposed between the substrate 110 and the light emitting element layer LEDL. The lower panel layer LDP further includes an encapsulation layer 400, and the light emitting element layer LEDL is covered by the encapsulation layer 400. Moisture and air are not introduced to the light emitting element layer LEDL because of the encapsulation layer 400, thereby protecting the light emitting element layer LEDL.

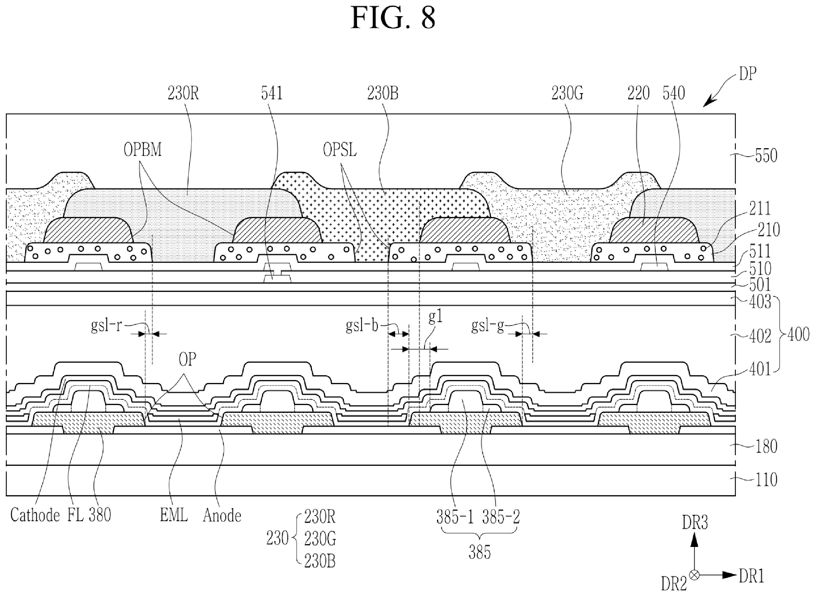

The upper panel layer UDP of the display panel DP may include a touch sensing layer TSL, and the light blocking layer and a color filter layer 220/230. The touch sensing layer TSL may include a sensing insulation layer (refer to 501, 510, 511 in FIG. 8) and sensing electrodes (see 540 and 541 in FIG. 8). The light blocking layer 220 and the color filter layer 230 may be disposed of by the light blocking layer (refer to 220 in FIG. 8) and the color filter (refer to 230 in FIG. 8), and the scattering layer (refer to 210 in FIG. 8) may also be disposed.

Regarding the light blocking layer and color filter layer 220/230, the light blocking layer 220 of FIG. 8 and the color filter 230 of FIG. 8 are disposed, and a scattering layer 210 of FIG. 8 may also be disposed.

The structure will now be described as follows.

The substrate 110 may be a base substrate or a base member, and may be a flexible substrate capable of bending, folding, rolling, etc. For example, the substrate 110 may include a polymer resin such as polyimide (PI), but is not limited thereto. In another example embodiment, the substrate 110 may include a glass material or a metallic material.

The pixel circuit layer PCL may be disposed on the substrate 110. The pixel circuit layer PCL may include thin-film transistors configuring a pixel circuit portion of the pixel PX, and may further include capacitors. The pixel circuit layer PCL may include wires connected to the pixel circuit portion, such as scan lines, data lines, and/or power voltage lines. Each of the thin-film transistors may include a semiconductor region, a source electrode, a drain electrode, and a gate electrode. The pixel circuit layer PCL may be disposed in the display area DA, and depending on some example embodiments, it may be disposed in some regions of the peripheral area PA or some regions of the bending area.

The light emitting element layer LEDL may be disposed on the pixel circuit layer PCL. The light emitting element layer LEDL may include light emitting diodes including an anode, a cathode, and a light emitting layer and emitting light, and a pixel defining layer defining a light emitting region. Light emitting elements of the light emitting element layer LEDL may be disposed in the display area DA.

In an example embodiment, the light emitting layer may be an organic light emitting layer including an organic material. The upper and lower portions of the light emitting layer may include at least one functional layers such as a hole transport layer, a hole injection layer, an electron transport layer, and/or an electron injection layer. When the current flows between the anode and the cathode, holes and electrons may move to the light emitting layer through the hole transport layer and electron transport layer, respectively, and may be combined with each other on the light emitting layer to emit light.

Accordingly, in an example embodiment, the light emitting element may include a quantum dot light emitting diode including a quantum dot light emitting layer, an inorganic light emitting diode including an inorganic semiconductor, or a micro-light emitting diode.

The encapsulation layer 400 may cover an upper surface and a side surface of the light emitting element layer LEDL and may protect the light emitting element layer LEDL. The encapsulation layer 400 may include at least one inorganic layer and at least one organic layer for encapsulating the light emitting element layer LEDL.

The touch sensing layer TSL may be disposed on the encapsulation layer 400. The touch sensing layer TSL may include sensing electrodes for detecting a user's touch with a capacitive type, and sensing lines for connecting the sensing electrodes and a touch driver 50-1. Depending on some example embodiments, the touch sensing layer TSL may detect the user's touch using either mutual capacitance or self-capacitance.

Depending on some example embodiments, the touch sensing layer TSL may be formed on a separate substrate disposed on the light emitting element layer LEDL. In this case, the substrate supporting the touch sensing layer TSL may function as an encapsulation substrate for encapsulating the light emitting element layer LEDL, and if the encapsulation substrate is disposed, the encapsulation layer 400 may be omitted.

The sensing electrodes of the touch sensing layer TSL may not overlap the light emitting region and may be covered and disposed of with a light blocking layer, etc., to be described later.

The light blocking layer and color filter layer 220/230 may be disposed on the touch sensing layer TSL and may include a light blocking layer (refer to 220 in FIG. 8) and a color filter (refer to 230 in FIG. 8). Depending on some example embodiments, the scattering layer (refer to 210 in FIG. 8) may also be disposed. The light blocking layer may have a position covering the sensing electrode and not overlapping the light emitting region, and the color filter may overlap the light emitting region to which the color filter of each color corresponds to and thus improve the color of light emitted by the light emitting diode.

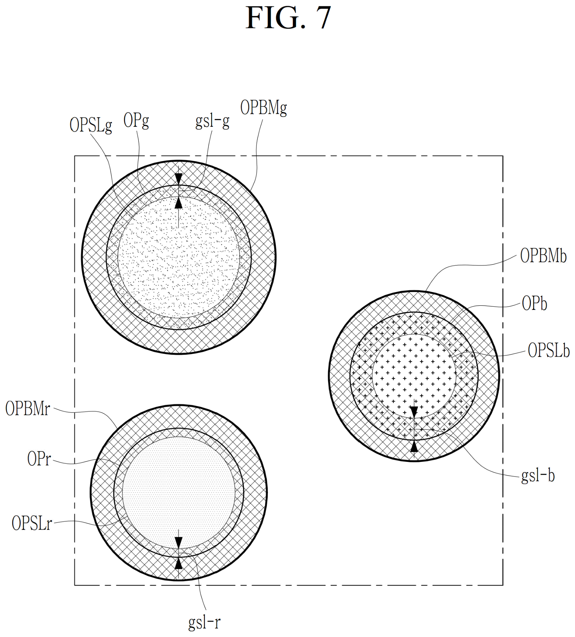

The light blocking layer and color filter layer 220/230 may have a structure for reducing reflection of external light so that external light flowing into the display device 1000 is not reflected back and transmitted to the user's eyes. This will be described in detail with reference to FIG. 7.

The substrate 110 may include a bending area and may be bent toward the rear surface, and the driver 50 may be disposed on one surface of the bent substrate 110 and may be electrically connected to the flexible printed circuit board FPCB to which the touch driver 50-1 is attached.

The driver 50 may output signals and voltages for driving the display panel DP. The driver 50 may supply data voltages to data lines, may supply power voltages to power lines such as a driving voltage line, and may supply control signals such as a clock signal so that a scan signal to be applied to a scan line may be generated. The driver 50 may be formed as an integrated circuit (IC) and may be mounted on the display panel DP using a chip-on-glass (COG) method, a chip-on-plastic (COP) method, or an ultrasonic junction method. For example, the driver 50 may be disposed in the direction opposite to the third direction DR3 of the display area DA by bending the substrate 110, and may be disposed on the rear surface of the display area DA. Depending on some example embodiments, the driver 50 may be mounted on the flexible printed circuit board FPCB.

The flexible printed circuit board FPCB may be attached to a pad portion of the display panel DP using an anisotropic conductive film (ACF). A pad portion of the flexible printed circuit board FPCB may be electrically connected to the pad portion of the display panel DP. The flexible printed circuit board FPCB may be a flexible printed circuit board, a printed circuit board, or a flexible film such as a chip on film.

The touch driver 50-1 may be mounted on the flexible printed circuit board FPCB. The touch driver 50-1 may be electrically connected to the sensing electrodes of the touch sensing layer TSL from among the display panel DP to supply driving signals to the sensing electrodes, and may detect the change in capacitance between the sensing electrodes to determine whether a touch has occurred. The touch driver 50-1 may be formed as an IC.

The cover window WU may be disposed on the front surface of the display panel DP, and the cover window WU may include a window WIN and an antireflection layer ARL.

The window WIN may be disposed on the light blocking layer and color filter layer 220/230 and may be attached to the light blocking layer and color filter layer 220/230 by a transparent adhesive. The window WIN may protect the display panel DP. The window WIN may be made of a transparent material. The window WIN may be made of, for example, glass or plastic.

When the window WIN includes glass, the glass may be ultra-thin glass (UTG) or thin glass. The ultra-thin glass may be strengthened to have a desired (or alternatively, predetermined) stress profile on its inside. The reinforced ultra-thin glass is better at reducing or preventing cracks, crack propagation, and breakage due to external impact than before it is strengthened. In other words, tempered ultra-thin glass is more effective than non-tempered ultra-thin glass in reducing or preventing cracking, crack propagation, and breakage due to external impact. The ultra-thin glass strengthened through a strengthening process (e.g., a reinforcement process) may have different stresses in different regions.

When glass is made of an ultra-thin film or thin film, it may have flexible characteristics and may be bent, folded, or rolled. The thickness of the glass may range from, about 10µm to about 300µm. For example, glass with a thickness of about 10µm to about 100µm or about 50µm may be applied. The glass of the window WIN may include soda lime glass, alkali aluminosilicate glass, borosilicate glass, or lithium aluminosilicate glass. The glass of the window WIN may include chemically strengthened or thermally strengthened glass so that it has relatively high strength. Chemical strengthening may be achieved through an ion exchange process in an alkaline salt. The ion exchange process may be performed at least twice. The window WIN may be a thin film of glass coated on both sides of a polymer film.

The antireflection layer ARL may be disposed on the front surface of the window WIN, and the antireflection layer ARL may be attached to the front surface of the window WIN in the form of an optical film.

The antireflection layer ARL may be disposed in the window WIN. The antireflection layer ARL may protect the window WIN and may reduce reflection of external light.

The antireflection layer ARL may include a hard coating layer and a low-refraction layer, and may prevent or reduce reflection of external light by forming two layers with different refractive indices so that external light is lost or destructive interference occurs at the interface. The low-refraction layer may have particles dispersed in a transparent resin. Depending on some example embodiments, a high-refraction layer may additionally be included, and the high-refraction layer may be disposed between the hard coating layer and the low-refraction layer. The low-refraction layer and the high-refraction layer are determined relative to a certain refractive index.

The hard coating layer, the low-refraction layer, and/or the high-refraction layer included in the antireflection layer ARL may have the following characteristics.

The hard coating layer may improve reliability issues by reducing distortion or lifting of the antireflection layer ARL under relatively harsh conditions such as relatively high temperature and/or relatively high humidity.

The hard coating layer may include an organic layer. The organic layer may include at least one of an acrylate-based compound, a urethane-based compound, polyimide, polycarbonate, polyether sulfone, polyethylene naphthalate, poly phenylene sulfide, liquid crystal polymer (LCP), polymethyl methacrylate, an epoxy-based polymer, or combinations thereof.

In another example embodiment, the hard coating layer may include an organic layer and an organic/inorganic composite layer. In this case, the organic layer may include an acrylate-based compound. For example, the organic layer may be formed of or include urethane acrylate. The organic layer may function as a stress buffer layer.

Among the organic/inorganic composite layers, the organic material may be formed from at least one of an acrylate-based compound, a polyurethane compound, an epoxy compound, or combinations thereof. For example, the organic material may include urethane acrylate. Among the organic/inorganic composite layers, the inorganic material may be at least one of silicon oxide (SiO2), zirconium oxide (ZrO2), aluminum oxide (Al2O3), tantalum oxide (Ta2O5), niobium oxide (Nb2O5 or NbO2), or glass beads.

The inorganic material may be provided in the form of a single type of the inorganic oxide or a mixture of the inorganic oxides listed above. The inorganic material may be available in various forms to form organic/inorganic composite layers. For example, the silicon oxide may be provided in the form of particles, sol or hollow shapes.

In the organic/inorganic composite layer, the acrylate-based compound, which is the organic material, and the inorganic particle may be provided mixed in a weight ratio of about 5:5 to about 8:2. By including both the acrylate-based compounds and the inorganic particles, the organic/inorganic composite layer may improve surface hardness, may have impact absorption on external impacts, and/or may form a hard coating layer that is not easily broken.

In an example embodiment, the hard coating layer may include an acrylate-based compound and a urethane-based compound. The acrylate-based compound and the urethane-based compound may be mixed in a monomer form and may be polymerized. The acrylate-based compound may increase the hardness of the low-refraction layer, thereby increasing the hardness and wear resistance of the antireflection layer ARL. The urethane-based compound may increase the elasticity of the antireflection layer ARL by imparting flexibility to the low-refraction layer. In this case, the ratio of the acrylate-based compound in the hard coating layer may be 70% to 99.9%, and the ratio of the urethane-based compound may be 0.1% to 30%. For example, the mixing ratio of the acrylate-based compound and the urethane-based compound may be 7:3 or more, and the ratio of the acrylate-based compound may be further increased. For example, the mixing ratio of the acrylate-based compound and the urethane-based compound may be 7:3, 8:2, or 9:1, which signifies that the ratio of the acrylate-based compound is further increased.

In another example embodiment, the hard coating layer may include an acrylate-based compound. The acrylate-based compound may be acryl resin. That is, the hard coating layer may improve the hardness and wear resistance of the antireflection layer ARL by including acrylic resin.

The thickness of the hard coating layer may be about 2µm to about 10µm. The hard coating layer is made in the above-noted thickness range, which may reduce distortion and/or lifting phenomena, thereby improving reliability issues.

The refractive index of the hard coating layer may be about 1.48 to about 1.53. The hard coating layer is formed to have a refractive index within the refractive index range, and thus has a difference in refractive index at the interface with the low-refraction layer described later, thereby refracting light emitted from the light emitting element layer upward, and increasing light emission efficiency and reducing reflection of external light.

The low-refraction layer may be disposed on the hard coating layer. The low-refraction layer may increase light output efficiency and/or reduce reflection of external light by refracting light emitted from the light emitting element layer upward.

The low-refraction layer may include particles dispersed in the transparent resin.

The resin may include at least one of acryl, polysiloxane, polyurethane, polyurethane acrylate, polyimide, polymethylsilsesquioxane (PMSSQ), or poly(methyl methacrylate) (PMMA).

The particles may be hollow particles. For example, the particles may include at least one of silica (SiO2), magnesium fluoride (MgF2), or iron oxide (Fe3O4). The particles may include a shell made of one or more of the materials and a cavity inside the shell. In an example embodiment, the diameter of the particles may be about 10 nm to about 200 nm, and the thickness of the shell and the diameter of the cavity may be determined according to the diameter of the particles.

The particles included in the low-refraction layer may be included in the weight ratio of about 10% to about 50% with respect to the resin. When the weight ratio of particles to resin is about 10% or more, the refractive index of the low-refraction layer may be lowered, and when it is about 50% or less, the adherence to adjacent layers may be reduced or prevented from deteriorating. The low-refraction layer may be formed by coating a solution including a solvent in which resin and particles are dispersed and curing the same.

The thickness of the low-refraction layer may be about 10 nm to about 200 nm. The low-refraction layer is formed with the thickness range, so it may include sufficient particles to lower the refractive index and improve the adhesive strength with the lower layer.

The refractive index of the low-refraction layer may be less than the refractive index of the hard coating layer. For example, the refractive index of the low-refraction layer may be less than the refractive index of the hard coating layer by about 0.05 or more. When the difference between the refractive index of the low-refraction layer and the refractive index of the hard coating layer is about 0.05 or more, the total internal reflection of external light at the interface of the low-refraction layer and the hard coating layer may be increased, inducing destructive interference with the light reflected from the surface of the low-refraction layer. Accordingly, the reflectance of external light of the antireflection layer ARL may be reduced. The refractive index of the low-refraction layer may range from about 1.3 to about 1.43. However, it is not limited to this, and a lower refractive index may be used within a range smaller than the refractive index of the hard coating layer.

The high-refraction layer may include an inorganic material, an organic material, or an inorganic material and an organic material. Therefore, the high-refraction layer may be made of an inorganic layer, an organic layer, or an organic layer including inorganic particles.

The inorganic material included in the high-refraction layer may be at least one of zinc oxide, titanium oxide, zirconium oxide, niobium oxide, tantalum oxide, tin oxide, nickel oxide, silicon oxide, silicon nitride, indium nitride, or gallium nitride.

The organic material included in the high-refraction layer may be at least one of poly(3,4-ethylenedioxythiophene) (PEDOT), 4,4'-bis[N-(3-methylphenyl)-N-phenylamino]biphenyl (TPD), 4,4',4"-tris[(3-methylphenyl)phenyl aminotriphenylamine (m-MTDATA), 1,3,5-tris[N,N-bis(2-methylphenyl)-amino]-benzene (o-MTDAB), 1,3,5-tris[N,N-bis(3-methylphenyl)-amino]-benzene (m-MTDAB), 1,3,5-tris[N,N-bis(4-methylphenyl)-amino]-benzene (p-MTDAB), 4,4'-bis [N,N-bis(3-methylphenyl)-amino]-diphenylmethane (BPPM), 4,4'-dicarbazolyl-1,1'-biphenyl (CBP), 4,4',4"-tris (N-carbazole)triphenylamine (TCTA), 2,2',2"- (1,3,5-benzenetolyl)tris-[1-phenyl-1H-benzoimidazole] (TPBI), or 3-(4-biphenyl)-4-phenyl-5-t-butylphenyl-1,2,4-triazole (TAZ).

The refractive index of the high-refraction layer may be greater than that of the low-refraction layer to reduce reflection of external light. For example, the refractive index of the high-refraction layer may be greater than the refractive index of the low-refraction layer by at least 0.05. The refractive index of the high-refraction layer may be in the range of about 1.53 to about 1.7. However, it is not limited to this, and a larger refractive index may be used within a larger range than the refractive index of the low-refraction layer.

The thickness of the high-refraction layer may be about 50 nm to about 200 nm. The high-refraction layer may be formed in the above-noted range of thickness, thereby forming a flat interface with the low-refraction layer and reducing or preventing the bonding strength with the hard coating layer from deteriorating.

The antireflection layer ARL further including a high-refraction layer may further reduce reflection of external light by increasing the difference of the refractive index at the interface with the low-refraction layer.

Depending on some example embodiments, the front surface of the window WIN may further include an optical film other than the antireflection layer ARL, and may also include an anti-fingerprint layer. However, the polarization plate is not included because the light blocking layer and color filter layer 220/230 to be described later lowers the of external light and makes it difficult for the user to see. Accordingly, depending on some example embodiments, the front surface of the window WIN may not include the antireflection layer ARL.

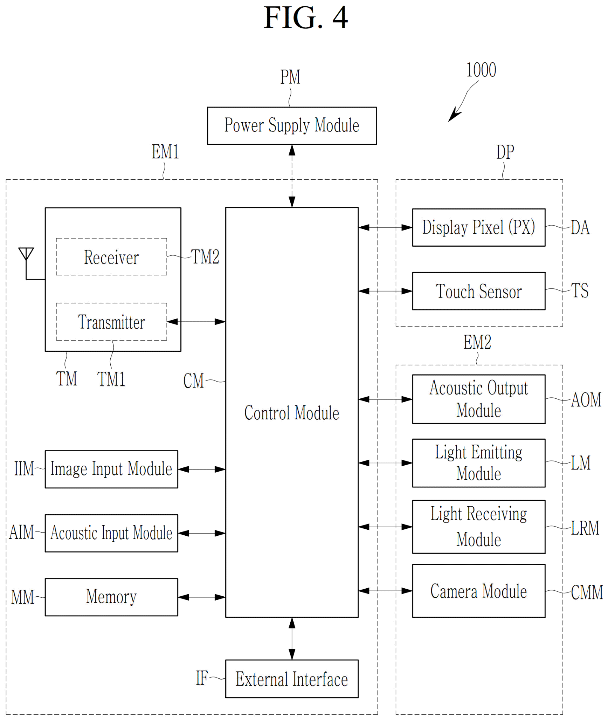

A display device according to an example embodiment will now be described using a block diagram of FIG. 4.

FIG. 4 shows a block diagram of a display device according to an example embodiment.

Referring to FIG. 4, the display device 1000 may include a display panel DP, a power supplying module PM, a first electronic module EM1, and a second electronic module EM2. The display panel DP, the power supplying module PM, the first electronic module EM1, and the second electronic module EM2 may be electrically connected to each other. FIG. 4 shows a display pixel PX and a touch sensor TS disposed in a display area DA of the configuration of the display panel DP.

The power supplying module PM may supply a power voltage for general operation of the display device 1000. The power supplying module PM may include a conventional battery module.

The first electronic module EM1 and the second electronic module EM2 may include various types of function modules for operating the display device 1000. The first electronic module EM1 may be directly mounted on a motherboard electrically connected to the display panel DP or may be mounted on an individual substrate, and may be electrically connected to the motherboard through a connector (not shown).

The first electronic module EM1 may include a control module CM, a wireless communication module TM, an image input module IIM, an acoustic input module AIM, a memory MM, and an external interface IF. Some of the modules may not be mounted on the motherboard and may be electrically connected to the motherboard through the flexible printed circuit substrate connected thereto.

The control module CM may control general operation of the display device 1000. The control module CM may be a microprocessor. For example, the control module CM may activate or deactivate the display panel DP. The control module CM may control other modules such as the image input module IIM or the acoustic input module AIM based on touch signals received from the display panel DP.

The wireless communication module TM may transmit/receive radio signals to/from other terminals by using Bluetooth or Wi-Fi lines. The wireless communication module TM may transmit/receive voice signals by using general communication lines. The wireless communication module TM includes a transmitter TM1 for modulating signals and transmitting signals, and a receiver TM2 for demodulating received signals.

The image input module IIM may process video signals to convert them into image data displayable on the display panel DP. The acoustic input module AIM may receive external acoustic signals by a microphone in a recording mode or a voice recognition mode and may convert them into electrical voice data.

The external interface IF may function as an interface connected to an external charger, a wired/wireless data port, and/or a card socket (e.g., a memory card, a SIM/UIM card), etc.

The second electronic module EM2 may include an acoustic output module AOM, a light emitting module LM, a light receiving module LRM, and a camera module CMM, and at least some thereof may be disposed as optical elements ES on a rear surface of the display panel DP as shown in FIG. 1 and FIG. 2. The optical element ES may include the light emitting module LM, the light receiving module LRM, and the camera module CMM. The second electronic module EM2 may be mounted on the motherboard, may be mounted on an additional substrate and may be electrically connected to the display panel DP through a connector (not shown), or may be electrically connected to the first electronic module EM 1.

The acoustic output module AOM may convert the acoustic data received from the wireless communication module TM or the acoustic data stored in the memory MM and may output them to the outside.

The light emitting module LM may generate light and may output it. The light emitting module LM may output infrared rays. For example, the light emitting module LM may include an LED element. For example, the light receiving module LRM may sense infrared rays. The light receiving module LRM may be activated when infrared rays that are greater than a desired (or alternatively, predetermined) level are sensed. The light receiving module LRM may include a CMOS sensor. The infrared rays generated by the light emitting module LM may be output and may be reflected by an external object (e.g., the user's finger or face), and the reflected infrared rays may be introduced to the light receiving module LRM. The camera module CMM may photograph external images.

In an example embodiment, the optical element ES may further include a photosensor or a heat sensor. The optical element ES may sense the external object received through the front surface or may provide sound signals such as voice to the outside through the front surface. The optical element ES may include elements, and is not limited to one example embodiment.

Referring to FIG. 2, the housing HM may be combined with the cover window WU. The cover window WU may be arranged on the front surface of the housing HM. The housing HM may be combined with the cover window WU and may provide a desired (or alternatively, predetermined) receiving space. The display panel DP and the optical element ES may be received in a desired (or alternatively, predetermined) receiving space provided between the housing HM and the cover window WU.

The housing HM may include a material with relatively high rigidity. For example, the housing HM may include glass, plastic, or metal, or may include frames and/or plates formed by combinations thereof. The housing HM may stably protect the elements of the display device 1000 received in the internal space from external impacts.

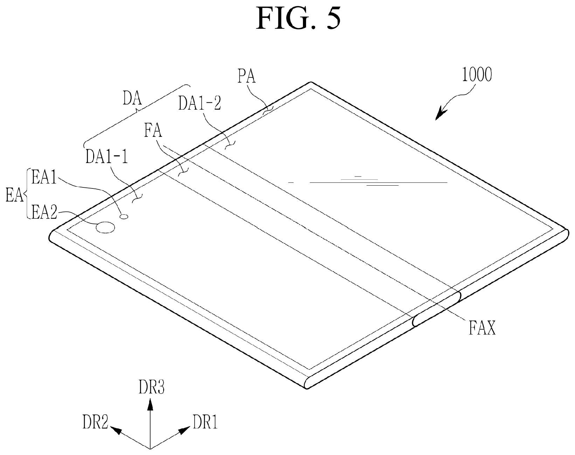

A structure of the display device 1000 according to another example embodiment will now be described with reference to FIG. 5.

FIG. 5 shows a perspective view illustrating a light emitting display device according to another example embodiment.

Descriptions of the same configuration as the constituent elements described above will be omitted, and the example embodiment of FIG. 5 shows a foldable display device having a structure in which the display device 1000 is folded through a folding axis FAX.

Referring to FIG. 5, in an example embodiment, the display device 1000 may be a foldable display device. The display device 1000 may be folded outward or inward based on the folding axis FAX. When folded outward based on the folding axis FAX, the display surface of the display device 1000 may be disposed to the outside in the third direction DR3 so that images may be displayed in both directions. When folded inward on the basis of the folding axis FAX, the display surface may not be visually recognized from the outside.

In an example embodiment, the display device 1000 may include the display area DA, the component area EA, and the peripheral area PA. The display area DA may be divided into a first-1 display area DA1-1, a first-2 display area DA1-2, and a folding area FA. The first-1 display area DA1-1 and the first-2 display area DA1-2 may be disposed to the left and right, respectively, based on (or centered on) the folding axis FAX, and the folding area FA may be disposed between the first-1 display area DA1-1 and the first-2 display area DA1-2. When folded outward based on the folding axis FAX, the first-1 display area DA1-1 and the first-2 display area DA1-2 may be disposed on both sides of an axis of the third direction DR3, and may display images in both directions. When folded inward with respect to the folding axis FAX, the first-1 display area DA1-1 and the first-2 display area DA1-2 may be invisible from the outside.

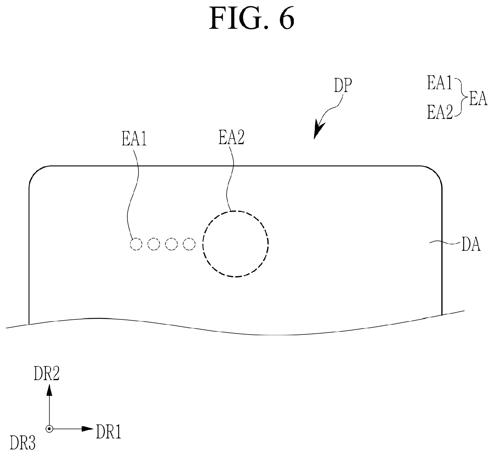

FIG. 6 shows a top plan view illustrating an enlarged region of a light emitting display device according to an example embodiment.

FIG. 6 shows part of the light emitting display panel DP from among light emitting display devices according to an example embodiment, by using a display panel for a mobile phone.

The display area DA is disposed on the front surface of the light emitting display panel DP, and the component area EA is disposed in the display area DA. For example, the component area EA may include the first component area EA1 and the second component area EA2. In the example embodiment of FIG. 6, the first component area EA1 may be disposed near the second component area EA2. The first component area EA1 is disposed to the left of the second component area EA2. The position and the number of the first component area EA1 may vary depending on some example embodiments. In FIG. 6, the second optical element ES2 corresponding to the second component area EA2 may be a camera, and the first optical element ES1 corresponding to the first component area EA1 may be a photosensor.

A plurality of light emitting diodes LED and pixel circuits for generating light emitting currents and transmitting the same to the light emitting diodes LEDs are formed in the display area DA. One light emitting diode LED and one pixel circuit are referred to as a pixel PX. In the display area DA, one pixel circuit and one light emitting diode LED are formed one to one. The display area DA is also referred to as a normal display area. FIG. 6 does not show the structure of the light emitting display panel DP given under a cutting-plane line, but the display area DA may be disposed under the cutting-plane line.

The light emitting display panel DP according to an example embodiment may be largely divided into a lower panel layer and an upper panel layer. The lower panel layer is the part where the light emitting diode and the pixel circuit constituting the pixel are disposed, and may include an encapsulation layer (refer to 400 of FIG. 8) covering the same. That is, the lower panel layer covering from the substrate (refer to 110 of FIG. 8) to the encapsulation layer includes an anode, a pixel defining layer (refer to 380 of FIG. 8), an emission layer or light emitting layer (refer to EML of FIG. 8), a spacer (refer to 385 of FIG. 8), a functional layer (refer to FL of FIG. 8), and a cathode (refer to a cathode of FIG. 8) and includes an insulating layer between the substrate and the anode, a semiconductor layer, and a conductive layer. The upper panel layer may be disposed on an upper portion of the encapsulation layer, and may include a sensing insulation layer (refer to 501, 510, and 511 of FIG. 8) and sensing electrodes (refer to 540 and 541 of FIG. 8) for sensing touches, and may include a light blocking layer (refer to 220 of FIG. 8), a scattering layer (refer to 210 of FIG. 8), a color filter (refer to 230 of FIG. 8), and a planarization layer (refer to 550 of FIG. 8).

The first component area EA1 may be made of a transparent layer to allow light to be transmitted therethrough, and the conductive layer or the semiconductor layer may not be disposed thereon to allow light to be transmitted therethrough, and the first component area EA1 may not block light by allowing the lower panel layer to have a photosensor region, and forming an opening (also referred to as an additional opening) in a position that corresponds to the first component area EA1 of the pixel defining layer, the light blocking layer, and the color filter layer of the upper panel layer. When the photosensor region is disposed in the lower panel layer and there is no corresponding opening in the upper panel layer, the region may be in the display area DA and not in the first component area EA1. One first component area EA1 may include adjacent photosensor regions, and in this case, pixels adjacent to the photosensor region may be included in the first component area EA1. When the first optical element ES1 corresponding to the first component area EA1 uses infrared rays instead of visible rays, the first component area EA1 may overlap the light blocking layer 220 for blocking the visible rays.

The second component area EA2 may include a second component pixel and a light transmitting area, and a space between adjacent second component pixels may be the light transmitting area.

A scattering layer (refer to 210 of FIG. 8) may be disposed in the first component area EA1 and the second component area EA2, an opening may be formed in the scattering layer, and at least a portion or an entirety of the scattering layer may be removed.

Although not shown in FIG. 6, a peripheral area may be further disposed outside the display area DA. FIG. 6 shows a display panel for a mobile phone, but the present example embodiment may be applied to a display panel capable of disposing the optical element on the rear surface of the display panel, and may it be a flexible display device. In the case of a foldable display device from among flexible display devices, the positions of the second component area EA2 and the first component area EA1 may be formed at different positions from FIG. 5.

Another example embodiment in which widths of the scattering layer overlapping the light emitting layer exposed by the opening of the pixel defining layer are different from each other for each color in a three-color subpixel in a plan view will now be described with reference to FIG. 7.

For example, an example embodiment will be described in which openings OPr, OPg, and OPb (also referred to as first openings) of the pixel defining layer 380, second openings OPBMr, OPBMg, and OPBMb of the light blocking layer 220, and openings OPSLr, OPSLg, and OPSLb of the scattering layer 210 are formed to have circles with the same center according to the structure of the light emitting display panel DP formed in the display area DA, the openings OPSLr, OPSLg, and OPSLb of the scattering layer 210, the openings OPr, OPg, and OPb of the pixel defining layer 380, and the second openings OPBMr, OPBMg, and OPBMb of the light blocking layer 220 may be formed in that order, and gaps gsl-r, gsl-g, and gsl-b where the scattering layer 210 overlaps the openings OPr, OPg, and OPb of the pixel defining layer 380, respectively, are different from each other in red, green, and blue.

FIG. 7 shows a top plan view illustrating a portion of a display panel according to an example embodiment.

FIG. 7 shows the openings OPr, OPg, and OPb of the pixel defining layer 380 corresponding to the red, green, and blue subpixels belonging to one unit pixel, the second openings OPBMr, OPBMg, and OPBMb of one light blocking layer 220 corresponding thereto, and the openings OPSLr, OPSLg, and OPSLb of a scattering layer 210. Referring to FIG. 7, the pixel defining layer 380 is disposed outside the openings OPr, OPg, and OPb of the pixel defining layer 380, the light blocking layer 220 is disposed outside the second openings OPBMr, OPBMg, and OPBMb of the light blocking layer 220, and the scattering layer 210 is disposed outside the openings OPSLr, OPSLg, and OPSLb of the scattering layer 210. FIG. 7 shows the gaps gsl-r, gsl-g, and gsl-b where the scattering layer 210 and the openings OPr, OPg, and OPb of the pixel defining layer 380 overlap each other in the red, green, and blue subpixels, and the overlapping gaps gsl-r, gsl-g, and gsl-b are shown as differing from each other. Here, r, g, and b may correspond to red, green, and blue, respectively.

In FIG. 7, the opening OPr for red, the opening OPg for green, and the opening OPb for blue of the pixel defining layer 380 and the second opening OPBMr for red, the second opening OPBMg for green, and the second opening OPBMb for blue of the light blocking layer 220 may each be formed to have circles with different radii depending on the sizes of the openings OPSLr, OPSLg, and OPSLb of the corresponding scattering layer 210. Among the openings OPr, OPg, and OPb, the second openings OPBMr, OPBMg, and OPBMb, and the openings OPSLr, OPSLg, and OPSLb of the scattering layer 210, a group of openings associated with the same color may have the same radius and may be formed with the same size, or may be formed with two or more different sizes. Referring to FIG. 7, the openings OPSLr, OPSLg, and OPSLb of the scattering layer 210 and the corresponding openings OPr, OPg, and OPb of the pixel defining layer 380 may have the same planar shape and may be arranged at regular intervals in a plan view. The gaps gsl-r, gsl-g, and gsl-b where the scattering layer 210 and the openings OPr, OPg, and OPb of the pixel defining layer 380 overlap are the same, but may be formed in different sizes depending on some example embodiments.

In the example embodiment of FIG. 7, all the openings are depicted as circular, but depending on some example embodiments, at least some of the openings may be formed in a planar shape such as an ellipse, a closed curve similar to a circle, or a polygon. The gaps gsl-r, gsl-g, and gsl-b where the scattering layer 210 and the openings OPr, OPg, and OPb of the pixel defining layer 380 overlap with each other may have different values in different colored subpixels.

The openings OPr, OPg, and OPb of one pixel defining layer 380 correspond to the openings OPSLr, OPSLg, and OPSLb of one scattering layer 210 and the second openings OPBMr, OPBMg, and OPBMb of one light blocking layer 220. That is, the openings OPSLr, OPSLg, and OPSLb of the scattering layer 210 corresponding to the second openings OPBMr, OPBMg, and OPBMb of the light blocking layer 220, respectively, and the openings OPr, OPg, and OPb of the pixel defining layer 380 are disposed in the second openings OPBMr, OPBMg, and OPBMb of the light blocking layer 220, respectively. The second openings OPBMr, OPBMg, and OPBMb of the light blocking layer 220, the openings OPSLr, OPSLg, and OPSLb of the scattering layer 210, and the openings OPr, OPg, and OPb of the pixel defining layer 380 may overlap each other, respectively, in a plan view. In other words, the second opening OPBMr of the light blocking layer 220, the opening OPSLr of the scattering layer 210, and the openings OPr of the pixel defining layer 380 may overlap each other in a plan view, the second opening OPBMg of the light blocking layer 220, the opening OPSLg of the scattering layer 210, and the openings OPg of the pixel defining layer 380 may overlap each other in a plan view, and the second opening OPBMb of the light blocking layer 220, the opening OPSLb of the scattering layer 210, and the openings OPb of the pixel defining layer 380 may overlap each other in a plan view

In FIG. 7, additional hatching is drawn to indicate the portion of the scattering layer 210 that is not obscured by the light blocking layer 220 and is visible on the front surface. This hatching may represent the scattering layer 210 not covered by the light blocking layer 220 throughout the present specification, thereby indicating a portion where light may be scattered by scattering particles 211 in FIG. 8. Three different hatchings are used to represent the red, green, and blue light emitting layers that may be exposed by the openings OPr, OPg, and OPb of the pixel defining layer 380 in FIG. 7, respectively. In the example embodiment of FIG. 7, it may be seen that some of the light emitting layers exposed by the openings OPr, OPg, and OPb of the pixel defining layer 380 overlap the scattering layer 210, and some of the remaining ones of the light emitting layers do not overlap the scattering layer 210.

In the example embodiment of FIG. 7, the openings OPr, OPg, and OPb of the pixel defining layer 380 and the second openings OPBMr, OPBMg, and OPBMb of the light blocking layer 220 are formed in a circular planar shape, and the openings OPSLr, OPSLg, and OPSLb of the scattering layer 210 are also formed in a circular planar shape, and the three openings may have the same center.

In the example embodiment of FIG. 7, the radius values of the circular shapes of the openings OPr, OPg, and OPb of the pixel defining layer 380 may be larger than the radius values of the elliptical shapes of the openings OPSLr, OPSLg, and OPSLb of the scattering layer 210, respectively, and the radius values of the circular shapes of the second openings OPBMr, OPBMg, and OPBMb of the light blocking layer 220 may be larger than the radius values of the openings OPSLr, OPSLg, and OPSLb of the scattering layer 210 and the radius values of the openings OPr, OPg, and OPb of the pixel defining layer 380, respectively. Depending on some example embodiment, the openings OPSLr, OPSLg, and OPSLb of the scattering layer 210 may be smaller than the second openings OPBMr, OPBMg, and OPBMb of the light blocking layer 220, respectively, by about 1 µm or more, and may be smaller than the openings OPr, OPg, and OPb of the pixel defining layer 380, respectively, by about 10 µm or less. In this way, the boundary portions of the openings OPr, OPg, and OPb of the pixel defining layer 380 are covered by the scattering layer 210, and the openings OPSLr, OPSLg, and OPSLb of the scattering layer 210 are formed in the remaining light emitting layer. When external light enters the inside and is reflected at various angles from the side wall of the pixel defining layer 380, color separation occurs. The scattering particles 211 of the scattering layer 210 scatter the external light, making it difficult for the user to see the color-separated reflected light, and generated rainbow spots may be weakened or removed.

In the present example embodiment, the widths (corresponding to the gaps gsl-r, gsl-g, and gsl-b where the scattering layer 210 and the openings OPr, OPg, and OPb of the pixel defining layer 380 overlap) of the scattering layer 210 covering the light emitting layer exposed by the openings OPr, OPg, and OPb of the pixel defining layer 380, respectively, may be different depending on the color of the emitted light. In the example embodiment of FIG. 7, the gap gsl-r where the scattering layer 210 and the opening OPr of the pixel defining layer 380 overlap in the red subpixel is the smallest, the gap gsl-g where the scattering layer 210 and the opening OPg of the pixel defining layer 380 overlap in the green subpixel is the next smallest, and the gap gsl-b where the scattering layer 210 and the opening OPb of the pixel defining layer 380 overlap in the blue subpixel is the largest. However, depending on some example embodiments, the color of the largest one of the gaps gsl-r, gsl-g, or gsl-b where the scattering layer 210 and the openings OPr, OPg, and OPb of the pixel defining layer 380 overlap may be green or red, and the size order may also be formed in various ways, unlike FIG. 7. The gaps gsl-r, gsl-g, and gsl-b where the scattering layer 210 and the openings OPr, OPg, and OPb of the pixel defining layer 380 overlap may be determined according to the size or radius of the openings OPSLr, OPSLg, and OPSLb of the scattering layer 210 formed in the subpixel of each color.

In the example embodiment of FIG. 7, the openings OPSLr, OPSLg, and OPSLb of the scattering layer 210 are formed for subpixels of all colors, but depending on some example embodiments, the openings OPSLr, OPSLg, and OPSLb of the scattering layer 210 may not be formed for one or two colors, and the light emitting layer of the corresponding color may be covered by the scattering layer 210. The arrangement of the openings OPSLr, OPSLg, and OPSLb of the scattering layer 210 may be arranged to have a specific period or may be arranged randomly.

The thickness or haze value of the scattering layer 210 may be the same for all colors, and may be formed to have different thickness and/or haze values depending on the color, depending on some example embodiments.

The planar structure has been described with reference to FIG. 7. A stacking structure of the light emitting display panel DP according to an example embodiment will now be described with reference to FIG. 8.

FIG. 8 shows a cross-sectional view illustrating a display panel according to an example embodiment of FIG. 7.

The light emitting display panel DP may display images by forming a light emitting diode on the substrate 110, may include sensing electrodes 540 and 541 to detect touches, and may include a light blocking layer 220 and color filters 230R, 230G, and 230B so that light emitted from the light emitting diode has color characteristics of the color filters 230R, 230G, and 230B. The example embodiment of FIG. 8 may further include a scattering layer 210 below the light blocking layer 220, and the scattering layer 210 may include scattering particles 211 such that light may be reflected or refracted from the scattering particles 211. The scattering layer 210 may be a colorless and light transmitting layer not having a color in the visible light band. For example, the scattering layer 210 may include a colorless and light transmitting organic material such as an acryl-based resin, and depending on some example embodiments, the scattering layer 210 may include a transparent photosensitive organic material. The scattering particles 211 may be formed of or include a material having a different refractive index from the scattering layer 210, and may include, for example, at least one of titanium oxide (TiO2), silicon oxide (SiO2), zirconium oxide (Zr2O3), aluminum oxide (Al2O3), hollow silica, an acrylate-based material, or a silicon-based material. The hollow silica may have a structure in which the inside of particles of silicon oxide (SiO2) having a three-dimensional shape such as a sphere has an empty space.

In the example embodiment of FIG. 8, the gaps gsl-r, gsl-g, and gsl-b where the scattering layer 210 overlaps the light emitting layer EML exposed by the openings OPr, OPg, and OPb (also referred to as first openings) of the pixel defining layer 380 have different values depending on the color of the exposed light. For example, in the example embodiment of FIG. 8, the gap gsl-r where the scattering layer 210 overlaps the light emitting layer EML exposed by the opening OPr of the pixel defining layer 380 in the red subpixel is the smallest, the gap gsl-g where the scattering layer 210 overlaps the light emitting layer EML exposed by the opening OPg of the pixel defining layer 380 in the green subpixel is the next smallest, and the gap gsl-b where the scattering layer 210 overlaps the light emitting layer EML exposed by the opening OPb of the pixel defining layer 380 in the blue subpixel is the largest. However, depending on some example embodiments, the color of the largest one of the gaps gsl-r, gsl-g, or gsl-b where the scattering layer 210 overlaps the light emitting layer EML exposed by the openings OPr, OPg, and OPb of the pixel defining layer 380 may be green or red, and the size order may also be formed in various ways, unlike FIG. 8.

The polarization plate is not formed on the front surface of the light emitting display panel DP, and instead, the pixel defining layer 380 is formed with a black organic material, and the light blocking layer 220 and the color filter 230 are formed on the upper surface so that when external light is introduced to the inside, it may not be reflected from the anode or the like and thus may not be transmitted to the user, and the scattering layer 210 is disposed on the upper surface so that when external light is incident or reflected, it is scattered and/or the intensity of the external light may be reduced. As no polarization plate is formed, the light emitted by the light emitting layer is partly absorbed by the polarization plate, and thus luminance is not reduced. Thus, the light emitting display device having the maximum luminance of about 2500 nits or more may be provided.

The scattering layer 210 includes scattering particles 211, which scatters incident light in various directions. In the case of a light emitting display device not including a polarization plate, various diffraction patterns may occur when external light is incident and is reflected and diffracted at the anode. When the external light is scattered through the scattering layer 210, the intensity may be weakened, causing the diffraction pattern to appear weaker. However, a problem may arise where the light reflected from the anode interferes with the scattering particles 211 of the scattering layer 210, causing so-called rainbow spots. In the present disclosure, the openings OPSLr, OPSLg, and OPSLb (also referred to as scattering layer openings) may be formed in the scattering layer 210 corresponding to the anode, and the position of the scattering layer openings OPSLr, OPSLg, and OPSLb may be adjusted to reduce or remove rainbow spots.

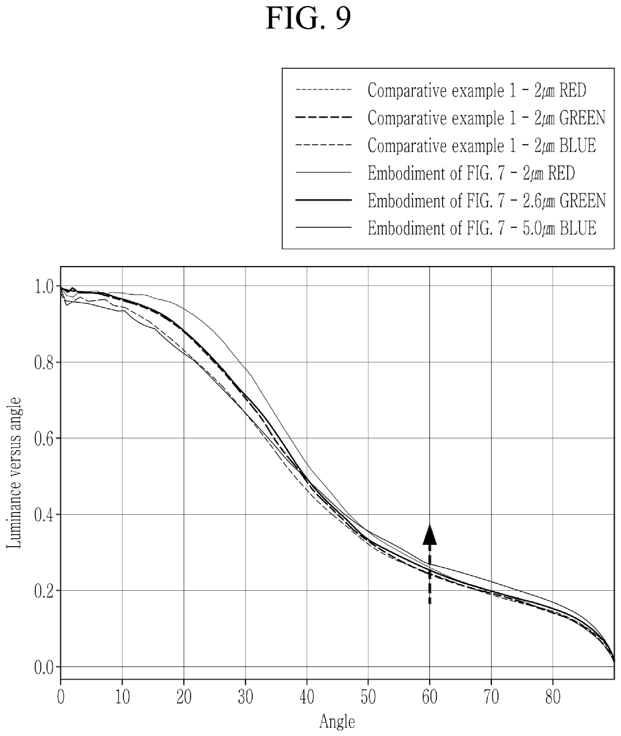

In the present example embodiment, the sizes of the openings OPSLr, OPSLg, and OPSLb of the scattering layer 210 are adjusted to form different gaps gsl-r, gsl-g, and gsl-b where the scattering layer 210 and the light emitting layer EML exposed by the openings OPr, OPg, and OPb of the pixel defining layer 380 overlap with each other in a plan view. Thus, when a light emitting display device is viewed from the side, changes in luminance and/or color may occur as the viewing angle changes. The gaps gsl-r, gsl-g, and gsl-b where the scattering layer 210 overlaps the light emitting layer EML exposed by the openings OPr, OPg, and OPb of the pixel defining layer 380 may be formed differently according to color so that the changes in luminance and/or color from the side may be reduced to a desired (or alternatively, predetermined) level or less, and the light emitting display device may have improved side luminance and/or side color. This will be described in more detail with reference to FIG. 9 to FIG. 12.

The light emitting display panel DP according to an example embodiment will now be described in detail with reference to FIG. 8.

The substrate 110 may include a rigid material such as glass that is not bent, or a flexible material such as plastic or polyimide that may be rolled.

The thin-film transistors are formed on the substrate 110, but are omitted in FIG. 8, and the organic layer 180 covering the thin-film transistors is shown. One pixel is formed with a pixel circuit portion formed with a light emitting diode, and transistors and capacitors that transmit light emitting current to the light emitting diode. FIG. 8 does not show the pixel circuit portion, and the structure of the pixel circuit portion may vary depending on some example embodiments. FIG. 8 shows the organic layer 180 covering the pixel circuit portion.

The light emitting diode including an anode, a light emitting layer EML, and a cathode is disposed on the organic layer 180.

The anode may be configured with a single layer including a transparent conductive oxide layer and a metal material, or a multilayer including the same. The transparent conductive oxide layer may include indium tin oxide (ITO), poly-ITO, indium zinc oxide (IZO), indium gallium zinc oxide (IGZO), or indium tin zinc oxide (ITZO), and the metal material may include silver (Ag), molybdenum (Mo), copper (Cu), gold (Au), or aluminum (Al).

The light emitting layer EML may be formed of an organic light emitting material, and adjacent light emitting layers EML may display different colors. Depending on some example embodiment, the light emitting layer EML may display light of the same color due to the color filters 230R, 230G, and 230B disposed at the upper portion. Depending on some example embodiment, the light emitting layer EML may have a structure in which light emitting layers are stacked (also referred to as a tandem structure).

The pixel defining layer 380 is disposed on the organic layer 180 and the anode, an opening OP is formed in the pixel defining layer 380, and the opening overlaps a part of the anode, and the light emitting layer EML is disposed on the anode exposed by the opening OP. The light emitting layer EML may be disposed in the opening OP of the pixel defining layer 380, and may be separated from the adjacent light emitting layer EML by the pixel defining layer 380.

The pixel defining layer 380 may be formed of or include an organic material with a negative-type black color. Black-colored organic material may include a light blocking material, and the light blocking material may include carbon black, carbon nanotube, resin or paste including a black dye, metal particles such as nickel, aluminum, molybdenum or alloys thereof, metal oxide particles, chromium nitride, etc. The pixel defining layer 380 is black and includes a light blocking material, and thus may have the characteristic of absorbing/blocking light without reflecting it. As such pixel defining layer 380 is the negative-type organic material, the portion of the pixel defining layer 380 covered by the mask may be removed.

The spacer 385 is formed on the pixel defining layer 380. The spacer 385 includes a first portion 385-1 disposed in a relatively tall and narrow region and a second portion 385-2 disposed in a relatively short and wide region. FIG. 8 shows that the first portion 385-1 and the second portion 385-2 are separated by a dotted line in the spacer 385. The first portion 385-1 may reinforce scratch resistance and/or may secure rigidity against pressing pressure. The second portion 385-2 may serve as a contact assistant between the pixel defining layer 380 and the upper functional layer FL. The first portion 385-1 and the second portion 385-2 are formed of or include the same material, and may be formed of a positive-type photosensitive organic material-for example, photosensitive polyimide (PSPI). As the material has a positive-type photosensitive characteristic, portions not covered by the mask may be removed. The spacer 385 has transparency, allowing light to be transmitted and/or reflected.

In the present example embodiment, the pixel defining layer 380 is formed as a negative type, the spacer 385 is formed as a positive type. Depending on some example embodiments, however, the pixel defining layer 380 and the spacer 385 may include a material of the same type.

At least a portion of the upper surface of the pixel defining layer 380 is covered by the spacer 385, and an edge of the second portion 385-2 is spaced apart from an edge of the pixel defining layer 380 so that a portion of the pixel defining layer 380 is not covered by the spacer 385. The second portion 385-2 may cover the upper surface of the pixel defining layer 380 where the first portion 385-1 is not disposed, thereby strengthening the adhesion between the pixel defining layer 380 and the functional layer FL. In the present example embodiment, the spacer 385 is disposed in a region that overlaps the light blocking layer 220 in a plan view, which will be described later, so that the spacer 385 may be covered by the light blocking layer 220 and may not be seen when viewed from the front surface of the display panel DP. In other words, the spacer 385 may not be exposed on or through a front surface of the light emitting display device.

The functional layer FL is disposed on the spacer 385 and the exposed pixel defining layer 380. The functional layer FL may be formed on the front surface of the light emitting display panel DP or may be formed in all regions except for some regions-for example, the light transmission area of the second component area EA2. The functional layer FL may include an electron injection layer, an electron transport layer, a hole transport layer, and/or a hole injection layer, and the functional layer FL may be disposed above or below the light emitting layer EML. That is, the hole injection layer, the hole transport layer, the light emitting layer EML, the electron transport layer, the electron injection layer, and the cathode may be sequentially disposed on the anode, and the hole injection layer and the hole transport layer from among the functional layers FL may be disposed on a lower portion of the light emitting layer EML, and the electron transport layer and the electron injection layer may be disposed on an upper portion of the light emitting layer EML.

The spacer 385 may increase the scratch resistance of the light emitting display panel DP, thereby reducing the occurrence of defects caused by the pressing pressure. Further, the adhesiveness between the spacer 385 and the functional layer FL disposed on the upper portion of the spacer 385 may increase so that moisture and air may be reduced or prevented from being introduced from the outside. Relatively high adhesiveness has the merit of reducing or eliminating the problem of adhesiveness between layers decreasing when the light emitting display panel DP is flexible and is folded and unfolded.

The cathode may be formed as a light transmitting electrode or a reflective electrode. Depending on some example embodiments, the cathode may be a transparent or semi-transparent electrode, and may be formed of or include a metallic thin film having a relatively small work function, including lithium (Li), calcium (Ca), lithium fluoride /calcium (LiF/Ca), lithium fluoride/aluminum (LiF/Al), aluminum (Al), silver (Ag), magnesium (Mg), or compounds thereof. A transparent conductive oxide (TCO) layer such as indium tin oxide (ITO), indium zinc oxide (IZO), zinc oxide (ZnO), or indium oxide (In2O3) may be further disposed on the metallic thin film. The cathode 270 may be formed integrally over the front surface of the light emitting display panel DP.

The encapsulation layer 400 is disposed on the cathode. The encapsulation layer 400 may include at least one inorganic layer and at least one organic layer. FIG. 8 shows a triple-layer structure including a first inorganic encapsulation layer 401, an organic encapsulation layer 402, and a second inorganic encapsulation layer 403. The encapsulation layer 400 may protect the light emitting layer EML formed of or including an organic material from moisture or oxygen that may be introduced from the outside. Depending on some example embodiments, the encapsulation layer 400 may include a structure in which an inorganic layer and an organic layer are sequentially further stacked.

The sensing insulation layers 501, 510, and 511 and the sensing electrodes 540 and 541 are disposed on the encapsulation layer 400 for touch sensing. In the example embodiment of FIG. 8, touch is detected in a capacitive type using two sensing electrodes 540 and 541, but depending on some example embodiments, touch may also be detected in a self-cap method using one sensing electrode. The sensing electrodes 540 and 541 may be insulated with the second sensing insulation layer 510 disposed therebetween, the lower sensing electrode 541 may be disposed on the first sensing insulation layer 501, the upper sensing electrode 540 may be disposed on the second sensing insulation layer 510, and the upper sensing electrode 540 may be covered by the third sensing insulation layer 511. The sensing electrodes 540 and 541 may be electrically connected through the openings disposed in the second sensing insulation layer 510. The sensing electrodes 540 and 541 may include metal such as aluminum (Al), copper (Cu), silver (Ag), gold (Au), molybdenum (Mo), titanium (Ti), or tantalum (Ta), or metal alloys, and may be configured as a single layer or a multilayer.

The scattering layer 210, the light blocking layer 220, and the color filters 230R, 230G, and 230B are sequentially disposed on the third sensing insulation layer 511

The light blocking layer 220 may be disposed to overlap the sensing electrodes 540 and 541 in a plan view, and may be disposed not to overlap the anode in a plan view. This is to ensure that the anode and the light emitting layer EML for displaying images are not covered by the light blocking layer 220 and the sensing electrodes 540 and 541.

The scattering layer 210 may be disposed to overlap the light blocking layer 220 and the sensing electrodes 540 and 541 in a plan view, a portion of the scattering layer 210 may overlap the anode, and another portion of the scattering layer 210 may not overlap the anode. At least a portion of the scattering layer 210 may also overlap the pixel defining layer 380 in a plan view. The scattering layer 210 includes scattering particles 211 for scattering light, and has an opening OPSL (also referred to as a scattering layer opening) at least partly overlapping the opening OP of the pixel defining layer 380 in a plan view. The size, shape, and arranged direction of the opening OPSL of the scattering layer 210 may vary, and may have various shapes such as a circle or an oval in a plan view.

Referring to FIG. 8, the light blocking layer 220 is disposed in a region overlapping the pixel defining layer 380 in a plan view, and one side of the light blocking layer 220 is indented from the corresponding side of the pixel defining layer 380 in a plan view.

The light blocking layer 220 may have a second opening OPBM (also referred to as a second opening), an area of the second opening OPBM of the light blocking layer 220 may be formed to be larger than the opening OP of the pixel defining layer 380, and the opening OP of the pixel defining layer 380 may be disposed within the second opening OPBM of the light blocking layer 220 in a plan view. The second opening OPBM of the light blocking layer 220 may be formed larger than the opening OPSL of the scattering layer 210, and at least a portion of the second opening OPBM of the light blocking layer 220 may overlap the opening OPSL of the scattering layer 210 in a plan view.

One side of the spacer 385 is indented from the corresponding side of the pixel defining layer 380 by a desired (or alternatively, predetermined) gap g1, and the spacer 385 is also indented from one side of the light blocking layer 220. Thus, when viewed from the front surface of the display panel DP, the spacer 385 may be covered by the light blocking layer 220 and may not be visible.

When external light is incident, it may be transmitted through the second opening OPBM of the light blocking layer 220 and the opening OPSL of the scattering layer 210, and may be reflected from a side wall of the opening OP of the pixel defining layer 380. The side wall of the opening OP of the pixel defining layer 380 is curved so color separation occurs depending on the reflected position, and the reflected light may appear as rainbow spots. The color-separated reflected light may be easily seen by the user's eyes and display quality may deteriorate, but in the present example embodiment, the scattering particles 211 disposed in the scattering layer 210 may cause the light to be scattered, making it difficult for the user to easily recognize the reflected light. For example, as the scattering layer 210 is formed to cover the side wall of the pixel defining layer 380, rainbow spots may be reduced or removed. The shape, size, and angle of the opening OPSL of the scattering layer 210 may be varied, and a single panel may include various openings OPSL of the scattering layer 210. Thus, the display quality deterioration due to reflected light may be reduced, reducing or preventing the user from perceiving external light as rainbow spots.

FIG. 8 shows that the opening OP of the pixel defining layer 380 is larger than the opening OPSL of the scattering layer 210, and the second opening OPBM of the light blocking layer 220 is larger than the opening OPSL of the scattering layer 210 and the opening OP of the pixel defining layer 380. However, the width relationship of the openings may vary depending on some example embodiments, shape, size, arrangement, and cross-section of the openings, etc.

The color filters 230R, 230G, and 230B are disposed on the sensing insulation layers 501, 510, and 511, the scattering layer 210, and the light blocking layer 220. The color filters 230R, 230G, and 230B include a red color filter 230R transmitting red light, a green color filter 230G transmitting green light, and a blue color filter 230B transmitting blue light. The respective one of the color filters 230R, 230G, and 230B may be disposed to overlap the anode of the light emitting diode corresponding thereto in a plan view. As the light emitted by the light emitting layer EML may be emitted with the corresponding color changed as it is transmitted through the color filter, all the light emitted by the light emitting layer EML may have the same color. However, the light emitting layer EML may display different colors of light, and may allow the light to be transmitted through the color filter of the same color to reinforce the displayed colors.

The light blocking layer 220 may be disposed between each of the color filters 230R, 230G, and 230B. Depending on some example embodiments, the color filters 230R, 230G, and 230B may be replaced with color conversion layers or may further include a color conversion layer. The color conversion layer may include quantum dots.

The planarization layer 550 for covering the color filters 230R, 230G, and 230B is disposed on the color filters 230R, 230G, and 230B. The planarization layer 550 may planarize the upper surface of the light emitting display panel and may be a transparent organic insulator including at least one of polyimide, polyamide, acryl resin, benzocyclobutene, or phenol resin.

Depending on some example embodiments, a low-refraction layer and an additional planarization layer may be further disposed on the planarization layer 550 to improve the front visibility and/or light emission efficiency of the display panel. Light may be refracted and emitted toward the front surface by the low-refraction layer and the additional planarization layer with relatively high refraction characteristics. Depending on some example embodiments, the planarization layer 550 may be omitted and the low-refraction layer and the additional planarization layer may be disposed on the color filter 230.

In the present example embodiment, no polarization plate is included on the upper portion of the planarization layer 550. The polarization plate may reduce or prevent deterioration of display quality when external light is introduced and is reflected from the anode or the side wall of the opening OP of the pixel defining layer 380, and the user sees it. However, the polarization plate has the drawback of consuming more electric power so as to reduce the light emitted by the light emitting layer EML and display desired (or alternatively, predetermined) luminance in addition to reducing reflection of external light. To reduce power consumption, the light emitting display device may not include the polarization plate. As the light emitting display device does not form the polarization plate, light emitted by the light emitting layer could not be partly absorbed by the polarization plate, and thus luminance may not be lowered, and thus the light emitting display device may be enabled to have the maximum luminance value of about 2500 nits or more.

In the present example embodiment, the scattering layer 210 is formed below the light blocking layer 220, and the edge of the opening OPSL of the scattering layer 210 is formed to cover the side wall of the pixel defining layer 380 in a plan view, thereby reducing or preventing deterioration of display quality by reducing or preventing reflected external light from being recognized as a rainbow spot. Therefore, there is no need to separately form the polarization plate on the front surface of the light emitting display panel DP.

In the example embodiment of FIG. 8, the scattering layer 210 is disposed between the third sensing insulation layer 511 and the light blocking layer 220, and protrudes toward the front surface (in the third direction DR3) with respect to the third sensing insulation layer 511. The scattering layer 210 has a tapered side, and a taper angle may be an angle greater than 0 degrees and less than about 90 degrees toward the third direction DR3 from the first direction DR1 or the second direction DR2. Compared to the comparative example in which the scattering layer 210 protrudes toward the rear surface (opposite direction of the third direction DR3), the example embodiment in which the scattering layer 210 protrudes toward the front surface is not only easy to manufacture using a photolithography-type exposing and developing process, but it is also easy to control the taper angle, thereby effectively reducing the rainbow spots to be described.

In the example embodiment of FIG. 8, the light emitting layer EML exposed by the scattering layer 210 and the openings OPr, OPg, and OPb of the pixel defining layer 380 are formed to have the overlapping gaps gsl-r, gsl-g, and gsl-b which are different from each other in a plan view. Thus, the light emitting display device has improved lateral luminance and/or lateral color, which will be described in detail with reference to FIG. 9 to FIG. 12.

FIG. 9 to FIG. 12 show characteristics of the example embodiment of FIG. 7 and FIG. 8.

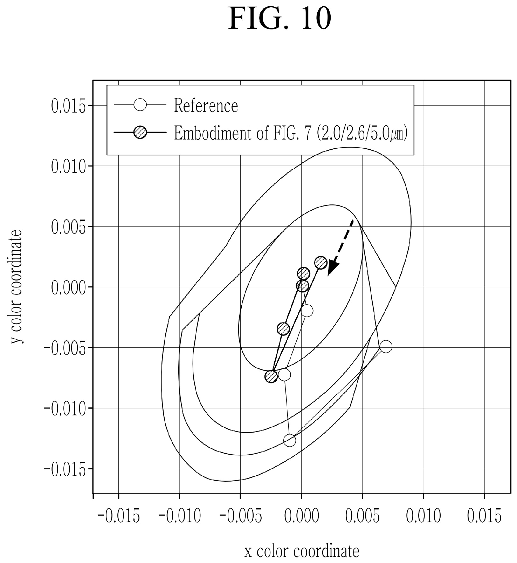

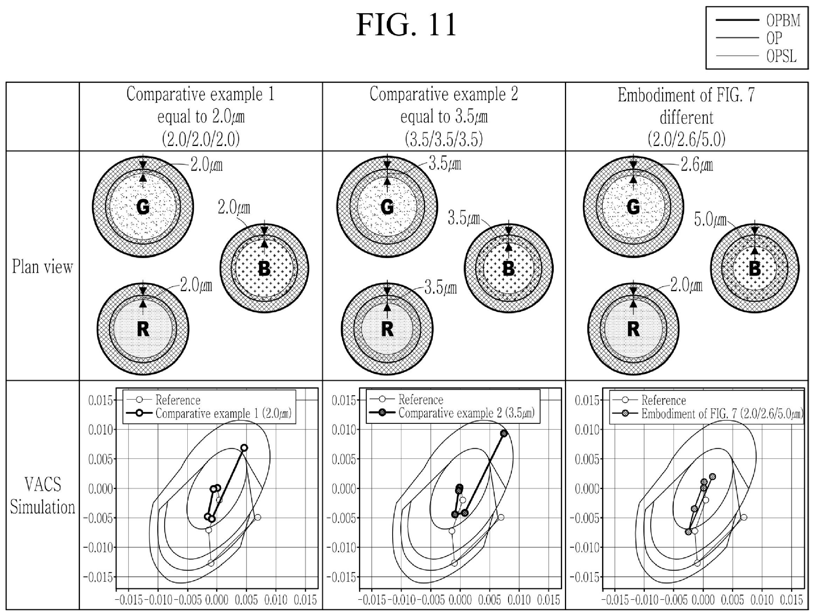

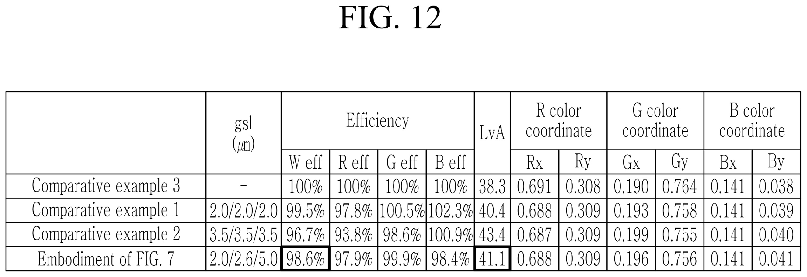

FIG. 9 shows a graph of luminance ratio, FIG. 10 shows a graph of white color coordinates, and FIG. 11 and FIG. 12 show the characteristic differences between the comparative example and the example embodiment of FIG. 7 and FIG. 8. Comparative Examples 1 and 2 have a structure in which the scattering layer 210 has an opening OPSL, and the gap gsl where the scattering layer 210 overlaps the light emitting layer EML is the same for all colors, while Comparative Example 3 has a structure that does not include the scattering layer 210. In Comparative Example 1 simulated in FIG. 9 to FIG. 12, as shown in FIG. 11, the gap gsl where the scattering layer 210 overlaps the light emitting layer EML is 2 µm for all colors, and in Comparative Example 2, as shown in FIG. 11, the gap gsl where the scattering layer 210 overlaps the light emitting layer EML is 3.5 µm for all colors. The example embodiment of FIG. 7 is formed such that, as shown in FIG. 11, the gap gsl-r where the scattering layer 210 overlaps the light emitting layer EML in the red subpixel in a plan view is 2 µm, the gap gsl-g where the scattering layer 210 overlaps the light emitting layer EML in the green subpixel in a plan view is 2.6 µm, and the gap gsl-b where the scattering layer 210 overlaps the light emitting layer EML in the blue subpixel in a plan view is 5 µm.

FIG. 9 will now be described. FIG. 9 shows a graph of the luminance ratio tilted in the left and right directions with the front as a reference for the red, green, and blue subpixels in Comparative Example 1 and the red, green, and blue subpixels in the example embodiment of FIG. 7.

Referring to FIG. 9, there is little difference between Comparative Example 1 and the example embodiment of FIG. 7 at angles that are close to the front surface, but as the luminance ratio of the example embodiment of FIG. 7 moves to the side, it is higher than that of the comparative example, and particularly when considered with respect to the lateral side of 60 degrees, it is found that the luminance ratio of the example embodiment of FIG. 7 is higher than that of the comparative example. Therefore, it may be confirmed that the lateral luminance ratio is improved in the example embodiment of FIG. 7.

FIG. 10 shows a graph on simulation (also referred to as visual appearance characteristic simulation (VACS)) obtained by setting a white color coordinate value at the front surface with the value of 0 of the x-axis and y-axis in the color coordinate, and simulating the change of the white color coordinate value while moving to the side at the intervals of 15 degrees. The measured angles are 0 degrees (front), 15 degrees, 30 degrees, 45 degrees, and 60 degrees, which are represented by five circles. In the reference and the example embodiment of FIG. 7, the white color coordinate values at 0 degrees (front) are all disposed at the center, and the white color coordinate values measured while moving by 15 degrees from there are connected as a straight line.

FIG. 10 additionally shows closed curves on the outside, which show the variation range of white color coordinates guided as references in various light emitting display devices.

Referring to FIG. 10, when the white color coordinate value is substantially changed as the angle changes, the color is changed, so the light emitting display device displays better colors when the white color coordinate value changes less as the angle changes.

The change in the white color coordinates for the example embodiment of FIG. 7 shown in FIG. 10 is also shown in FIG. 11, which compares Comparative Example 1 and Comparative Example 2.

Referring to Comparative Example 1 and Comparative Example 2 in FIG. 11, it may be seen that the white color coordinate value at the angle of 60 degrees on the side is disposed outside the reference marked as a closed curve, and the white color coordinate value at the angle of 45 degrees on the side and the white color coordinate value at the angle of 60 degrees on the side are disposed quite far apart. Therefore, in the comparative example, when the user changes the viewing angle and views the image, the degree of changing colors is relatively large.

However, referring to the example embodiment of FIG. 7 of FIG. 11, the white color coordinate value at the angle of 60 degrees on the side is disposed within the reference shown as a closed curve, and the white color coordinate value at the angle of 45 degrees on the side and the white color coordinate value at the angle of 60 degrees on the side are disposed relatively close. Therefore, as shown in FIG. 7, it may be confirmed that the degree of color change may be reduced when the user changes the viewing angle and views the image by having a gap gsl where the scattering layer 210 and the light emitting layer EML for each color overlap. In this case, the size of the gap gsl where the scattering layer 210 overlaps the light emitting layer EML for a desired (or alternatively, predetermined) color may be changed depending on the characteristics of the light emitting display device. Therefore, the gap gsl between the scattering layer 210 and the light emitting layer EML for different colors may be the largest or smallest, as shown in FIG. 7, and the gap value may also be different.

FIG. 12 shows the gap gsl where the scattering layer 210 overlaps the light emitting layer EML, efficiency, luminance ratio (LvA) according to angle, and color coordinate values. Here, efficiency is included by dividing it into efficiency of white light (W eff), efficiency of red light (R eff), efficiency of green light (G eff), and efficiency of blue light (B eff).

Comparative Example 3 does not include the scattering layer, so the light emitted by the light emitting layer may be transmitted without scattering, resulting in the highest efficiency of 100%, and the gap gsl where the scattering layer 210 overlaps the light emitting layer EML is not described. In Comparative Example 1, Comparative Example 2, and the example embodiment of FIG. 7, the efficiency value is reduced compared to that of Comparative Example 3 due to the presence of the scattering layer 210, but the difference is not significant.

The luminance ratio (LvA) is the value of the luminance ratio at the angle of 40 degrees on the side compared to the front surface, and it may be confirmed that Comparative Example 3 has the lowest value, and Comparative Example 1, Comparative Example 2, and the example embodiment of FIG. 7 have relatively large luminance ratio (LvA) values.

Comparing Comparative Example 1, Comparative Example 2, and the example embodiment of FIG. 7, Comparative Example 1 has the highest efficiency, the example embodiment of FIG. 7 has the next highest efficiency, and Comparative Example 2 has the lowest efficiency, but the luminance ratio (LvA) is the highest for Comparative Example 2, t is the next highest for the example embodiment of FIG. 7, and is the lowest for Comparative Example 2. Therefore, when considering both efficiency and luminance ratio (LvA), the example embodiment of FIG. 7 may be the most suitable. However, because the efficiency and the luminance ratio (LvA) in Comparative Example 1, Comparative Example 2, and the example embodiment of FIG. 7 do not show a very large difference, they may all be applied to light emitting display devices. However, as described with reference to FIG. 10 and FIG. 11, the example embodiment of FIG. 7 has an advantage over the comparative example in that the color coordinate values and the white color tone remain changed under a desired (or alternatively, predetermined) level when the viewing angle changes. In other words, the example embodiment of FIG. 7 has an advantage over the comparative example in that the color coordinate values and the white color tone change less than a desired (or alternatively, predetermined) level when the viewing angle changes.

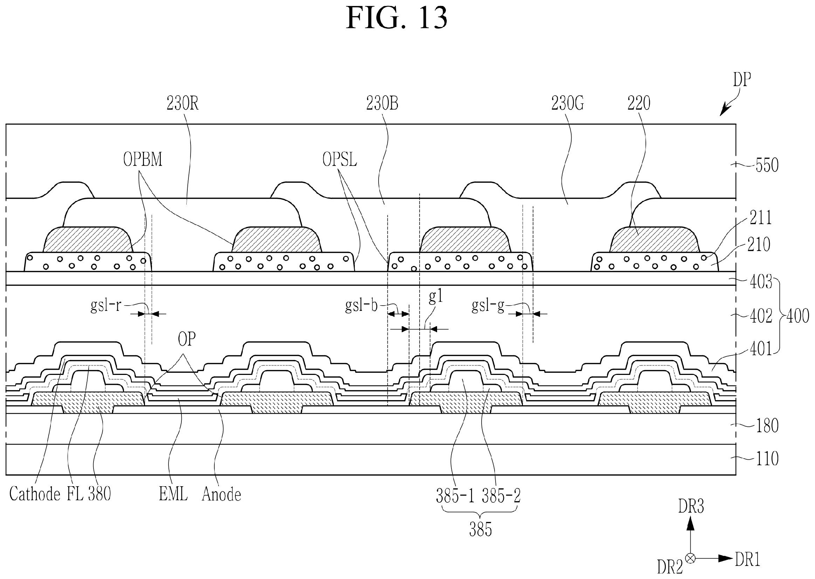

An example embodiment with a different cross-sectional structure from that of FIG. 8 will now be described with reference to FIG. 13.

FIG. 13 shows a cross-sectional view illustrating a display panel according to a modified example embodiment of FIG. 8.

The example embodiment of FIG. 13, unlike the example embodiment of FIG. 8, does not include the sensing insulation layers 501, 510, and 511 and the sensing electrodes 540 and 541 formed between the encapsulation layer 400 and the scattering layer 210 for detecting touch. Thus, the scattering layer 210, the light blocking layer 220, and the color filters 230R, 230G, and 230B are disposed on the encapsulation layer 400, and the second inorganic encapsulation layer 403 may contact the scattering layer 210, and the upper structure of the scattering layer 210 and the lower structure of the encapsulation layer 400 may be the same as in FIG. 8.

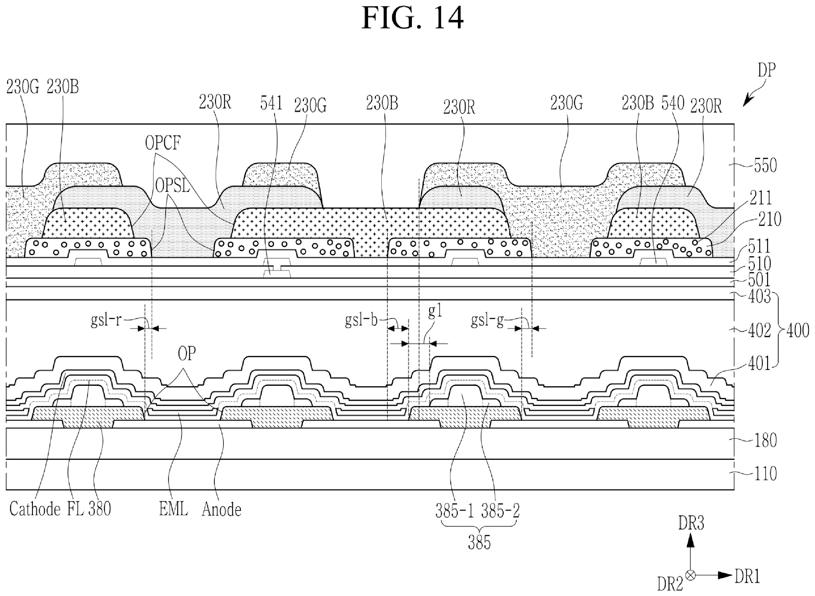

In some example embodiments, instead of the light blocking layer 220, a light blocking region of the color filter, where at least two of the color filters 230R, 230G, and 230B overlap may be formed. An example embodiment including no light blocking layer and including the light blocking region of the color filter, where at least two of the color filters 230R, 230G, and 230B overlap will now be described with reference to FIG. 14 to FIG. 16.

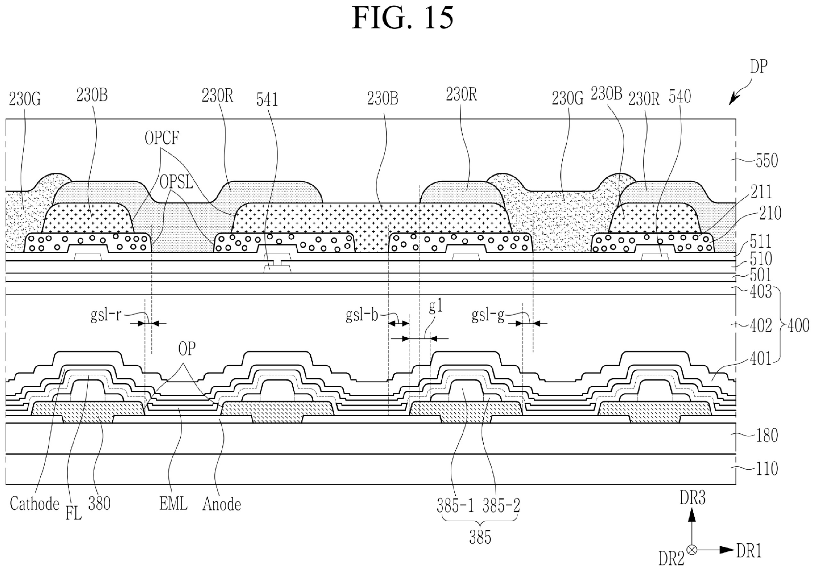

A modified structure of FIG. 8 will now be described with reference to FIG. 14 and FIG. 15.

FIG. 14 and FIG. 15 show cross-sectional views illustrating a display panel according to modified example embodiments of FIG. 8.

FIG. 14 and FIG. 15 show cross-sectional views illustrating a display panel according to some example embodiments.

The structure of the light emitting display panel DP according to an example embodiment will now be described with reference to FIG. 14, and the description of the same portion as FIG. 8 will be omitted.

The light emitting display panel DP according to the example embodiment of FIG. 14 may display images by forming a light emitting diode on the substrate 110, may detect touch by including sensing electrodes 540 and 541, and may have color filters 230R, 230G, and 230B so that light emitted by the light emitting diode has the color characteristics of the color filters 230R, 230G, and 230B. The light blocking layer formed in black to block visible rays may not be formed, and instead of the light blocking layer, at least two color filters may overlap to block visible rays.

The region blocking visible rays by overlapping at least two color filters is referred to as a light blocking region, and in the example embodiment of FIG. 14, the blue color filter 230B, the red color filter 230R, and the green color filter 230G are sequentially stacked. The order in which the color filters are stacked may vary depending on some example embodiments.

The polarization plate is not formed on the front surface of the light emitting display panel DP according to the example embodiment of FIG. 14. Instead, the pixel defining layer 380 is formed with a black color organic material, and the light blocking region in which at least two color filters overlap is formed on the upper surface of the pixel defining layer 380, so that when external light is incident on the inside, it may not be reflected from the anode or the like and may not reach the user.

In detail, the color filters 230R, 230G, and 230B may be disposed on the third sensing insulation layer 511. The color filters 230R, 230G, and 230B include a red color filter 230R transmitting red light, a green color filter 230G transmitting green light, and a blue color filter 230B transmitting blue light. Each of the color filters 230R, 230G, and 230B may be disposed to overlap the anode of the light emitting diode in a plan view. Because the light emitted by the light emitting layer EML may be emitted while changing to the corresponding color as it is transmitted through the color filter, all the light emitted by the light emitting layer EML may have the same color. However, the light emitting layer EML may display different colors of light, and the displayed color may be enhanced by transmitting it through the color filter of the same color.

Depending on some example embodiments, the color filters 230R, 230G, and 230B may be replaced with color conversion layers or may further include a color conversion layer. The color conversion layer may include quantum dots.

In the example embodiment of FIG. 14, a light blocking layer formed in black color to block visible light is not formed, and instead of the light blocking layer, a light blocking region formed by overlapping at least two color filters is formed to replace the light blocking layer. In the example embodiment of FIG. 14, the light blocking region has the blue color filter 230B, the red color filter 230R, and the green color filter 230G sequentially stacked therein. The order in which color filters are stacked may vary depending on some example embodiments.

The light blocking region, in which at least two color filters overlap, may be disposed to overlap the sensing electrodes 540 and 541 in a plan view, and not to overlap the anode in a plan view. This is to reduce or prevent the anode and the light emitting layer EML, which may display images, from being covered by the light blocking region and the sensing electrodes 540 and 541.

Referring to FIG. 14, the light blocking region of the color filter in which three color filters overlap is disposed in the region that overlaps the pixel defining layer 380 in a plan view, and one side of the light blocking region of the color filter is indented from the corresponding one side of the pixel defining layer 380.

One color filter may be disposed in a region other than the light blocking region, and light of the color of the corresponding color filter is transmitted to form the light transmitting region of the color filter. The light transmitting region of the color filter, where one color filter is disposed, is referred to as the second opening OPCF of the light blocking region because light is transmitted therethrough. The second opening OPCF of the light blocking region may be an opening disposed in the light blocking region where at least two color filters overlap, and may correspond to a region where one color filter is disposed. The second opening OPCF of the light blocking region of the color filter may correspond to the second opening OPBM of the light blocking layer 220 described above. Thus, the second opening OPCF of the light blocking region of the color filter may be circular or oval in a planar shape.

The area of the second opening OPCF of the light blocking region is formed larger than the opening OP of the pixel defining layer 380, and the opening OP of the pixel defining layer 380 in a plan view may be disposed within the second opening OPCF of the light blocking region. The opening OPSL of the scattering layer 210 may be in the second opening OPCF of the light blocking region, and may be disposed in the opening OP of the pixel defining layer 380 so that the scattering layer 210 may overlap the side of the pixel defining layer 380 in a plan view.

In the example embodiment of FIG. 14, the opening OPSL of the scattering layer 210 may have different sizes for red, green, and blue, and the width (corresponding to the gaps gsl-r, gsl-g, and gsl-b where the scattering layer 210 and the opening OP of the pixel defining layer 380 overlap) of the scattering layer 210 overlapping the light emitting layer EML exposed by the opening OP of the pixel defining layer 380 in the red subpixel, the green subpixel, and the blue subpixel in a plan view may be formed with different values.

One side of the spacer 385 may be indented from the corresponding one side of the pixel defining layer 380 by a desired (or alternatively, predetermined) gap g1, and the spacer 385 may be indented from one side of the light blocking region. Thus, when viewed from the front surface of the display panel DP, the spacer 385 may be covered by the light blocking region and may not be visible.

When external light is incident, it may be reflected from the side wall of the opening OP of the pixel defining layer 380 after being transmitted through the second opening OPCF of the light blocking region of the color filter and the opening OPSL of the scattering layer 210. The side wall of the opening OP of the pixel defining layer 380 may be curved, and color separation occurs depending on the reflected position, which may cause rainbow spots in which the colors of the reflected light appear in various colors like a rainbow. The rainbow spots may be easily visible to the user and may deteriorate display quality, but in the present example embodiment, the scattering layer 210 having the opening OPSL may be formed, and the side wall of the pixel defining layer 380 may be covered with the scattering layer 210 to remove or weaken the rainbow spots, making it difficult for the user to recognize the rainbow spots. The gaps gsl-r, gsl-g, and gsl-b, where the scattering layer 210 and the opening OP of the pixel defining layer 380 overlap, are formed differently in the red, green, and blue subpixels. Thus, when the viewing angle changes, the color coordinate values and color changes of white change below a desired (or alternatively, predetermined) level, thereby improving the display quality of the light emitting display device.

The planarization layer 550 covering the color filters 230R, 230G, and 230B is disposed on the color filters 230R, 230G, and 230B. The planarization layer 550 may planarize the upper surface of the light emitting display panel and may be a transparent organic insulator including at least one of polyimide, polyamide, acryl resin, benzocyclobutene, or phenol resin.

Depending on some example embodiments, a low-refraction layer and an additional planarization layer may be disposed on the planarization layer 550 to improve the front visibility and light emission efficiency of the display panel. Light may be refracted and emitted toward the front surface by the low-refraction layer and the additional planarization layer with high refraction characteristics. Depending on some example embodiments, the planarization layer 550 may be omitted and the low-refraction layer and the additional planarization layer may be disposed directly on the color filter.

In the present example embodiment, no polarization plate is included on the planarization layer 550. That is, the polarization plate may reduce or prevent deterioration of the display visible to the user when external light is incident and is reflected from the anode or the side wall of the opening OP of the pixel defining layer 380. However, the polarization plate has the drawback of consuming more electric power to display a determined luminance because it not only reduces the reflection of external light but also reduces the light emitted by the light emitting layer EML. To reduce power consumption, the light emitting display device may not include the polarization plate.

The present example embodiment already includes a structure that covers the sides of the anode with the pixel defining layer 380 to reduce the amount of reflection from the anode, and the light blocking region with at least two color filters overlapping to reduce the degree of incident light and reduce or prevent deterioration of display quality due to reflection. Therefore, there is no need to separately form the polarization plate on the front surface of the light emitting display panel DP.

In the example embodiment of FIG. 14, an example in which the light blocking region in which at least two color filters overlap is formed by overlapping three color filters has been described. However, depending on some example embodiments, two color filters may overlap to form a light blocking region of the color filter, as shown in FIG. 15.

FIG. 15 corresponds to FIG. 8 and FIG. 14, with the color filters 230R, 230G, and 230B differing from FIG. 14, and the lower structure of the third sensing insulation layer 511 is the same as in FIG. 14. An upper structure of the third sensing insulation layer 511, which differs from FIG. 14, will now be described.

Referring to FIG. 15, the light blocking layer blocking visible light is not formed, and the blue color filter 230B and the red color filter 230R sequentially overlap to block visible light. The order in which color filters are stacked may vary depending on some example embodiments.

For example, the light blocking region where two color filters overlap is where the blue color filter 230B and the red color filter 230R overlap, and a desired (or alternatively, predetermined) region of the light blocking region of the color filters has a portion where the green color filter 230G overlaps. However, because the green color filter 230G is not formed in the entire light blocking region of the color filter, unlike the example embodiment of FIG. 14, the light blocking region of the color filter is formed with two color filters. The light blocking region where two color filters overlap is disposed in the region that overlaps the pixel defining layer 380 in a plan view, and one side of the light blocking region of the color filter is indented from the corresponding side of the pixel defining layer 380.

One color filter may be disposed in a region other than the light blocking region of the color filter, and the light of the color of the corresponding color filter is transmitted to form a second opening OPCF in the light transmitting region of the color filter or the light blocking region of the color filter. The area of the second opening OPCF is formed larger than the opening OP of the pixel defining layer 380, and the opening OP of the pixel defining layer 380 in a plan view may be disposed within the second opening OPCF of the light blocking region of the color filter. The opening OPSL of the scattering layer 210 is in the second opening OPCF of the light blocking region and is disposed in the opening OP of the pixel defining layer 380.

The light blocking region of the color filter overlaps the pixel defining layer 380, the scattering layer 210, the spacer 385, and the sensing electrodes 540 and 541 in a plan view. For example, regarding the light blocking region of the color filter, one side of the spacer 385 is indented from the corresponding side of the pixel defining layer 380 by the desired (or alternatively, predetermined) gap g1, and the spacer 385 is indented from one side of the light blocking region of the color filter. The sensing electrodes 540 and 541 are covered by the light blocking region of the color filter in a plan view. Thus, when viewed from the front surface of the display panel DP, the spacer 385 and the sensing electrodes 540 and 541 may be covered by the light blocking region of the color filter and may not be visible.

In the example embodiment of FIG. 15, the opening OPSL of the scattering layer 210 may have different sizes for red, green, and blue, and the width (corresponding to the gaps gsl-r, gsl-g, and gsl-b where the scattering layer 210 and the opening OP of the pixel defining layer 380 overlap) of the scattering layer 210 overlapping the light emitting layer EML exposed by the opening OP of the pixel defining layer 380 in the red subpixel, the green subpixel, and the blue subpixel in a plan view is formed with different values. Thus, when the viewing angle changes, the color coordinate values and color changes of white change below a desired (or alternatively, predetermined) level, thereby improving the display quality of the light emitting display device.

Depending on some example embodiments, the color filters 230R, 230G, and 230B may be replaced with color conversion layers or may further include a color conversion layer. The color conversion layer may include quantum dots.

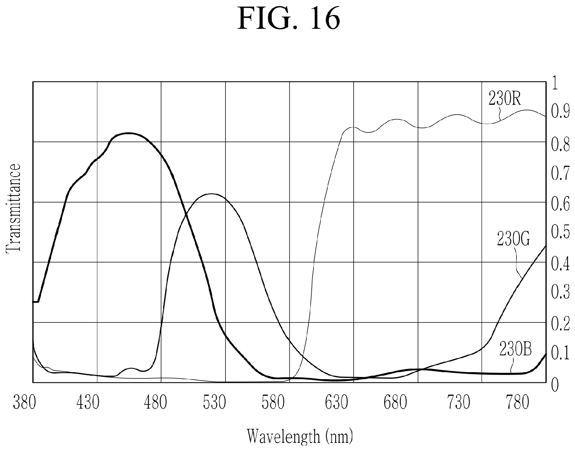

It will now be described whether the function of the light blocking layer may be replaced by stacking two color filters with reference to FIG. 16.

FIG. 16 shows a graph on transmittance with respect to wavelengths of a color filter.

FIG. 16 is a transmittance graph for the wavelengths of the color filters 230R, 230G, and 230B, so light in the wavelength range of the portion indicated as higher is transmitted. Referring to FIG. 16, it may be seen that the portions other than the wavelength bands transmitted by the color filters 230R, 230G, and 230B have transmittances of less than 10%, and that when three or two color filters overlap, there is almost no transmitted wavelength band. Therefore, the function of the light blocking layer may be replaced by overlapping at least two color filters, and thus it may be possible that the light blocking layer may be replaced by overlapping three color filters as shown in FIG. 14 or overlapping two color filter as shown in FIG. 15.

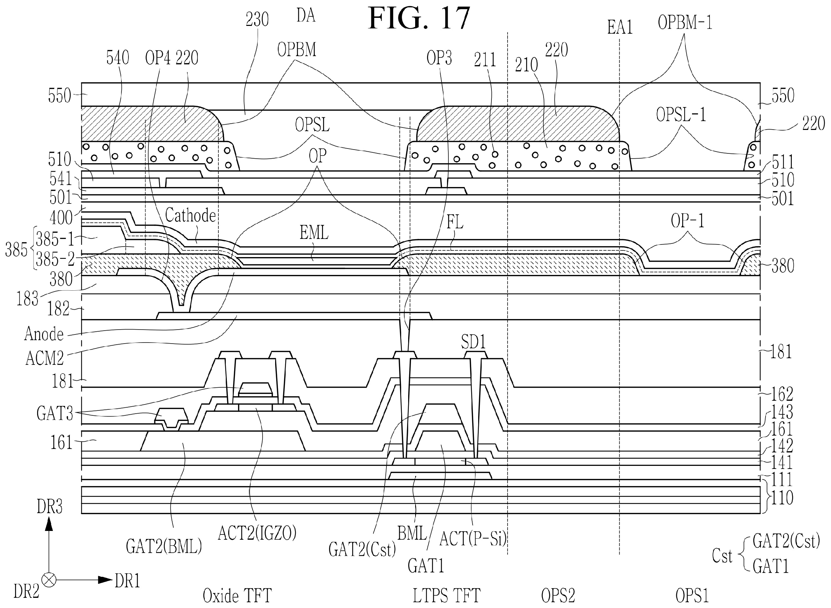

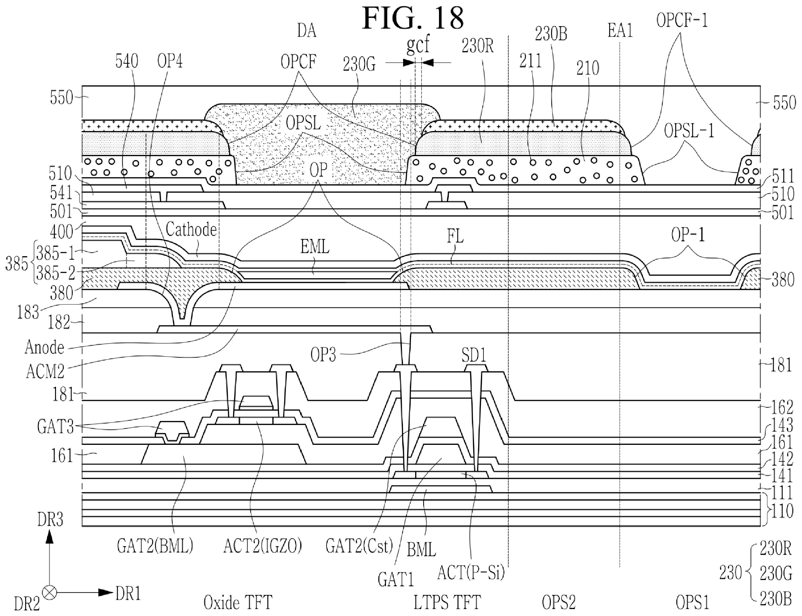

A stacking structure of the display area DA and the first component area EA1 will now be described in more detail with reference to FIG. 17 and FIG. 18.

FIG. 17 and FIG. 18 show cross-sectional views illustrating a light emitting display device including the display panels of FIG. 8 and FIG. 15, respectively, according to some example embodiment.

FIG. 17 shows an example embodiment including the light blocking layer 220, and FIG. 18 shows an example embodiment for forming the light blocking region by overlapping the blue color filter 230B and the red color filter 230R instead of using the light blocking layer 220.

The example embodiment of FIG. 17 will now be described in detail.

The light emitting display device may be divided into a lower panel layer and an upper panel layer. The lower panel layer may be a portion where the light emitting diode and the pixel circuit portion constituting the pixel are disposed, and may include an encapsulation layer 400 covering the same. The pixel circuit portion may include a second organic layer 182 and a third organic layer 183 and may represent a lower configuration thereof, and the light emitting diode may represent the component disposed on an upper portion of the third organic layer 183 and a lower portion of the encapsulation layer 400. The component disposed on an upper portion of the encapsulation layer 400 may correspond to the upper panel layer.

Referring to FIG. 17, a metal layer (BML) is disposed on the substrate 110.

The substrate 110 may include a material that is rigid and does not bend such as glass, or a flexible material that may be bent such as plastic or polyimide. As shown in FIG. 17, the flexible substrate may have a double structure formed by two layers including polyimide and a barrier layer formed of or including an inorganic insulating material thereon.

The metal layer (BML) may be formed at a position overlapping a channel of a driving transistor from among the subsequent first semiconductor layer in a plan view, and may be referred to as a lower shielding layer. The metal layer (BML) may include metal such as copper (Cu), molybdenum (Mo), aluminum (Al), titanium (Ti) or metal alloys thereof.

A buffer layer 111 covering the substrate 110 and the metal layer (BML) is disposed thereon. The buffer layer 111 serves to block the penetration of impurity elements into the first semiconductor layer (ACT(P-Si)), and may be an inorganic insulation layer including silicon oxide (SiO2), silicon nitride (SiNx), or silicon oxynitride (SiOxNy).

The first semiconductor layer (ACT(P-Si)) formed of a silicon semiconductor (e.g., polycrystalline semiconductor (P-Si)) is disposed on the buffer layer 111. The first semiconductor layer (ACT(P-Si)) includes a channel of a polycrystalline transistor (LTPS TFT) including a driving transistor, and a first region and a second region disposed on both sides thereof. The polycrystalline transistor (LTPS TFT) may include not only a driving transistor but also various switching transistors or compensation transistors. A region having conductive layer characteristics may be formed on both sides of the channel of the first semiconductor layer (ACT(P-Si)) through plasma treatment or doping, thereby serving as the first electrode and the second electrode of the transistor.

A first gate insulation layer 141 may be disposed on the first semiconductor layer (ACT(P-Si)). The first gate insulation layer 141 may be an inorganic insulation layer including silicon oxide (SiO2), silicon nitride (SiNx), or silicon oxynitride (SiOxNy).

A first gate conductive layer GAT1 including a gate electrode of the polycrystalline transistor (LTPS TFT) may be disposed on the first gate insulation layer 141. The first gate conductive layer GAT1 may form a first scan line or a light emission control line in addition to the gate electrode of the polycrystalline transistor (LTPS TFT). The first gate conductive layer may include metal such as copper (Cu), molybdenum (Mo), aluminum (Al), titanium (Ti), or metal alloys thereof, and may be a single layer or a multilayer.

The exposed region of the first semiconductor layer may be made conductive by performing plasma treatment or a doping process after forming the first gate conductive layer GAT1. That is, the first semiconductor layer (ACT(P-Si)) covered by the first gate conductive layer GAT1 does not become conductive, and a portion of the first semiconductor layer (ACT(P-Si)) not covered by the first gate conductive layer GAT1 may have the same characteristics as the conductive layer.

A second gate insulation layer 142 may be disposed on the first gate conductive layer GAT1 and the first gate insulation layer 141. The second gate insulation layer 142 may be an inorganic insulation layer including silicon oxide (SiOx), silicon nitride (SiNx), or silicon oxynitride (SiOxNy).

A second gate conductive layer including one electrode (GAT2(Cst)) of a storage capacitor (Cst) and a lower shielding layer (GAT2(BML)) of an oxide transistor (Oxide TFT) may be disposed on the second gate insulation layer 142. The lower shielding layer (GAT2(BML)) of the oxide transistor (Oxide TFT) may be disposed on the lower portion of the channel of the oxide transistor (Oxide TFT) to shield the channel from light or electromagnetic interference (EMI) provided to the channel from the lower portion. The one electrode (GAT2(Cst)) of the storage capacitor (Cst) overlaps the gate electrode of the driving transistor to form the storage capacitor (Cst). Depending on some example embodiments, the second gate conductive layer may further include scan lines, control lines, or voltage lines. The second gate conductive layer may include metal such as copper (Cu), molybdenum (Mo), aluminum (Al), titanium (Ti), or metal alloys thereof, and may be a single layer or a multilayer.

A first interlayer insulation layer 161 may be disposed on the second gate conductive layer. The first interlayer insulation layer 161 may include an inorganic insulation layer including silicon oxide (SiO2), silicon nitride (SiNx), silicon oxynitride (SiOxNy), etc. Depending on some example embodiments, the inorganic insulating material may be formed to be relatively thick.

An oxide semiconductor layer (ACT2(IGZO)) including a channel, a first region, and a second region of the oxide transistor (Oxide TFT) may be disposed on the first interlayer insulation layer 161.

A third gate insulation layer 143 may be disposed on the oxide semiconductor layer (ACT2(IGZO)). The third gate insulation layer 143 may be disposed on the front surfaces of the oxide semiconductor layer (ACT2(IGZO)) and the first interlayer insulation layer 161. The third gate insulation layer 143 may include an inorganic insulation layer including silicon oxide (SiO2), silicon nitride (SiNx), or silicon oxynitride (SiOxNy).

A third gate conductive layer GAT3 including the gate electrode of the oxide transistor (Oxide TFT) may be disposed on the third gate insulation layer 143. The gate electrode of the oxide transistor (Oxide TFT) may overlap the channel. The third gate conductive layer GAT3 may further include scan lines or control lines, and may additionally include a connecting electrode connected to the lower shielding layer (GAT2(BML)) of the oxide transistor (Oxide TFT). The third gate conductive layer GAT3 may include a metal such as copper (Cu), molybdenum (Mo), aluminum (Al), titanium (Ti), or metal alloys thereof, and may be a single layer or a multilayer.

A second interlayer insulation layer 162 may be disposed on the third gate conductive layer GAT3. The second interlayer insulation layer 162 may have a single-layer or multi-layer structure. The second interlayer insulation layer 162 may include an inorganic insulating material such as silicon nitride (SiNx), silicon oxide (SiO2), or silicon oxynitride (SiOxNy), and may include an organic material, depending on some example embodiments.

A first data conductive layer SD1, which includes connecting electrodes that may be connected to the first region and the second region of each of the polycrystalline transistor (LTPS TFT) and the oxide transistor (Oxide TFT) may be disosed on the second interlayer insulation layer 162

The first data conductive layer SD1 may include a metal such as aluminum (Al), copper (Cu), molybdenum (Mo), titanium (Ti), etc., or metal alloys thereof, and may be a single layer or a multilayer.

A first organic layer 181 may be disposed on the first data conductive layer SD1. The first organic layer 181 may be an organic insulator including an organic material, and the organic material may include at least one of polyimide, polyamide, acryl resin, benzocyclobutene, or phenol resin.

A second data conductive layer including an anode connecting electrode ACM2 may be disposed on the first organic layer 181. The second data conductive layer may include data lines or driving voltage lines. The second data conductive layer SD2 may include a metal such as aluminum (Al), copper (Cu), molybdenum (Mo), titanium (Ti), or metal alloys thereof, and may be a single layer or a multilayer.

The second organic layer 182 and the third organic layer 183 are disposed on the second data conductive layer, and an anode connecting opening OP4 is formed in the second organic layer 182 and the third organic layer 183. The anode connecting electrode ACM2 is electrically connected to the anode through the anode connecting opening OP4. The second organic layer 182 and the third organic layer 183 may be organic insulators and may include at least one of polyimide, polyamide, acryl resin, benzocyclobutene, or phenol resin. Depending on some example embodiments, the third organic layer 183 may be omitted.

The pixel defining layer 380 having an opening OP exposing the anode and covering at least a portion of the anode may be disposed on the anode. The pixel defining layer 380 may be a black pixel defining layer formed of or including a black organic material to reduce or prevent externally applied light from being reflected back to the outside, and may be formed of or including a transparent organic material, depending on some example embodiment. Therefore, depending on some example embodiments, the pixel defining layer 380 may include a negative-type black organic material and may include a black pigment.

The spacer 385 is disposed on the pixel defining layer 380. The spacer 385 may include a first portion 385-1 disposed in a relatively tall and narrow region and a second portion 385-2 disposed in a relatively short and wide region. The spacer 385, unlike the pixel defining layer 380, may be formed of or include a transparent organic insulating material. According to some example embodiments, the spacer 385 may be formed of a positive-type transparent organic material.

The functional layer FL and the cathode are sequentially formed on the anode, the spacer 385, and the pixel defining layer 380, and the functional layer FL and the cathode may be disposed in all regions of the display area DA and the first component area EA1. The light emitting layer EML is disposed between the functional layers FL, and the light emitting layer EML may be disposed in the opening OP of the pixel defining layer 380. A combination of the functional layer FL and the light emitting layer EML may be referred to as an intermediate layer. The functional layer FL may include at least one auxiliary layer from among an electron injection layer, an electron transport layer, a hole transport layer, or a hole injection layer, and the hole injection layer and the hole transport layer may be disposed on a lower portion of the light emitting layer EML, and the electron transport layer and the electron injection layer may be disposed on an upper portion of the light emitting layer EML.

The encapsulation layer 400 is disposed on the cathode. The encapsulation layer 400 includes at least one inorganic layer and at least one organic layer, and may have a triple-layer structure including a first inorganic encapsulation layer, an organic encapsulation layer, and a second inorganic encapsulation layer, depending on some example embodiments. The encapsulation layer 400 may protect the light emitting layer EML from moisture or oxygen that may be introduced from the outside. Depending on some example embodiments, the encapsulation layer 400 may include a structure in which an inorganic layer and an organic layer are sequentially stacked.

The sensing insulation layers 501, 510, and 511 and the sensing electrodes 540 and 541 are disposed on the encapsulation layer 400 to detect touch. In the example embodiment of FIG. 17, touch may be detected in a capacitive type using two sensing electrodes 540 and 541.

For example, the first sensing insulation layer 501 is formed on the encapsulation layer 400, and the sensing electrodes 540 and 541 are formed thereon. The sensing electrodes 540 and 541 may be insulated with the second sensing insulation layer 510 therebetween, and some may be electrically connected through the opening disposed in the second sensing insulation layer 510. The sensing electrodes 540 and 541 may include metal such as aluminum (Al), copper (Cu), silver (Ag), gold (Au), molybdenum (Mo), titanium (Ti), tantalum (Ta), or metal alloys thereof, and may be a single layer or a multilayer. The third sensing insulation layer 511 is formed on the sensing electrode 540.

The scattering layer 210, the light blocking layer 220, and the color filters 230R, 230G, and 230B are disposed on the third sensing insulation layer 511.

The scattering layer 210 may be disposed to overlap the pixel defining layer 380 and the sensing electrodes 540 and 541 in a plan view, and a portion of the scattering layer 210 may overlap the anode in a plan view, and another portion may not overlap the anode. The scattering layer 210 may overlap the pixel defining layer 380 in a plan view. The scattering layer 210 includes scattering particles 211 scattering light, and has an opening OPSL overlapping at least a portion of the opening OP of the pixel defining layer 380 in a plan view. The size, shape, and arrangement direction of the opening OPSL of the scattering layer 210 may vary, and the opening OPSL of the scattering layer 210 may be formed with different sizes in subpixels of different colors, and the gaps where the scattering layer 210 and the opening OP of the pixel defining layer 380 overlap are formed differently in the red, green, and blue subpixels.

The light blocking layer 220 may be disposed to overlap the sensing electrodes 540 and 541 in a plan view. The light blocking layer 220 has a second opening OPBM, and the second opening OPBM of the light blocking layer 220 overlaps the opening OP of the pixel defining layer 380 in a plan view. The second opening OPBM of the light blocking layer 220 may be formed wider than the opening OP of the pixel defining layer 380. Thus, the anode overlapping (e.g., exposed by the opening OP of the pixel defining layer 380) the opening OP of the pixel defining layer 380 may not be covered by the light blocking layer 220 in a plan view. This is to reduce or prevent the anode and the light emitting layer EML displaying images from being covered by the light blocking layer 220 and the sensing electrodes 540 and 541. The second opening OPBM of the light blocking layer 220 may be formed to be larger than the opening OPSL of the scattering layer 210, and at least a portion of the second opening OPBM of the light blocking layer 220 may overlap the opening OPSL of the scattering layer 210 in a plan view. The light blocking layer 220 overlaps the anode connecting opening OP4 but does not overlap the opening OP3 of the first organic layer 181 in a plan view.

The color filters 230R, 230G, and 230B are disposed on the sensing insulation layers 501, 510, and 511, the scattering layer 210, and the light blocking layer 220. Depending on some example embodiments, the color filters 230R, 230G, and 230B may be replaced with color conversion layers or may further include a color conversion layer. The color conversion layer may include quantum dots.

The planarization layer 550 covering the color filters 230R, 230G, and 230B may be disposed on the color filters 230R, 230G, and 230B, and depending on some example embodiments, a low-refraction layer and an additional planarization layer may be further disposed on the planarization layer 550 to improve the front visibility and/or light emission efficiency of the display device. Light may be refracted and emitted toward the front surface by the low-refraction layer and the additional planarization layer with high refraction characteristics. Depending on some example embodiments, the planarization layer 550 may be omitted and the low-refraction layer and the additional planarization layer may be disposed directly on the color filter 230.

In the present example embodiment, no polarization plate is included on the planarization layer 550. The polarization plate may reduce or prevent the user from seeing deteriorated images when external light is incident and is reflected from the anode, etc. However, according to the present example embodiment, the pixel defining layer 380 covers a side of the anode to reduce reflection of light from the anode, and the scattering layer 210 and the light blocking layer 220 are formed to reduce the incident degree of light, thereby reducing or preventing deterioration of display quality caused by reflection. Therefore, there is no need to separately form the polarization plate on the front surface of the display panel DP.

FIG. 17 also shows a cross-section of the first component area EA1 formed to allow light to be transmitted through a portion of the display area DA in addition to the stacking structure of the display area DA.

Referring to FIG. 17, the first component area EA1 is divided into a first photosensor region OPS1 (or a transmission-type photosensor region) and a second photosensor region OPS2 (or a non-transmission-type photosensor region). Additional openings OP-1, OPSL-1, and OPBM-1 are disposed in the first photosensor region OPS1 so that the first photosensor region OPS1 may not overlap the pixel defining layer 380, the scattering layer 210, and the light blocking layer 220 in a plan view and light may be transmitted therethrough. The second photosensor region OPS2 is formed to overlap the pixel defining layer 380, the scattering layer 210, and the light blocking layer 220 in a plan view so that light is not transmitted therethrough. The first photosensor region OPS1 of the first component area EA1 may not include a light blocking layer such as a metal layer or a semiconductor layer, and the second photosensor region OPS2 of the first component area EA1 may not include a light blocking layer such as a metal layer or a semiconductor layer. Depending on the example embodiment, light may not be transmitted therethrough, so light blocking layers such as a metal layer or a semiconductor layer may be disposed in some regions. For reference, a first optical element ES1 (refer to FIG. 2) may be disposed on the rear surface of the first component area EA1, and the front surface of the light emitting display device may be detected through the first photosensor region OPS1 disposed in the first component area EA1. When the number of the first photosensor regions OPS1 and the second photosensor regions OPS2 in one first component area EA1 may be adjusted, the sensor disposed on the rear surface of the first component area EA1 may detect the front surface of the light emitting display device, and the reflected colors of light in the first component area EA1 may be improved. Thus, depending on some example embodiment, the first component area EA1 may have different reflectance or reflected colors from the display area surrounding the first component area EA1, which may reduce or prevent the first component area EA1 from being perceived by the user.

For example, the layered structure of the first component area EA1 is as follows.

The buffer layer 111 that is an inorganic insulation layer is disposed on the substrate 110, and the first gate insulation layer 141 and the second gate insulation layer 142 that is inorganic insulation layers are sequentially disposed thereon. The first interlayer insulation layer 161, the third gate insulation layer 143, and the second interlayer insulation layer 162 that is inorganic insulation layers are sequentially stacked on the second gate insulation layer 142.

The first organic layer 181, the second organic layer 182, and third organic layer 183 that is the organic insulators are sequentially stacked on the second interlayer insulation layer 162.

The functional layer FL may be disposed on the third organic layer 183, and the cathode may be disposed thereon.

The encapsulation layer 400 is disposed on the cathode, and the sensing insulation layers 501, 510, and 511 are sequentially disposed thereon. The encapsulation layer 400 may have a triple-layer structure sequentially including an inorganic encapsulation layer, an organic encapsulation layer, and an inorganic encapsulation layer. The sensing insulation layers 501, 510, and 511 may be inorganic insulation layers.

The planarization layer 550 may be disposed on the sensing insulation layers 501, 510, and 511.

The metal layer, the first semiconductor layer, the first gate conductive layer, the second gate conductive layer, the oxide semiconductor layer, the third gate conductive layer, the first data conductive layer, the second data conductive layer, and the anode are not disposed in the first component area EA1. The light emitting layer EML and the sensing electrodes 540 and 541 are not formed.

Additional openings OP-1, OPSL-1, and OPBM-1 may be formed in the pixel defining layer 380, the scattering layer 210, and the light blocking layer 220 in the first photosensor region OPS1 of the first component area EA1 so the pixel defining layer 380, the scattering layer 210, and the light blocking layer 220 may not be formed. Thus, light may be transmitted through the first photosensor region OPS1 and may not be scattered. The second photosensor region OPS2 in the first component area EA1 does not have the additional openings OP-1, OPSL-1, and OPBM-1 disposed therein, so it may overlap the pixel defining layer 380 and the light blocking layer 220 and light may not be transmitted.

The example embodiment in which three organic layers are formed, and the anode connecting opening is formed in the second organic layer and the third organic layer has been described. However, at least two of the organic layers may be formed, in which case the anode connecting opening may be disposed in the upper organic layer, which is disposed away from the substrate, and the lower organic layer opening may be disposed in the lower organic layer.

An example embodiment in which a light blocking region of a color filter is formed by overlapping the blue color filter 230B and the red color filter 230R instead of a light blocking layer 220 will now be described with reference to FIG. 18.

The third sensing insulation layer 511 and the structure therebelow in FIG. 18 corresponds to the structure of FIG. 17, so an upper structure of the third sensing insulation layer 511 that is different from FIG. 17 will now be described in detail.

The color filters 230R, 230G, and 230B are disposed on the third sensing insulation layer 511. The example embodiment of FIG. 18 does not include the light blocking layer, a function of the light blocking layer is performed by the overlapping color filters 230R and 230B, and the overlapping color filters 230R and 230B may be disposed to overlap the scattering layer 210 and the sensing electrodes 540 and 541 in a plan view. The overlapping color filters 230R and 230B have a second opening OPCF, and the second opening OPCF of the overlapping color filters 230R and 230B overlaps the opening OP of the pixel defining layer 380 and the opening OPSL of the scattering layer 210. The second opening OPCF of the overlapping color filters 230R and 230B may be formed wider than the opening OP of the pixel defining layer 380. Thus, the anode overlapping (ie.g., which is exposed by the opening OP of the pixel defining layer 380) the opening OP of the pixel defining layer 380 may not be covered by the overlapping color filters 230R and 230B in a plan view. This is to reduce or prevent the anode and the light emitting layer EML for displaying images from being covered by the overlapping color filters 230R and 230B and the sensing electrodes 540 and 541. The overlapping color filters 230R and 230B overlap the anode connecting opening OP4 in a plan view.

Among the overlapping color filters 230R and 230B, the width of the blue color filter 230B disposed above the width of the red color filter 230R disposed below may be narrower than the color filter gap gcf, and the color filter gap gcf may have a value of 0 µm to about 2 µm, depending on some example embodiment. Depending on some example embodiment, as shown in FIG. 14, when three color filters overlap to form the light blocking region of the color filter having the same characteristic as the light blocking layer, the two color filters overlapping and neighboring each other may have the color filter gap gcf, and the color filter gap gcf may have the value of 0 µm to about 2 µm.

The second opening OPCF of the overlapping color filters 230R and 230B may be formed larger than the opening OPSL of the scattering layer 210, and at least a portion of the second opening OPCF of the overlapping color filters 230R and 230B may overlap the opening OPSL of the scattering layer 210 in a plan view. The size, shape, and arrangement direction of the opening OPSL of the scattering layer 210 may vary, and the opening OPSL of the scattering layer 210 may be formed with different sizes in subpixels of different colors, and the gaps where the scattering layer 210 and the opening OP of the pixel defining layer 380 overlap are formed differently in the red, green, and blue subpixels. Thus, when the viewing angle changes, the color coordinate values and color changes of white change below a desired (or alternatively, predetermined) level, thereby improving the display quality of the light emitting display device.

A color filter may be disposed within the second opening OPCF of the overlapping color filters 230R and 230B, and the green color filter 230G is disposed therein in FIG. 18. Depending on some example embodiment, the color filters 230R, 230G, and 230B may be replaced with color conversion layers or may further include a color conversion layer. The color conversion layer may include quantum dots.

The planarization layer 550 covering the color filters 230R, 230G, and 230B is disposed on the color filters 230R, 230G, and 230B. The planarization layer 550 covering the color filters 230R, 230G, and 230B may be disposed on the color filters 230R, 230G, and 230B, and a low-refraction layer and an additional planarization layer may be further disposed on the planarization layer 550 to improve the front visibility and/or light emission efficiency of the display device. Depending on some example embodiment, the planarization layer 550 may be omitted and the low-refraction layer and the additional planarization layer may be disposed directly on the color filter.

In the example embodiment of FIG. 18, the polarization plate is not included on the upper portion of the planarization layer 550. The polarization plate may reduce or prevent the user from seeing deteriorated images when external light is incident and is reflected from the anode. However, according to the present example embodiment, the pixel defining layer 380 covers a side of the anode to reduce reflection of light from the anode, and the overlapping color filters 230R and 230B and the scattering layer 210 are formed to reduce the degree of incident light, thereby reducing or preventing deterioration of display quality caused by reflection. Therefore, there is no need to separately form the polarization plate on the front surface of the display panel DP.

A cross-sectional structure of the first component area EA1 according to an example embodiment of FIG. 18 will now be described

The first component area EA1 is divided into the first photosensor region OPS1 and the second photosensor region OPS2. The additional openings OP-1, OPSL-1, and OPCF-1 are disposed in the first photosensor region OPS1 so that the first photosensor region OPS1 may not overlap the pixel defining layer 380, the scattering layer 210, and at least two color filters in a plan view, and light may be transmitted therethrough. The second photosensor region OPS2 is formed to overlap the pixel defining layer 380, the scattering layer 210, and the light blocking region of the color filter by overlapping at least two color filters in a plan view, and light may not be transmitted therethrough. The first photosensor region OPS1 and the second photosensor region OPS2 of the first component area EA1 may not include a light blocking layer such as a metal layer or a semiconductor layer. For reference, a first optical element ES1 (refer to FIG. 2) may be disposed on the rear surface of the first component area EA1, and the front surface of the light emitting display device may be detected through the first photosensor region OPS1 disposed in the first component area EA1.

A layered structure of the first component area EA1 will now be described.

The buffer layer 111 is disposed on the substrate 110, and the first gate insulation layer 141 and the second gate insulation layer 142, both of which are inorganic insulation layers, are sequentially disposed thereon. Additionally, the first interlayer insulation layer 161, the third gate insulation layer 143, and the second interlayer insulation layer 162, which are inorganic insulation layers, are sequentially stacked on the second gate insulation layer 142.

The first organic layer 181, the second organic layer 182, and third organic layer 183, which are organic insulators, are sequentially stacked on the second interlayer insulation layer 162.

The functional layer FL may be disposed on the third organic layer 183, and the cathode may be disposed thereon.

The encapsulation layer 400 is disposed on the cathode, and the sensing insulation layers 501, 510, and 511 are sequentially disposed thereon. The encapsulation layer 400 may have a triple-layer structure sequentially including an inorganic encapsulation layer, an organic encapsulation layer, and an inorganic encapsulation layer. The sensing insulation layers 501, 510, and 511 may be inorganic insulation layers.

The planarization layer 550 may be disposed on the sensing insulation layers 501, 510, and 511.

The metal layer, the first semiconductor layer, the first gate conductive layer, the second gate conductive layer, the oxide semiconductor layer, the third gate conductive layer, the first data conductive layer, the second data conductive layer, and the anode are not disposed in the first component area EA1. The light emitting layer EML and the sensing electrodes 540 and 541 are not formed.

The additional openings OP-1, OPSL-1, and OPCF-1 may be formed in the pixel defining layer 380, the scattering layer 210, and the light blocking region of the color filter in the first photosensor region OPS1 of the first component area EA1, so the pixel defining layer 380 and the color filter may not be formed. Thus, light may be transmitted through the first photosensor region OPS1. The second photosensor region OPS2 in the first component area EA1 does not have the additional openings OP-1, OPSL-1, and OPCF-1 disposed therein, so it may overlap the pixel defining layer 380, the scattering layer 210, and the light blocking region of the color filter, and light may not be transmitted and may not be scattered.

The example embodiment in which three organic layers are formed, and the anode connecting opening is formed in the second organic layer and the third organic layer has been described. However, at least two of the organic layers may be formed, in which case the anode connecting opening may be disposed in the upper organic layer, which is disposed away from the substrate, and the lower organic layer opening may be disposed in the lower organic layer.

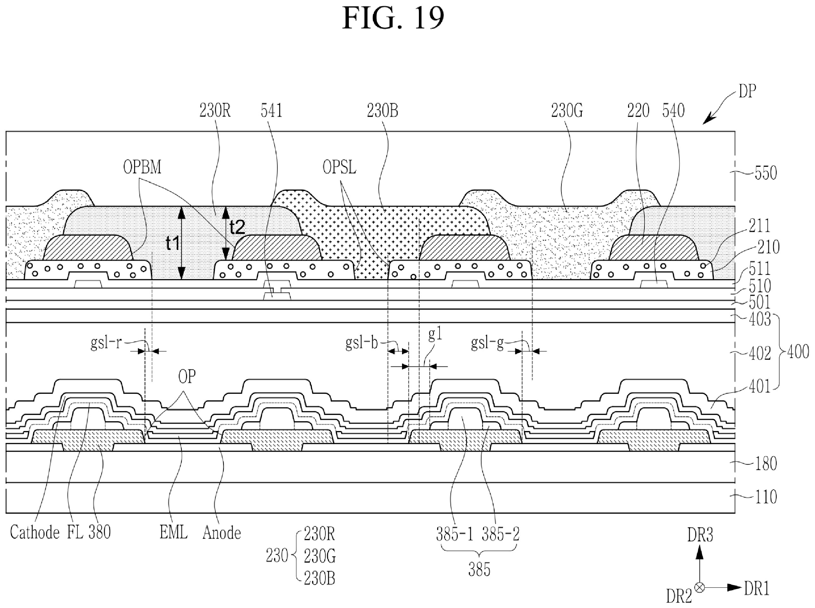

As described above, by differently forming the gaps where the scattering layer 210 and the opening OP of the pixel defining layer 380 overlap in a plan view in the red, green, and blue subpixels, the color coordinate values of white displayed by the light emitting display device and the color change of the displayed image may be made to have the merit of changing below a desired (or alternatively, predetermined) level even when the viewing angle changes. However, because the scattering layer 210 and the scattering layer opening OPSL are formed below the color filter 230, the color filter 230 may be formed with different thicknesses depending on the position, which may affect the color of the displayed images. This will be described in detail with reference to FIG. 19.

FIG. 19 shows a cross-sectional view additionally illustrating the thickness of a color filter according to an example embodiment of FIG. 8.

FIG. 19, in addition to FIG. 8, is a drawing that further illustrates that the thickness of the red color filter 230R may vary depending on the position.

Referring to the color filters 230R, 230G, and 230B in FIG. 19, it may be seen that a portion of the color filters 230R, 230G, and 230B covering the opening OPSL of the scattering layer 210 is formed with a thickness of t1, but a portion of the color filters 230R, 230G, and 230B covering the scattering layer 210 is formed with a thickness of t2, which is less than the thickness of t1. The thickness of the portion covering the light blocking layer 220 from among the color filters 230R, 230G, and 230B is less than the thickness of t2, but this portion is not considered because it does not affect the color of the displayed image because light is not transmitted due to the light blocking layer 220.

Therefore, the color and/or color coordinate values of the light emitted by the light emitting layer EML may differ depending on which portion of the color filters 230R, 230G, and 230B it is transmitted through as it progresses to the front surface. That is, the color will be relatively strong when being transmitted through the portions of the color filters 230R, 230G, and 230B with a relatively big thickness of t1, but the color will be relatively weak when being transmitted through the portions of the color filters 230R, 230G, and 230B with a relatively small thickness of t2. Therefore, in the case of the light emitting display device in which the scattering layer 210 and the scattering layer opening OPSL are formed below the color filters 230R, 230G, and 230B, removal of color differences of the color filters 230R, 230G, and 230B with respect to thickness may be desired.

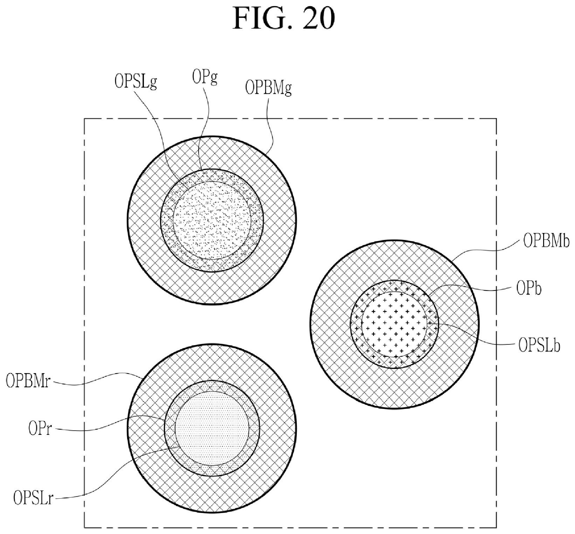

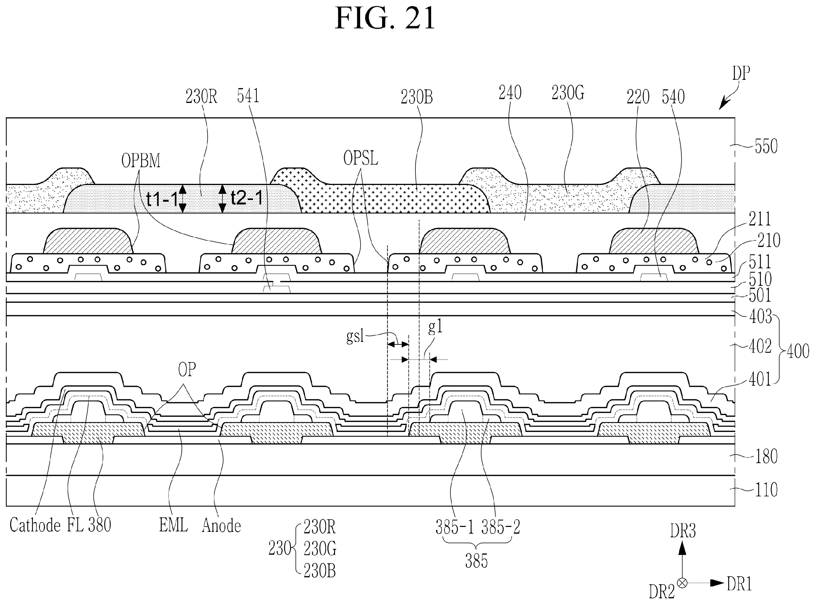

The light emitting display device in which the scattering layer 210 and the scattering layer opening OPSL are formed on the lower portions of the color filters 230R, 230G, and 230B and in which the thicknesses of the color filters 230R, 230G, and 230B, through which light emitted by the light emitting layer EML is transmitted, are formed to be constant to display the images with improved color quality, will be described with reference to FIG. 20 and FIG. 21.

A planar structure will now be described with reference to FIG. 20.

FIG. 20 shows a top plan view illustrating a portion of a display panel according to another example embodiment.

FIG. 20 is a plan view corresponding to FIG. 7, but unlike FIG. 7, the gaps where the scattering layer 210 and the opening OP of the pixel defining layer 380 overlap in a plan view are constant in the red, green, and blue subpixels.

For example, FIG. 20 shows the openings OPr, OPg, and OPb of the pixel defining layer 380 corresponding to three red, green, and blue subpixels belonging to one unit pixel, respectively, and the second openings OPBMr, OPBMg, and OPBMb of one light blocking layer 220 corresponding thereto, and the openings OPSLr, OPSLg, and OPSLb of one scattering layer 210. Referring to FIG. 20, the pixel defining layer 380 is disposed outside the openings OPr, OPg, and OPb of the pixel defining layer 380, the light blocking layer 220 is disposed outside the second openings OPBMr, OPBMg, and OPBMb of the light blocking layer 220, and the scattering layer 210 is disposed outside the openings OPSLr, OPSLg, and OPSLb of the scattering layer 210. The gaps where the scattering layer 210 and the openings OPr, OPg, and OPb of the pixel defining layer 380 overlap are formed to have a constant gap in the red, green, and blue subpixels, unlike in FIG. 7. Here, r, g, and b may correspond to red, green, and blue, respectively.

Referring to FIG. 20, the opening OPr for red, the opening OPg for green, and the opening OPb for blue of the pixel defining layer 380 and the second opening OPBMr for red, the second opening OPBMg for green, and the second opening OPBMb for blue of the light blocking layer 220 may each be formed into circles with different radii depending on the sizes of the openings OPSLr, OPSLg, and OPSLb of the corresponding scattering layer 210. The openings OPr, OPg, and OPb of the same color, the second openings OPBMr, OPBMg, and OPBMb, and the openings OPSLr, OPSLg, and OPSLb of the scattering layer 210 each have the same radius and may be formed with the same size, or may be formed with two or more different sizes. The gap where the scattering layer 210 and the openings OPr, OPg, and OPb of the pixel defining layer 380 overlap in the same color may be formed with the same size, or may be formed with different sizes, depending on the position. In the example embodiment of FIG. 20, the openings are depicted as circular, but depending on some example embodiment, they may be formed in a planar shape such as an ellipse, a closed curve similar to a circle, or a polygon. At this time, the gap where the scattering layer 210 and the openings OPr, OPg, and OPb of the pixel defining layer 380 overlap other may have the same value in the color subpixels.

The openings OPr, OPg, and OPb of one pixel defining layer 380 correspond to the openings OPSLr, OPSLg, and OPSLb of one scattering layer 210 and the second openings OPBMr, OPBMg, and OPBMb of one light blocking layer 220, respectively. That is, the openings OPSLr, OPSLg, and OPSLb of the scattering layer 210 and the openings OPr, OPg, and OPb of the pixel defining layer 380 corresponding to the second openings OPBMr, OPBMg, and OPBMb, respectively, of the light blocking layer 220 are disposed in the second openings OPBMr, OPBMg, and OPBMb of the light blocking layer 220. The second openings OPBMr, OPBMg, and OPBMb of the corresponding light blocking layer 220, the openings OPSLr, OPSLg, and OPSLb of the scattering layer 210, and the openings OPr, OPg, and OPb of the pixel defining layer 380 may overlap in a plan view.

In FIG. 20, additional hatching is drawn to indicate a portion of the scattering layer 210 that is not covered by the light blocking layer 220 and is visible on the front surface. This hatching may represent the scattering layer 210 not covered by the light blocking layer 220 throughout the specification, thereby indicating a portion where light may be scattered by scattering particles (211 in FIG. 21). Three different hatchings are used to represent the red, green, and blue light emitting layers exposed by the openings OPr, OPg, and OPb, respectively, of the pixel defining layer 380. It is found in the example embodiment of FIG. 20 that some of the light emitting layers exposed by the openings OPr, OPg, and OPb of the pixel defining layer 380 overlap the scattering layer 210, and some of the remaining layers do not overlap the scattering layer 210.

The openings OPr, OPg, and OPb of the pixel defining layer 380 and the second openings OPBMr, OPBMg, and OPBMb of the light blocking layer 220 are formed to have circular shapes in a plan view, and the openings OPSLr, OPSLg, and OPSLb of the scattering layer 210 are formed to have circular shapes in a plan view, and the three openings may have the same center.

The radius values of the circular shapes of the openings OPr, OPg, and OPb of the pixel defining layer 380 may be larger than the radius values of the elliptical shapes of the openings OPSLr, OPSLg, and OPSLb of the scattering layer 210, and the radius values of the circular shapes of the second openings OPBMr, OPBMg, and OPBMb of the light blocking layer 220 are also formed to be larger than the radius values of the openings OPSLr, OPSLg, and OPSLb of the scattering layer 210 and the radius values of the openings OPr, OPg, and OPb of the pixel defining layer 380. Depending on some example embodiments, the openings OPSLr, OPSLg, and OPSLb of the scattering layer 210 may be smaller than the second openings OPBMr, OPBMg, and OPBMb of the light blocking layer 220 by at least about 1 µm, and may be smaller than the openings OPr, OPg, and OPb of the pixel defining layer 380 by no more than about 10 µm. In this way, the side wall area of the openings OPr, OPg, and OPb of the pixel defining layer 380 is covered with the scattering layer 210, and the remaining light emitting layer is formed with the openings OPSLr, OPSLg, and OPSLb of the scattering layer 210. When external light enters the inside and is reflected at various angles from the side wall of the pixel defining layer 380, color separation occurs. The scattering particles 211 of the scattering layer 210 overlapping the same scatter the external light, making it difficult for the user to see the color-separated reflected light, and the resulting rainbow spots may be made weaker or may be removed.

In the example embodiment of FIG. 20, unlike the example embodiment of FIG. 7, the width of the scattering layer 210 covering the light emitting layer exposed by the openings OPr, OPg, and OPb of the pixel defining layer 380 may have the same width, regardless of the color of the emitted light. In the example embodiment of FIG. 20, the effect shown in FIG. 7 and FIG. 8-that is, the effect of the color coordinate value of white and the change in color tone changing below a desired (or alternatively, predetermined) level when the viewing angle changes-may not be achieved. However, as shown in FIG. 21, it may have the merit of displaying an image with improved color quality by forming a constant thickness of the color filters 230R, 230G, and 230B through which light emitted by the light emitting layer EML is transmitted.

In the example embodiment of FIG. 20, the openings OPSLr, OPSLg, and OPSLb of the scattering layer 210 are formed for all color subpixels, but depending on some example embodiments, the openings OPSLr, OPSLg, and OPSLb of the scattering layer 210 may not be formed for one or two colors, and the light emitting layer of the corresponding color may be covered by the scattering layer 210. The openings OPSLr, OPSLg, and OPSLb of the scattering layer 210 may be arranged to have a specific period or may be arranged randomly.

Depending on some example embodiments, the thickness or haze value of the scattering layer 210 may be the same for all colors, and may be formed to have different thickness and haze values, depending on the color.

The planar structure has been described with reference to FIG. 20. A stacking structure of the light emitting display panel DP according to an example embodiment will now be described with reference to FIG. 21.

FIG. 21 shows a cross-sectional view illustrating a display panel according to the example embodiment of FIG. 20.

FIG. 21 corresponds to the cross-section of FIG. 8, but unlike the example embodiment of FIG. 8, it further includes a step-removing organic layer 240 for covering the scattering layer 210 and the light blocking layer 220.

For example, the light emitting display panel DP according to the example embodiment of FIG. 21 may display images by forming a light emitting diode on the substrate 110, may detect touch by including the sensing electrodes 540 and 541, and has the light blocking layer 220 and the color filters 230R, 230G, and 230B so that light emitted by the light emitting diode has the color characteristics of the color filters 230R, 230G, and 230B. For example, the color filters 230R, 230G, and 230B may be formed with a constant thickness when the step is reduced or removed by the step-removing organic layer 240. Thus, the thickness of the portion through which light emitted by the light emitting layer EML is transmitted from among the color filters 230R, 230G, and 230B may be constant so that the color quality of the displayed image is consistent.

The example embodiment of FIG. 21 further includes a scattering layer 210 below the light blocking layer 220, and the scattering layer 210 includes scattering particles 211 so that light may be reflected or refracted from the scattering particles 211. The scattering layer 210 may be a colorless, transmittable layer that does not have a color in the visible light band. For example, the scattering layer 210 may include a colorless, light transmitting organic material such as acryl-based resin, and depending on some example embodiments, the scattering layer 210 may include a transparent photosensitive organic material. The scattering particles 211 may be formed of a material having a different refractive index from the scattering layer 210, and may include, for example, at least one of titanium oxide (TiO2), silicon oxide (SiO2), zirconium oxide (Zr2O3), aluminum oxide (Al2O3), hollow silica, an acrylate-based material, or a silicon-based material. The hollow silica may have a structure in which the inside of particles of the silicon oxide (SiO2) having a three-dimensional shape such as a sphere has an empty space.

A polarization plate is not formed on the front surface of the light emitting display panel DP, and instead, the pixel defining layer 380 is formed with a black organic material, and the light blocking layer 220 and the color filter 230 are formed on the upper surface so that when external light is introduced to the inside, it may not be reflected from the anode or the like and transmitted to the user, and the scattering layer 210 may be disposed on the upper surface so that when external light is introduced or reflected, it may be scattered and the intensity of the external light may be reduced. Because the polarization plate is not formed, the luminance does not decrease as some of the light emitted by the light emitting layer is absorbed by the polarization plate, so the light emitting display device having a maximum luminance value of about 2500 nits or more may be provided.

The scattering layer 210 may include the scattering particles 211, which scatter incident light in various directions. In the case of the light emitting display device including no polarization plate, various diffraction patterns may occur when external light is incident and reflected and diffracted at the anode. However, when the external light is scattered through the scattering layer 210, the intensity may be weakened, causing the diffraction pattern to appear weaker. However, a problem may arise where the light reflected from the anode interferes with the scattering particles 211 of the scattering layer 210, causing it to be recognized as a rainbow spot. In the present disclosure, the openings OPSLr, OPSLg, and OPSLb (also referred to as scattering layer openings) are formed in the scattering layer 210 corresponding to the anode, and the position of the scattering layer openings OPSLr, OPSLg, and OPSLb may be adjusted to reduce or remove rainbow spots.

The light emitting display panel DP according to an example embodiment will now be described with reference to FIG. 21.

The substrate 110 may include a material that is rigid and does not bend such as glass or a flexible material that may be bent such as plastic or polyimide.

Thin-film transistors are formed on the substrate 110, but are omitted in FIG. 21, and the organic layer 180 covering the thin-film transistors is shown. One pixel is formed with a pixel circuit portion including a light emitting diode, transistors transmitting a light emitting current to the light emitting diode, and a capacitor. In FIG. 21, the pixel circuit portion is not illustrated, and the structure of the pixel circuit portion may vary, depending on some example embodiments. FIG. 21 shows the organic layer 180 covering the pixel circuit portion.

The light emitting diode including an anode, a light emitting layer EML, and a cathode is disposed on the organic layer 180.

The anode may be a single layer including a transparent conductive oxide layer and a metal material, or a multilayer including the same. The transparent conductive oxide layer may include indium tin oxide (ITO), poly-ITO, indium zinc oxide (IZO), indium gallium zinc oxide (IGZO), or indium tin zinc oxide (ITZO), and the metal material may include silver (Ag), molybdenum (Mo), copper (Cu), gold (Au), or aluminum (Al).

The light emitting layer EML may be formed of an organic light emitting material, and the adjacent light emitting layer EMLs may display different colors. Depending on some example embodiments, the light emitting layer EML may display light of the same color due to the color filters 230R, 230G, and 230B disposed on the upper portion. Depending on some example embodiment, the light emitting layer EML may have a structure (or a tandem structure) in which emitting layers are stacked.

The pixel defining layer 380 is disposed on the organic layer 180 and the anode, the opening OP is formed in the pixel defining layer 380, and the opening overlaps a portion of the anode, and the light emitting layer EML is disposed on the anode exposed by the opening OP. The light emitting layer EML may be disposed in the opening OP of the pixel defining layer 380, and is separated from the adjacent light emitting layer EML by the pixel defining layer 380.

The pixel defining layer 380 may be formed of an organic material with a negative type black color. The black organic material may include a light blocking material, and the light blocking material may include carbon black, carbon nanotubes, a resin or paste having black dye, metal particles such as nickel, aluminum, molybdenum, alloys thereof, metal oxide particles, or chromium nitride. The pixel defining layer 380 is black, including a light blocking material, and may have the characteristic of absorbing/blocking light without reflecting it. The negative-type organic material is used, so the portion covered by the mask may be removed.

The spacer 385 is formed on the pixel defining layer 380. The spacer 385 includes the first portion 385-1 disposed in a relatively tall and narrow region and the second portion 385-2 disposed in a relatively short and wide region. In FIG. 21, the first portion 385-1 and the second portion 385-2 are shown as separated by a dotted line in the spacer 385. The first portion 385-1 may reinforce scratch resistance and secure rigidity against pressing pressures. The second portion 385-2 may serve as a contact assistant between the pixel defining layer 380 and the upper functional layer FL. The first portion 385-1 and the second portion 385-2 are formed of the same material, which may be formed of a positive-type photosensitive organic material-for example, photosensitive polyimide (PSPI) may be used. As it has a positive characteristic, the portion not covered by the mask may be removed. The spacer 385 is transparent, allowing light to be transmitted through and/or be reflected.

The pixel defining layer 380 may be formed as a negative type, the spacer 385 may be formed as a positive type, and depending on some example embodiments, the pixel defining layer 380 and the spacer 385 may include a material of the same type.

At least a portion of the upper surface of the pixel defining layer 380 is covered by the spacer 385, and the edge of the second portion 385-2 is spaced apart from the edge of the pixel defining layer 380 so that a portion of the pixel defining layer 380 is not covered by the spacer 385. The second portion 385-2 may cover the upper surface of the pixel defining layer 380 where the first portion 385-1 is not disposed, thereby strengthening the adhesion between the pixel defining layer 380 and the functional layer FL. In the present example embodiment, the spacer 385 is disposed in a region overlapping the light blocking layer 220 to be described later, so the spacer 385 may be covered by the light blocking layer 220 and may not be visible when viewed from the front surface of the display panel DP.

The functional layer FL is disposed on the spacer 385 and the exposed pixel defining layer 380. The functional layer FL may be formed on the front surface of the light emitting display panel DP or may be formed in all regions except for some regions-for example, the light transmission area of the second component area EA2. The functional layer FL may include the electron injection layer, the electron transport layer, the hole transport layer, and the hole injection layer, and the functional layer FL may be disposed above and below the light emitting layer EML. For example, the hole injection layer, the hole transport layer, the light emitting layer EML, the electron transport layer, the electron injection layer, and the cathode are sequentially disposed on the anode so that the hole injection layer and hole transport layer from among the functional layer FL may be disposed on the lower portion of the light emitting layer EML, and the electron transport layer and the electron injection layer may be disposed on the upper portion of the light emitting layer EML.

The spacer 385 may increase the scratch resistance of the light emitting display panel DP to thus reduce the rate of defects caused by pressing pressure, and, depending on some example embodiments, may increase the adhesive strength with the functional layer FL disposed on the upper portion of the spacer 385, thereby reducing or preventing moisture and air from being injected from the outside. High adhesive strength has the merit of eliminating the problem of the adhesive strength between layers decreasing when the light emitting display panel DP is flexible and is folded and unfolded.

The cathode may be formed as a transparent electrode or a reflecting electrode. Depending on some example embodiments, the cathode may be a transparent or semi-transparent electrode, and may be formed of or include a metal thin film having a relatively small work function including lithium (Li), calcium (Ca), fluorinated lithium/calcium (LiF/Ca), fluorinated lithium/aluminum (LiF/Al), aluminum (Al), silver (Ag), magnesium (Mg), or compounds thereof. A transparent conductive oxide (TCO) layer such as indium tin oxide (ITO), indium zinc oxide (IZO), zinc oxide (ZnO), or indium oxide (In2O3) may be further disposed on the metal thin film. The cathode may be formed integrally on the front surface of the light emitting display panel DP.

The encapsulation layer 400 is disposed on the cathode. The encapsulation layer 400 includes at least one inorganic layer and at least one organic layer, and in FIG. 21, it has a triple-layer structure including a first inorganic encapsulation layer 401, an organic encapsulation layer 402, and a second inorganic encapsulation layer 403. The encapsulation layer 400 may protect the light emitting layer EML formed of an organic material from moisture or oxygen that may be introduced from the outside. Depending on some example embodiments, the encapsulation layer 400 may include a structure in which an inorganic layer and an organic layer are sequentially stacked.

The sensing insulation layers 501, 510, and 511 and the sensing electrodes 540 and 541 for sensing touch are disposed on the encapsulation layer 400. In the example embodiment of FIG. 21, touch is detected in a capacitive type using the two sensing electrodes 540 and 541, but depending on some example embodiments, touch may also be detected in a self-cap method using one sensing electrode. The sensing electrodes 540 and 541 may be insulated from each other with the second sensing insulation layer 510 therebetween, the lower sensing electrode 541 is disposed on the first sensing insulation layer 501, the upper sensing electrode 540 is disposed on the second sensing insulation layer 510, and the upper sensing electrode 540 is covered by the third sensing insulation layer 511. The sensing electrodes 540 and 541 may be electrically connected to each other through openings disposed in the second sensing insulation layer 510. The sensing electrodes 540 and 541 may include metal such as aluminum (Al), copper (Cu), silver (Ag), gold (Au), molybdenum (Mo), titanium (Ti), tantalum (Ta), etc., or metal alloys thereof may be a single layer or a multilayer.

The scattering layer 210, the light blocking layer 220, the step-removing organic layer 240, and the color filters 230R, 230G, and 230B are sequentially disposed on the third sensing insulation layer 511.

The light blocking layer 220 may overlap the sensing electrodes 540 and 541 and may not overlap the anode in a plan view. This is to reduce or prevent the anode and the light emitting layer EML, which may display images, from being covered by the light blocking layer 220 and the sensing electrodes 540 and 541.

The scattering layer 210 may overlap the light blocking layer 220 and the sensing electrodes 540 and 541, a portion of the scattering layer 210 may overlap the anode, and another portion thereof may not overlap the anode in a plan view. At least a portion of the scattering layer 210 may also overlap the pixel defining layer 380 in a plan view. The scattering layer 210 includes scattering particles 211 for scattering light, and has an opening OPSL (or a scattering layer opening) overlapping at least a portion of the opening OP of the pixel defining layer 380 in a plan view. The size, shape, and arrangement direction of the opening OPSL of the scattering layer 210 may vary, and it may have various shapes such as a circle or an oval in a plan view.

Referring to FIG. 21, the light blocking layer 220 is disposed in a region overlapping the pixel defining layer 380 in a plan view, and one side of the light blocking layer 220 is indented from the corresponding side of the pixel defining layer 380.

The light blocking layer 220 has a second opening OPBM (or a second opening), and the area of the second opening OPBM of the light blocking layer 220 is formed to be larger than the opening OP of the pixel defining layer 380, and the opening OP of the pixel defining layer 380 may be disposed within the second opening OPBM of the light blocking layer 220. The second opening OPBM of the light blocking layer 220 may be formed to be larger than the opening OPSL of the scattering layer 210, and at least a portion of the second opening OPBM of the light blocking layer 220 may overlap the opening OPSL of the scattering layer 210 in a plan view.

One side of the spacer 385 is indented from the corresponding side of the pixel defining layer 380 by the desired (or alternatively, predetermined) gap g-1, and the spacer 385 is also indented from one side of the light blocking layer 220. Thus, when viewed from the front surface of the display panel DP, the spacer 385 may be covered by the light blocking layer 220 and may not be visible.

When external light is incident, it may be reflected from the side wall of the opening OP of the pixel defining layer 380 after being transmitted through the second opening OPBM of the light blocking layer 220 and the opening OPSL of the scattering layer 210. The side wall of the opening OP of pixel defining layer 380 is curved, so color separation occurs, depending on the reflected position, and the reflected light may appear as rainbow spots. The color-separated reflected light may be easily seen by the user's eyes and display quality may deteriorate, but in the present example embodiment, the scattering particles 211 disposed in the scattering layer 210 may cause the light to be scattered, making it difficult for the user to easily recognize the reflected light. As the scattering layer 210 is formed to cover the side wall of the pixel defining layer 380, rainbow spots may be reduced or removed. The shape, size, and angle of the opening OPSL of the scattering layer 210 may be varied, and a single panel may include various openings OPSL of the scattering layer 210. Thus, the display quality deterioration due to reflected light may be reduced, reducing or preventing the user from perceiving external light as rainbow spots.

FIG. 21 shows that the opening OP of the pixel defining layer 380 is larger than the opening OPSL of the scattering layer 210, and the second opening OPBM of the light blocking layer 220 is larger than the opening OPSL of the scattering layer 210 and the opening OP of the pixel defining layer 380. However, the width relationship of the openings may vary, depending on some example embodiment, shape, size, arrangement, and cross-section of the openings, etc.

The step-removing organic layer 240 for covering the scattering layer 210 and the light blocking layer 220 is formed on the third sensing insulation layer 511, the scattering layer 210, and the light blocking layer 220. The step-removing organic layer 240 may be formed to cover the entire region of the display area, and it may cover at least a portion of the peripheral area disposed around the display area.

The step-removing organic layer 240 according to the example embodiment of FIG. 21 is an organic layer for removing the steps caused by the scattering layer 210 and the light blocking layer 220, and may be formed of an optically transparent organic material. For example, the step-removing organic layer 240 may be or may include a transparent organic insulator including at least one of polyimide, polyamide, acryl resin, benzocyclobutene, or phenol resin.

In FIG. 21, the upper surface of the step-removing organic layer 240 is depicted as being flat, but depending on some example embodiments, the upper surface may be formed with a step difference of less than a desired (or alternatively, predetermined) level due to the step caused by the scattering layer 210 and the light blocking layer 220 disposed thereunder.

The color filters 230R, 230G, and 230B are disposed on the step-removing organic layer 240. The color filters 230R, 230G, and 230B include a red color filter 230R transmitting red light, a green color filter 230G transmitting green light, and a blue color filter 230B transmitting blue light. Each of the color filters 230R, 230G, and 230B may be disposed to overlap the anode of the light emitting diode in a plan view. Because the light emitted by the light emitting layer EML may be emitted while changing to the corresponding color as it is transmitted through the color filter, all the light emitted by the light emitting layer EML may have the same color. However, the light emitting layer EML may display different colors of light, and the displayed color may be enhanced by transmitting it through the color filter of the same color.

The color filters 230R, 230G, and 230B are formed on the upper surface of the step-removing organic layer 240, and the upper surface of the step-removing organic layer 240 is flat or has a step with a desired (or alternatively, predetermined) level or less, so the color filters 230R, 230G, and 230B may also be formed with a constant thickness.

For example, referring to FIG. 21, the thickness t1-1 of the portion of the color filters 230R, 230G, and 230B covering the opening OPSL of the scattering layer 210 and the thickness t2-1 of the portion of the color filters 230R, 230G, and 230B covering the scattering layer 210 have the same value or differ by a desired (or alternatively, predetermined) level or below to have substantially the same thickness. Substantially the same thickness may represent generation of the thickness difference of less than about 10% when considering processing errors. Therefore, there is no difference in the thicknesses of t1 and t2 as shown in FIG. 19, and the thicknesses of the color filters 230R, 230G, and 230B through which light emitted by the light emitting layer EML is transmitted are constant, so the displayed image may have improved color quality.

The light blocking layer 220 may be disposed between each of the color filters 230R, 230G, and 230B. Depending on some example embodiments, the color filters 230R, 230G, and 230B may be replaced with color conversion layers or may further include a color conversion layer. The color conversion layer may include quantum dots. When the color filters 230R, 230G, and 230B are replaced with color conversion layers, the displayed images may have improved color quality because the color conversion layers have a consistent thickness.

The planarization layer 550 covering the color filters 230R, 230G, and 230B is disposed on the color filters 230R, 230G, and 230B. The planarization layer 550 may planarize the upper surface of the light emitting display panel and may be a transparent organic insulator including at least one of polyimide, polyamide, acryl resin, benzocyclobutene, or phenol resin.

Depending on some example embodiments, a low-refraction layer and an additional planarization layer may be disposed on the planarization layer 550 to improve the front visibility and light emission efficiency of the display panel. Light may be refracted and emitted toward the front surface by the low-refraction layer and the additional planarization layer with high refraction characteristics. Depending on some example embodiments, the planarization layer 550 may be omitted and the low-refraction layer and the additional planarization layer may be disposed on the color filter 230.

In the present example embodiment, no polarization plate is included on the upper portion of the planarization layer 550. The polarization plate may reduce or prevent deterioration of display quality when external light is introduced, it is reflected from the anode or the side wall of the opening OP of the pixel defining layer 380, and the user sees it. However, the polarization plate has the drawback of consuming more electric power so as to reduce the light emitted by the light emitting layer EML and display desired (or alternatively, predetermined) luminance in addition to reducing reflection of external light. To reduce power consumption, the light emitting display device may not include a polarization plate. As the light emitting display device does not form the polarization plate, light emitted by the light emitting layer is partly absorbed by the polarization plate, and luminance is not lowered, so the light emitting display device has the maximum luminance value of the light emitting display device of about 2500 nits or more.

In the present example embodiment, the scattering layer 210 is formed below the light blocking layer 220, and the edge of the opening OPSL of the scattering layer 210 is formed to cover the side wall of the pixel defining layer 380, thereby reducing or preventing deterioration of display quality by reducing or preventing reflected external light from being recognized as a rainbow spot. Therefore, there is no need to separately form the polarization plate on the front surface of the light emitting display panel DP.

In the example embodiment of FIG. 21, the scattering layer 210 is disposed between the third sensing insulation layer 511 and the light blocking layer 220, and protrudes to the front surface (or third direction DR3) with respect to the third sensing insulation layer 511. The scattering layer 210 has a tapered side, and the taper angle may be greater than 0 degrees and less than about 90 degrees toward the third direction DR3 in the first direction DR1 or the second direction DR2. Compared to the comparative example in which the scattering layer 210 protrudes toward the rear surface (opposite direction of the third direction DR3), the example embodiment in which the scattering layer 210 protrudes toward the front surface is not only easy to be manufactured using a photolithography-based exposing and developing process, but also it is easy to control the taper angle, so that the rainbow spots to be described may be effectively reduced.

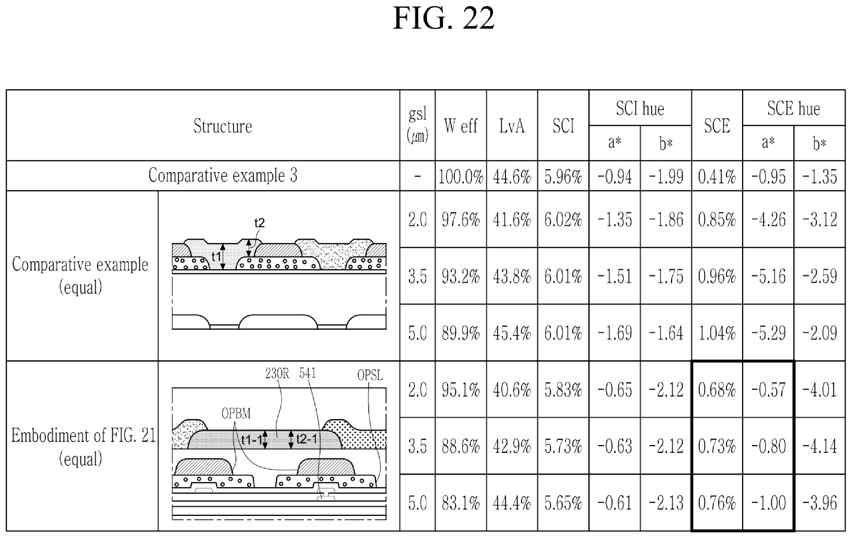

The display characteristics of the example embodiments of FIG. 20 and FIG. 21 will now be described in detail by comparing them with the comparative example with reference to FIG. 22.

FIG. 22 shows a table on comparison of characteristics according to the example embodiment of FIG. 20 and FIG. 21.

In FIG. 22, the gap gsl where the scattering layer 210 overlaps the light emitting layer EML, the efficiency of white light (W eff), the luminance ratio (LvA), the specular component included (SCI) index, and the specular component excluded (SCE) index are described. FIG. 22 compares Comparative Example 3, the comparative example, and the example embodiment of FIG. 21, where Comparative Example 3 does not include the scattering layer 210 and may have the same structure as in FIG. 12. Regarding the comparative example and the example embodiment of FIG. 21, the scattering layer 210 has the opening OPSL, and the gap gsl where the scattering layer 210 overlaps the light emitting layer EML is the same for all colors, but the comparative example does not include the step-removing organic layer 240, and the example embodiment of FIG. 21 includes the step-removing organic layer 240 covering the scattering layer 210 and the light blocking layer 220 and formed below the color filters 230R, 230G, and 230B. In the comparative example and the example embodiment of FIG. 21, each factor is simulated by changing the gap gsl where the scattering layer 210 overlaps the light emitting layer EML to 2.0 µm, 3.5 µm, and 5.0 µm, respectively, and the resulting values of the factors are included in FIG. 22.

Comparative Example 3 does not include the scattering layer so the light emitted by the light emitting layer may be transmitted without scattering, resulting in the highest efficiency (W eff) of white light at about 100%, and the gap gsl where the scattering layer 210 overlaps the light emitting layer EML is not described. In the example embodiment of FIG. 19 and the example embodiment of FIG. 21, the efficiency (W eff) value of white light is lower than that of Comparative Example 3 due to the presence of the scattering layer 210, but the difference is not significant. In FIG. 22, it may be confirmed that the efficiency (W eff) of white light decreases as the gap gsl where the scattering layer 210 overlaps the light emitting layer EML increases in the comparative example and the example embodiment of FIG. 21.

The luminance ratio (LvA) is the value at the angle of 40 degrees on the side compared to the front, and there is no significant difference in Comparative Example 3, the comparative example, and the example embodiment of FIG. 21, but it may be confirmed that the luminance ratio (LvA) increases as the gap gsl where the scattering layer 210 overlaps the light emitting layer EML increases.

FIG. 22 also shows the specular component included (SCI) index and the specular component excluded (SCE) index. The SCI index and the SCE index are indices corresponding to color sense, and FIG. 22 also shows factor a (a*) and factor b (b*) of the SCI index and the SCE index, respectively. The SCI index measures the color including specular reflected light (light reflected like a mirror), while the SCE index measures diffusely reflected light (light reflected in a diffuse manner) excluding the specular reflected light, so there is a difference. The SCI index is closer to recognizing the overall appearance of an object to the naked eye, while the SCE index is a measured result that focuses more on the unique color of the object itself. Both the SCI and SCE indices indicate that the smaller values that approach 0, the more accurate colors and closer colors to the actual color they represent.

Referring to FIG. 22, the SCI index shows that the comparative example has the value farthest from 0, followed by Comparative Example 3, which has the value next farthest from 0. Compared to them, it may be confirmed that the example embodiment of FIG. 21 has a value that is closest to 0. Regarding the factor a (a*) of the SCI index, like the SCI index, the comparative example having the value farthest from 0, followed by Comparative Example 3 having a value that is the next farthest from 0, and compared to these, the example embodiment of FIG. 21 has a value that is closest to 0. The factor b (b*) of the SCI index has a value that is farthest from 0 in the example embodiment of FIG. 21, which is opposite to the factor a (a*) of the SCI index. However, it may be confirmed that the differences of the values in Comparative Example 3, the comparative example, and the example embodiment of FIG. 21 in the SCI index are not large, so there are no significant differences in colors.

Regarding the SCE index, the comparative example has a value that is farthest from 0, followed by Comparative Example 3, which has a value that is close to 0. The example embodiment of FIG. 21 has an SCE index that has a value between Comparative Example 3 and the comparative example. The factor a (a*) of the SCE index, like the SCE index, has a value that is farthest from 0, followed by the example embodiment of FIG. 21 having a value that is next farthest from 0, and Comparative Example 3 having a value that is closest to 0. The factor b (b*) of the SCE index has a value that is farthest from 0 in the example embodiment of FIG. 21. Thus, it may be confirmed in FIG. 22 that the factor a (a*) of the SCE index is greatly reduced in the example embodiment of FIG. 21 compared to the comparative example, and has a value similar to that of Comparative Example 3. Therefore, it may be confirmed that the example embodiment of FIG. 21 may display relatively significantly improved colors compared to the comparative example.

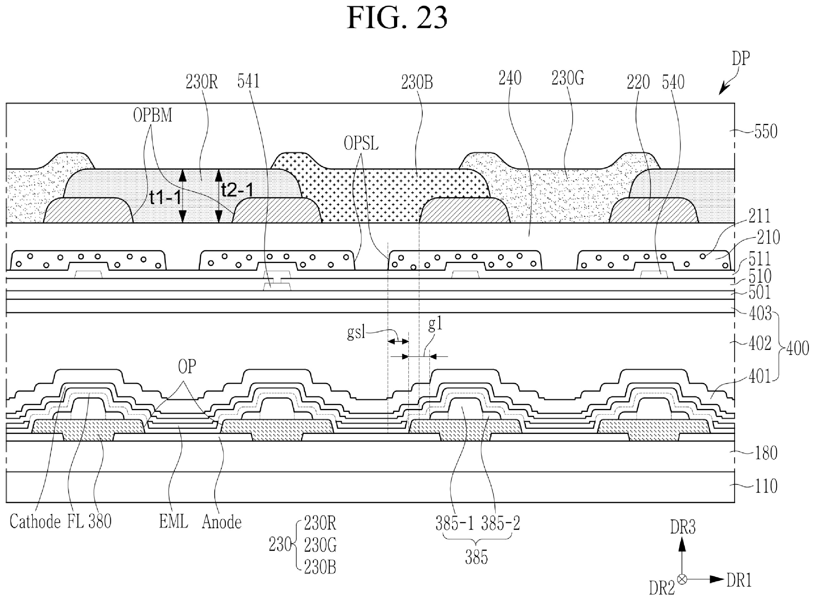

An example embodiment with a different cross-sectional structure from that of FIG. 21 will be described with reference to FIG. 23 to FIG. 26.

FIG. 23 to FIG. 26 show a cross-sectional view on a display panel according to some modified example embodiments of FIG. 21.

The example embodiment of FIG. 23 will now be described.

In the example embodiment of FIG. 23, unlike the example embodiment of FIG. 21, the step-removing organic layer 240 is formed on the lower portion of the light blocking layer 220. That is, the scattering layer 210, the step-removing organic layer 240, the light blocking layer 220, and the color filters 230R, 230G, and 230B are formed sequentially.

For example, the step caused by the scattering layer 210 is removed by the step-removing organic layer 240, and a light blocking layer 220 and color filters 230R, 230G, and 230B are formed thereon, so that the thickness of the color filters 230R, 230G, and 230B is formed to be constant. The thickness t1-1 of the portion of the color filters 230R, 230G, and 230B overlapping the opening OPSL of the scattering layer 210 in a plan view and the thickness t2-1 of the portion of the color filters 230R, 230G, and 230B that overlap the opening OP of the pixel defining layer 380 and the scattering layer 210 in a plan view have the same value or differ by a desired (or alternatively, predetermined) level or less, so they have substantially the same thickness. Substantially the same thickness may mean the generation of a thickness difference of less than 10% when considering processing errors. Therefore, there is no difference in the thicknesses of t1 and t2 as shown in FIG. 19, and the thicknesses of the color filters 230R, 230G, and 230B through which light emitted by the light emitting layer EML is transmitted are constant, so the displayed images may have improved color quality.

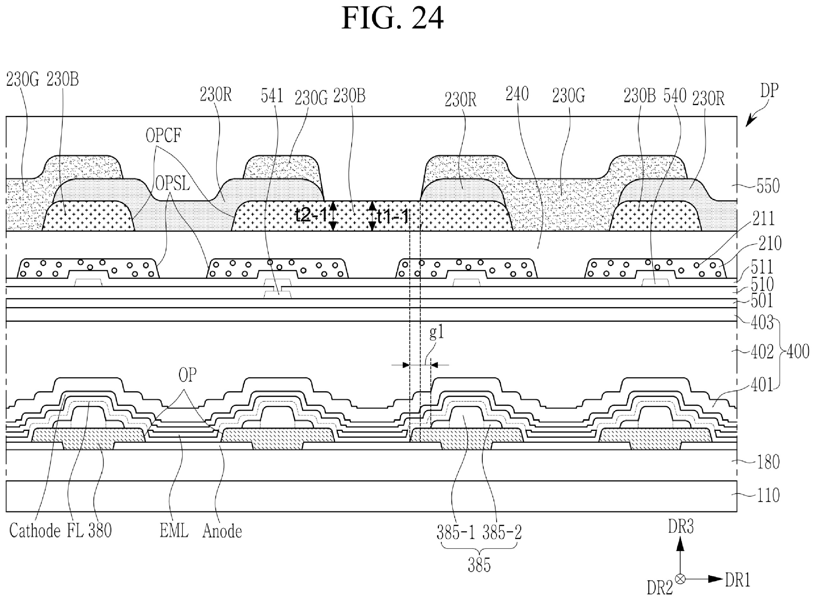

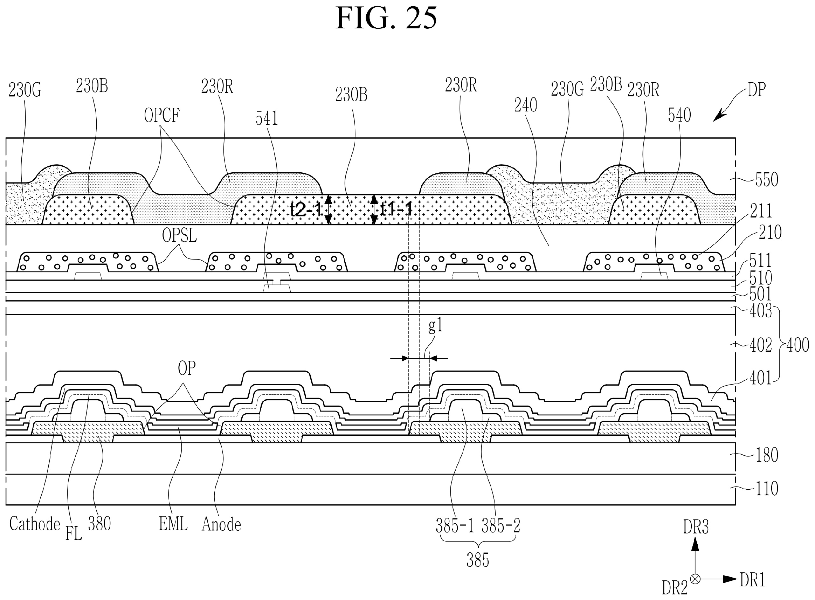

Depending on some example embodiment, instead of the light blocking layer 220, the light blocking region of the color filter where at least two color filters 230R, 230G, and 230B overlap may be formed. Some example embodiments not including a light blocking layer and including a light blocking region of a color filter, where at least two color filters 230R, 230G, and 230B overlap will be described with reference to FIG. 24 and FIG. 25.

A structure of the light emitting display panel DP according to an example embodiment will be described with reference to FIG. 24, and the description of the same portion as FIG. 21 or FIG. 23 will be omitted.

The light emitting display panel DP according to the example embodiment of FIG. 24 may display images by forming the light emitting diode on the substrate 110, may detect touch by including the sensing electrodes 540 and 541, and may have the color filters 230R, 230G, and 230B so that light emitted by the light emitting diode has the color characteristics of the color filters 230R, 230G, and 230B. The light blocking layer formed in black and blocking visible light may not be formed, and instead of the light blocking layer, at least two color filters may be overlapped to block visible light.

The region blocking visible light by overlapping at least two color filters is referred to as the light blocking region, and in some example embodiments of FIG. 24, the blue color filter 230B, the red color filter 230R, and the green color filter 230G are sequentially stacked. The order in which color filters are stacked may vary, depending on some example embodiments.

The polarization plate is not formed on the front surface of the light emitting display panel DP according to the example embodiment of FIG. 14, and instead, the pixel defining layer 380 is formed with a black organic material, and the light blocking region in which at least two color filters overlap is formed on the upper surface of the pixel defining layer 380, so that when external light is incident on the inside, it may not be reflected from the anode or the like and may not be transmitted to the user.

For example, the step-removing organic layer 240 is disposed on the third sensing insulation layer 511, and the color filters 230R, 230G, and 230B are disposed on the step-removing organic layer 240.

The color filters 230R, 230G, and 230B include a red color filter 230R transmitting red light, a green color filter 230G transmitting green light, and a blue color filter 230B transmitting blue light. Each of the color filters 230R, 230G, and 230B may be disposed to overlap the anode of the light emitting diode in a plan view. As the light emitted by the light emitting layer EML may be emitted with the corresponding color changed as it is transmitted through the color filter, all the light emitted by the light emitting layer EML may have the same color. However, the light emitting layer EML may display different colors of light, and may allow the light to be transmitted through the color filter of the same color to reinforce the displayed colors.

Depending on some example embodiments, the color filters 230R, 230G, and 230B may be replaced with color conversion layers or may further include a color conversion layer. The color conversion layer may include quantum dots.

In the example embodiment of FIG. 24, a light blocking layer formed in black color to block visible light is not formed, and instead of the light blocking layer, a light blocking region formed by overlapping at least two color filters is formed to replace the light blocking layer. In the example embodiment of FIG. 24, the light blocking region has the blue color filter 230B, the red color filter 230R, and the green color filter 230G sequentially stacked therein. The order in which color filters are stacked may vary, depending on some example embodiments.

The light blocking region, in which the at least two color filters overlap, may be disposed to overlap the sensing electrodes 540 and 541 in a plan view, and not to overlap the anode in a plan view. This is to reduce or prevent the anode and the light emitting layer EML, which may display images, from being covered by the light blocking region and the sensing electrodes 540 and 541.

Referring to FIG. 14, the light blocking region of the color filter in which three color filters overlap is disposed in the region that overlaps the pixel defining layer 380 in a plan view, and one side of the light blocking region of the color filter is indented from the corresponding side of the pixel defining layer 380.

One color filter may be disposed in a region other than the light blocking region, and light of the color of the corresponding color filter is transmitted to form the light transmitting region of the color filter. The light transmitting region of the color filter, where one color filter is disposed, is referred to as the second opening OPCF of the light blocking region because light is transmitted therethrough. The second opening OPCF of the light blocking region may be an opening disposed in the light blocking region where at least two color filters overlap, and may correspond to a region where one color filter is disposed. The second opening OPCF of the light blocking region of the color filter may correspond to the second opening OPBM of the light blocking layer 220 described above. Thus, the second opening OPCF of the light blocking region of the color filter may be circular or oval in a planar shape.

The area of the second opening OPCF of the light blocking region is formed larger than the opening OP of the pixel defining layer 380, and the opening OP of the pixel defining layer 380 in a plan view may be disposed within the second opening OPCF of the light blocking region. The opening OPSL of the scattering layer 210 may be in the second opening OPCF of the light blocking region, and may be disposed in the opening OP of the pixel defining layer 380 so that the scattering layer 210 may overlap the side of the pixel defining layer 380 in a plan view.

The step-removing organic layer 240 may remove the step caused by the scattering layer 210, so the color filters 230R, 230G, and 230B formed on the step-removing organic layer 240 may be formed with a constant thickness. For example, the thickness t1-1 of the portion of the color filters 230R, 230G, and 230B disposed within the second opening OPCF of the light blocking region and overlapping the opening OPSL of the scattering layer 210 and the thickness t2-1 of the portion of the color filters 230R, 230G, and 230B disposed within the second opening OPCF of the light blocking region and overlapping the opening OP of the pixel defining layer 380 and the scattering layer 210 have the same value or differ by a desired (or alternatively, predetermined) level or below to have substantially the same thickness. Substantially the same thickness may indicate generation of the thickness difference of less than 10% when considering processing errors. Therefore, the thicknesses of the color filters 230R, 230G, and 230B through which light emitted by the light emitting layer EML is transmitted are constant, so the displayed images may have improved color quality.

One side of the spacer 385 is indented from the corresponding side of the pixel defining layer 380 by the desired (or alternatively, predetermined) gap g1, and the spacer 385 is also indented from one side of the light blocking region. Thus, when viewed from the front surface of the display panel DP, the spacer 385 may be covered by the light blocking region and may not be visible.

When external light is incident, it may be transmitted through the second opening OPCF of the light blocking region of the color filter and the opening OPSL of the scattering layer 210, and may be reflected from the side wall of the opening OP of the pixel defining layer 380. The side wall of the opening OP of the pixel defining layer 380 may be curved, and color separation occurs, depending on the reflected position, which may cause rainbow spots in which the colors of the reflected light appear in various colors like a rainbow. The rainbow spots may be easily visible to the user and may deteriorate display quality, but in the present example embodiment, the scattering layer 210 having an opening OPSL may be formed, and the side wall of the pixel defining layer 380 may be covered with the scattering layer 210 to remove or weaken the rainbow spots, making it difficult for the user to easily recognize the rainbow spots.

The planarization layer 550 for covering the color filters 230R, 230G, and 230B is disposed on the color filters 230R, 230G, and 230B. The planarization layer 550 may planarize the upper surface of the light emitting display panel and may be a transparent organic insulator including at least one of polyimide, polyamide, acryl resin, benzocyclobutene, or phenol resin.

Depending on some example embodiment, a low-refraction layer and an additional planarization layer may be further disposed on the planarization layer 550 to improve the front visibility and/or light emission efficiency of the display panel. Light may be refracted and emitted toward the front surface by the low-refraction layer and the additional planarization layer with high refraction characteristics. Depending on some example embodiments, the planarization layer 550 may be omitted and the low-refraction layer and the additional planarization layer may be disposed on the color filter 230.

In the present example embodiment, no polarization plate is included on the upper portion of the planarization layer 550. The polarization plate may reduce or prevent deterioration of display quality when external light is introduced, it is reflected from the anode or the side wall of the opening OP of the pixel defining layer 380, and the user sees it. However, the polarization plate has the drawback of consuming more electric power so as to reduce the light emitted by the light emitting layer EML and display desired (or alternatively, predetermined) luminance in addition to reducing reflection of external light. To reduce power consumption, the light emitting display device may include no polarization plate.

The present example embodiment already includes a structure that covers the sides of the anode with the pixel defining layer 380 to reduce the amount of reflection from the anode, and the light blocking region with at least two color filters overlapping is formed to reduce the degree of incident light and reduce or prevent deterioration of display quality due to reflection. Therefore, there is no need to separately form the polarization plate on the front surface of the light emitting display panel DP.

In the example embodiment of FIG. 24, an example in which the light blocking region in which at least two color filters overlap is formed by overlapping three color filters has been described. However, depending on some example embodiments, two color filters may be overlapped to form a light blocking region of the color filter, which is shown in FIG. 25.

FIG. 25 corresponds to FIG. 24, with the color filters 230R, 230G, and 230B differing from FIG. 24, and the lower structure of the third sensing insulation layer 511 is the same as that of FIG. 24. An upper structure of the third sensing insulation layer 511, which differs from FIG. 24, will now be described.

Referring to FIG. 25, the light blocking layer blocking visible light is not formed, and the blue color filter 230B and the red color filter 230R are sequentially overlapped to block visible light. The order in which color filters are stacked may vary, depending on some example embodiments.

For example, the light blocking region where two color filters overlap is where the blue color filter 230B and the red color filter 230R overlap, and a desired (or alternatively, predetermined) region of the light blocking region of the color filters has a portion where the green color filter 230G overlaps. However, because the green color filter 230G is not formed in the entire light blocking region of the color filter, differently from the example embodiment of FIG. 24, the light blocking region of the color filter is formed with two color filters. The light blocking region where two color filters overlap is disposed in the region that overlaps the pixel defining layer 380 in a plan view, and one side of the light blocking region of the color filter is indented from the corresponding side of the pixel defining layer 380.

Only one color filter may be disposed in a region other than the light blocking region of the color filter, and the light of the color of that color filter is transmitted to form a second opening OPCF in the light transmitting region of the color filter or the light blocking region of the color filter. The area of the second opening OPCF is formed larger than the opening OP of the pixel defining layer 380, and the opening OP of the pixel defining layer 380 in a plan view may be disposed within the second opening OPCF of the light blocking region of the color filter. The opening OPSL of the scattering layer 210 is in the second opening OPCF of the light blocking region and is disposed in the opening OP of the pixel defining layer 380.

The light blocking region of the color filter overlaps the pixel defining layer 380, the scattering layer 210, the spacer 385, and the sensing electrodes 540 and 541 in a plan view. For example, regarding the light blocking region of the color filter, one side of the spacer 385 is indented from the corresponding side of the pixel defining layer 380 by the desired (or alternatively, predetermined) gap g1, and the spacer 385 is indented from one side of the light blocking region of the color filter. The sensing electrodes 540 and 541 are covered by the light blocking region of the color filter in a plan view. Thus, when viewed from the front surface of the display panel DP, the spacer 385 and the sensing electrodes 540 and 541 may be covered by the light blocking region of the color filter and may not be visible.

In the example embodiment of FIG. 25, the step-removing organic layer 240 is disposed on the third sensing insulation layer 511, and the color filters 230R, 230G, and 230B are disposed on the step-removing organic layer 240.

The step-removing organic layer 240 removes the step generated by the scattering layer 210, so the color filters 230R, 230G, and 230B formed on the step-removing organic layer 240 may be formed with a constant thickness. The thickness t1-1 of the portion of the color filters 230R, 230G, and 230B overlapping the opening OPSL of the scattering layer 210 in a plan view and the thickness t2-1 of the portion of the color filters 230R, 230G, and 230B overlapping the scattering layer 210 in a plan view have the same value or differ by a desired (or alternatively, predetermined) level or less so they have substantially the same thickness. Substantially the same thickness may mean the generation of the thickness difference of less than 10% when considering processing errors. Therefore, the thicknesses of the color filters 230R, 230G, and 230B through which light emitted by the light emitting layer EML is transmitted are constant, so the displayed images may have improved color quality.

Referring to FIG. 16, it may be seen that the portions other than the wavelength bands transmitted by the color filters 230R, 230G, and 230B have transmittances of less than 10%, and that when three or two color filters overlap, there is almost no transmitted wavelength band. Therefore, the function of the light blocking layer may be replaced by overlapping at least two color filters so it may be possible that the light blocking layer may be replaced by overlapping three color filters as shown in FIG. 24 or overlapping two color filters as shown in FIG. 25.

Depending on some example embodiment, the color filters 230R, 230G, and 230B may be replaced with color conversion layers or may further include a color conversion layer. The color conversion layer may include quantum dots.

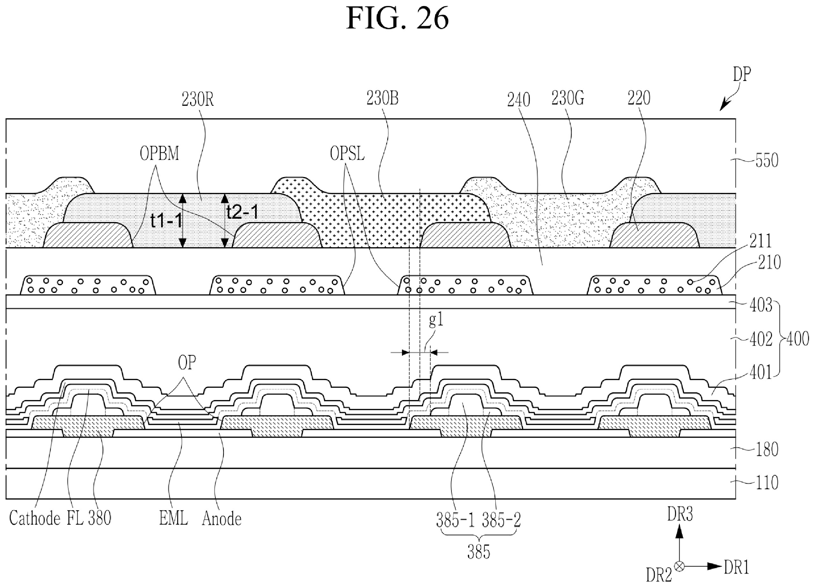

Depending on some example embodiment, the sensing insulation layers 501, 510, and 511 and the sensing electrodes 540 and 541 for sensing touch may not be included, which is shown in FIG. 26.

FIG. 26 is an example embodiment that corresponds to FIG. 23, and unlike the example embodiment of FIG. 23, the sensing insulation layers 501, 510, and 511 and the sensing electrodes 540 and 541 formed between the encapsulation layer 400 and the scattering layer 210 for sensing touch are not included. Thus, the scattering layer 210, the step-removing organic layer 240, the light blocking layer 220, and the color filters 230R, 230G, and 230B are sequentially disposed on the encapsulation layer 400, and the second inorganic encapsulation layer 403 may be in contact with the scattering layer 210 and the step-removing organic layer 240, and the upper structure of the scattering layer 210 and the lower structure of the encapsulation layer 400 may be equivalent to those shown in FIG. 21 and FIG. 23.

Some modified example embodiments in which the sensing insulation layers 501, 510, and 511 and the sensing electrodes 540 and 541 are omitted may be applied not only to FIG. 23, but also to FIG. 21, FIG. 24, and FIG. 25.

When the sensing insulation layers 501, 510, and 511 and the sensing electrodes 540 and 541 are omitted, the step generated by the scattering layer 210 is removed by the step-removing organic layer 240, and the color filters 230R, 230G, and 230B are formed so that the color filters 230R, 230G, and 230B may be formed with a constant thickness. For example, the thickness t1-1 of the portion of the color filters 230R, 230G, and 230B overlapping the opening OPSL of the scattering layer 210 in a plan view and the thickness t2-1 of the portion of the color filters 230R, 230G, and 230B overlapping the scattering layer 210 in a plan view have the same value or differ by a desired (or alternatively, predetermined) level or less so that they have substantially the same thickness. Substantially the same thickness may mean the generation of the thickness difference of less than 10% when considering processing errors. Therefore, the thicknesses of the color filters 230R, 230G, and 230B through which light emitted by the light emitting layer EML is transmitted are constant, so the displayed images may have improved color quality.

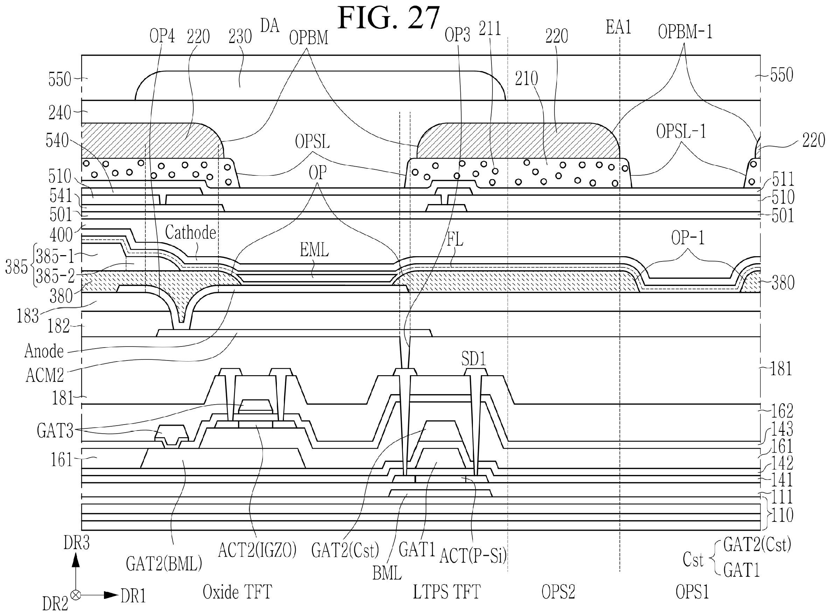

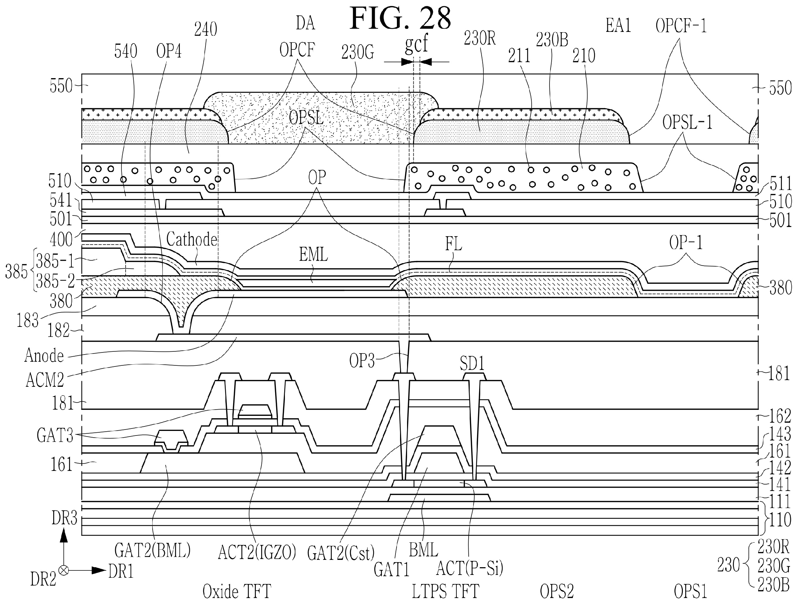

A stacking structure of the display area DA and the first component area EA1 of the light emitting display device including the step-removing organic layer 240 will be described in more detail with reference to FIG. 27 and FIG. 28.

FIG. 27 and FIG. 28 show cross-sectional views illustrating a light emitting display device according to an example embodiment of FIG. 21.

FIG. 27 shows an example embodiment including a light blocking layer 220, and FIG. 28 shows an example embodiment in which a light blocking region of a color filter is formed by overlapping the blue color filter 230B and the red color filter 230R instead of the light blocking layer 220. FIG. 27 corresponds to FIG. 17 and additionally includes the step-removing organic layer 240, and FIG. 28 corresponds to FIG. 18 and additionally includes the step-removing organic layer 240. The following description of FIG. 27 and FIG. 28 focuses on the portions that differ from FIG. 17 and FIG. 18.

An example embodiment of FIG. 27 will now be described.

The light emitting display device may be divided into a lower panel layer and an upper panel layer. The lower panel layer may be a portion where the light emitting diode and the pixel circuit portion constituting the pixels are disposed, and may include an encapsulation layer 400 covering the same. The pixel circuit portion may include a second organic layer 182 and a third organic layer 183 and may represent a lower configuration thereof, and the light emitting diode may represent the component disposed on an upper portion of the third organic layer 183 and a lower portion of the encapsulation layer 400. The component disposed on an upper portion of the encapsulation layer 400 may correspond to the upper panel layer.

Referring to FIG. 27, the structure from the substrate 110 to the third sensing insulation layer 511 is no different from that in FIG. 17, so a detailed description thereof will be omitted.

The scattering layer 210, the light blocking layer 220, the step-removing organic layer 240, and the color filters 230R, 230G, and 230B are sequentially disposed on the third sensing insulation layer 511.

The step-removing organic layer 240 is disposed on the sensing insulation layers 501, 510, and 511, the scattering layer 210, and the light blocking layer 220, and the color filters 230R, 230G, and 230B are disposed on the step-removing organic layer 240. Depending on some example embodiments, the color filters 230R, 230G, and 230B may be replaced with color conversion layers or may further include a color conversion layer. The color conversion layer may include quantum dots.

The step-removing organic layer 240 removes the steps generated by the scattering layer 210 and the light blocking layer 220 so the color filters 230R, 230G, and 230B formed on the step-removing organic layer 240 may have a constant thickness. Specifically, the thickness of the portion of the color filters 230R, 230G, and 230B overlapping the opening OPSL of the scattering layer 210 in a plan view and the thickness of the portion of the color filters 230R, 230G, and 230B overlapping the scattering layer 210 in a plan view have the same value or differ by a desired (or alternatively, predetermined) level or below to have substantially the same thickness. Substantially the same thickness may represent generation of the thickness difference of less than 10% when considering processing errors. Therefore, the thicknesses of the color filters 230R, 230G, and 230B through which light emitted by the light emitting layer EML is transmitted are constant, so the displayed image may have improved color quality.

The planarization layer 550 covering the color filters 230R, 230G, and 230B may be disposed on the color filters 230R, 230G, and 230B, and depending on some example embodiments, a low-refraction layer and an additional planarization layer may be further disposed on the planarization layer 550 to improve the front visibility and light emission efficiency of the display device. Light may be refracted and emitted toward the front surface by the low-refraction layer and the additional planarization layer with high refraction characteristics. Depending on some example embodiments, the planarization layer 550 may be omitted and the low-refraction layer and the additional planarization layer may be disposed directly on the color filter 230.

In the present example embodiment, no polarization plate is included on the planarization layer 550. That is, the polarization plate may reduce or prevent the user from seeing deteriorated images when external incident light is reflected from the anode, etc. However, according to the present example embodiment, the pixel defining layer 380 covers a side of the anode to reduce reflection of light from the anode, and the scattering layer 210 and the light blocking layer 220 are formed to reduce the degree of incident light, thereby reducing or preventing deterioration of display quality caused by reflection. Therefore, there is no need to separately form the polarization plate on the front surface of the display panel DP.

FIG. 27 shows a cross-sectional structure of a first component area EA1 formed to transmit light to a portion of a display area DA in addition to a stacking structure of the display area DA.

The first component area EA1 is divided into a first photosensor region OPS1 (or a transmission-type photosensor region) and a second photosensor region OPS2 (or a non-transmission-type photosensor region). The additional openings OP-1, OPSL-1, and OPBM-1 are disposed in the first photosensor region OPS1 so that the first photosensor region OPS1 may not overlap the pixel defining layer 380, the scattering layer 210, and the light blocking layer 220 in a plan view, and light may be transmitted therethrough. The second photosensor region OPS2 is formed to overlap the pixel defining layer 380, the scattering layer 210, and the light blocking layer 220 in a plan view so that light is not transmitted therethrough. The first photosensor region OPS1 of the first component area EA1 may not include a light blocking layer such as a metal layer or a semiconductor layer, and the second photosensor region OPS2 of the first component area EA1 may not include a light blocking layer such as a metal layer or a semiconductor layer. Depending on some example embodiments, light may not be transmitted, so light blocking layers such as a metal layer or a semiconductor layer may be disposed in some regions. For reference, a first optical element ES1 (refer to FIG. 2) may be disposed on the rear surface of the first component area EA1, and the front surface of the light emitting display device may be detected through the first photosensor region OPS1 disposed in the first component area EA1. To adjust the number of the first photosensor regions OPS1 and the second photosensor regions OPS2 in one first component area EA1, the sensor disposed on the rear surface of the first component area EA1 may detect the front surface of the light emitting display device, and the reflected colors of light in the first component area EA1 may be improved. Thus, depending on the present example embodiment, the first component area EA1 may have different reflectance or reflected colors from the display area surrounding the first component area EA1, which may reduce or prevent the first component area EA1 from being perceived by the user.

For example, the layered structure of the first component area EA1 is as follows.

The buffer layer 111, which is an inorganic insulation layer, is disposed on the substrate 110, and the first gate insulation layer 141 and the second gate insulation layer 142, which are inorganic insulation layers, are sequentially disposed thereon. The first interlayer insulation layer 161, the third gate insulation layer 143, and the second interlayer insulation layer 162 that is inorganic insulation layers are sequentially stacked on the second gate insulation layer 142.

The first organic layer 181, the second organic layer 182, and third organic layer 183 that is the organic insulators are sequentially stacked on the second interlayer insulation layer 162.

The functional layer FL may be disposed on the third organic layer 183, and the cathode may be disposed thereon.

The encapsulation layer 400 is disposed on the cathode, and the sensing insulation layers 501, 510, and 511 are sequentially disposed thereon. The encapsulation layer 400 may have a triple-layer structure sequentially including an inorganic encapsulation layer, an organic encapsulation layer, and an inorganic encapsulation layer. The sensing insulation layers 501, 510, and 511 may be inorganic insulation layers.

A step-removing organic layer 240 and a planarization layer 550 may be disposed on the sensing insulation layers 501, 510, and 511.

The metal layer, the first semiconductor layer, the first gate conductive layer, the second gate conductive layer, the oxide semiconductor layer, the third gate conductive layer, the first data conductive layer, the second data conductive layer, and the anode are not disposed in the first component area EA1. The light emitting layer EML and the sensing electrodes 540 and 541 are not formed.

The additional openings OP-1, OPSL-1, and OPBM-1 may be formed in the pixel defining layer 380, the scattering layer 210, and the light blocking layer 220 in the first photosensor region OPS1 of the first component area EA1 so the pixel defining layer 380, the scattering layer 210, and the light blocking layer 220 may not be formed, and the step-removing organic layer 240 may be disposed. Thus, light may be transmitted through the first photosensor region OPS1 and may not be scattered. The second photosensor region OPS2 in the first component area EA1 does not have the additional openings OP-1, OPSL-1, and OPBM-1 disposed therein, so it may overlap the pixel defining layer 380 and the light blocking layer 220 and light may not be transmitted.

An example embodiment in which a light blocking region of a color filter is formed by overlapping a blue color filter 230B and a red color filter 230R instead of a light blocking layer 220 will now be described with reference to FIG. 28.

The third sensing insulation layer 511 and the structure therebelow in FIG. 28 corresponds to the structure of FIG. 27, so an upper structure of the third sensing insulation layer 511 that is different from FIG. 27 will now be described in detail.

The step-removing organic layer 240 is disposed on the third sensing insulation layer 511, and the color filters 230R, 230G, and 230B are disposed on the step-removing organic layer 240. The step-removing organic layer 240 removes the steps generated by the scattering layer 210 and the light blocking layer 220 so the color filters 230R, 230G, and 230B may be formed with a constant thickness on the step-removing organic layer 240. For example, the thickness of the portion of the color filters 230R, 230G, and 230B overlapping the opening OPSL of the scattering layer 210 in a plan view and the thickness of the portion of the color filters 230R, 230G, and 230B overlapping the scattering layer 210 in a plan view have the same value or differ by a desired (or alternatively, predetermined) level or below to have substantially the same thickness. Substantially the same thickness may represent generation of the thickness difference of less than 10% when considering processing errors. Therefore, the thicknesses of the color filters 230R, 230G, and 230B through which light emitted by the light emitting layer EML is transmitted are constant, so the displayed image may have improved color quality.

The example embodiment of FIG. 28 does not include the light blocking layer, a function of the light blocking layer is performed by the overlapping color filters 230R and 230B, and the overlapping color filters 230R and 230B may be disposed to overlap the scattering layer 210 and the sensing electrodes 540 and 541 in a plan view. The overlapping color filters 230R and 230B have a second opening OPCF, and the second opening OPCF of the overlapping color filters 230R and 230B overlaps the opening OP of the pixel defining layer 380 and the opening OPSL of the scattering layer 210. The second opening OPCF of the overlapping color filters 230R and 230B may be formed wider than the opening OP of the pixel defining layer 380. Thus, the anode overlapping (e.g., exposed by the opening OP of the pixel defining layer 380) the opening OP of the pixel defining layer 380 may not be covered by the overlapping color filters 230R and 230B in a plan view. This is to reduce or prevent the anode and the light emitting layer EML for displaying images from being covered by the overlapping color filters 230R and 230B and the sensing electrodes 540 and 541. The overlapping color filters 230R and 230B overlap the anode connecting opening OP4 in a plan view.

The width of the blue color filter 230B disposed above from among the overlapping color filters 230R and 230B may be narrower than the width of the red color filter 230R disposed below by the color filter gap gcf, and the color filter gap gcf may have a value of 0 µm to about 2 µm, depending on some example embodiments. Depending on the example embodiment, as shown in FIG. 14, when three color filters overlap to form the light blocking region of the color filter having the same characteristic as the light blocking layer, the two color filters neighboring each other and overlapping each other may have the color filter gap gcf, and the color filter gap gcf may have the value of 0 µm to about 2 µm.

The second opening OPCF of the overlapping color filters 230R and 230B may be formed larger than the opening OPSL of the scattering layer 210, and at least a portion of the second opening OPCF of the overlapping color filters 230R and 230B may overlap the opening OPSL of the scattering layer 210 in a plan view. The size, shape, and arrangement direction of the opening OPSL of the scattering layer 210 may vary, and the opening OPSL of the scattering layer 210 may be formed with different sizes in subpixels of different colors.

One color filter may be disposed within the second opening OPCF of the overlapping color filters 230R and 230B, and the green color filter 230G is disposed therein in FIG. 28. Depending on some example embodiment, the color filters 230R, 230G, and 230B may be replaced with color conversion layers or may further include a color conversion layer. The color conversion layer may include quantum dots.

The planarization layer 550 covering the color filters 230R, 230G, and 230B may be disposed on the color filters 230R, 230G, and 230B, and a low-refraction layer and an additional planarization layer may be further disposed on the planarization layer 550 to improve the front visibility and light emission efficiency of the display device. Depending on some example embodiment, the planarization layer 550 may be omitted and the low-refraction layer and the additional planarization layer may be disposed on the color filter 230.

In the example embodiment of FIG. 28, the polarization plate is not included on the upper portion of the planarization layer 550. That is, the polarization plate may reduce or prevent the user from seeing deteriorated images when external light is incident and is reflected from the anode, etc. However, according to the present example embodiment, the pixel defining layer 380 covers a side of the anode to reduce reflection of light from the anode, and the overlapping color filters 230R and 230B and the scattering layer 210 are formed to reduce the incident degree of light, thereby reducing or preventing deterioration of display quality caused by reflection. Therefore, there is no need to separately form the polarization plate on the front surface of the display panel DP.

A cross-sectional structure of the first component area EA1 according to an example embodiment of FIG. 28 will now be described

The first component area EA1 is divided into a first photosensor region OPS1 and a second photosensor region OPS2. The additional openings OP-1, OPSL-1, and OPCF-1 are disposed in the first photosensor region OPS1 so that the first photosensor region OPS1 may not overlap the pixel defining layer 380, the scattering layer 210, and at least two color filters in a plan view, and light may be transmitted therethrough. The second photosensor region OPS2 is formed to overlap the pixel defining layer 380, the scattering layer 210, and the light blocking region of the color filter by overlapping at least two color filters in a plan view, and light may not be transmitted therethrough. The first photosensor region OPS1 and the second photosensor region OPS2 of the first component area EA1 may not include a light blocking layer such as a metal layer or a semiconductor layer. For reference, a first optical element ES1 (refer to FIG. 2) may be disposed on the rear surface of the first component area EA1, and the front surface of the light emitting display device may be detected through the first photosensor region OPS1 disposed in the first component area EA1.

A layered structure of the first component area EA1 will now be described.

The buffer layer 111 that is an inorganic insulation layer is disposed on the substrate 110, and the first gate insulation layer 141 and the second gate insulation layer 142 that is inorganic insulation layers are sequentially disposed thereon. The first interlayer insulation layer 161, the third gate insulation layer 143, and the second interlayer insulation layer 162, which are inorganic insulation layers, are sequentially stacked on the second gate insulation layer 142.

The first organic layer 181, the second organic layer 182, and third organic layer 183, which are organic insulators, are sequentially stacked on the second interlayer insulation layer 162.

The functional layer FL may be disposed on the third organic layer 183, and the cathode may be disposed thereon.

The encapsulation layer 400 is disposed on the cathode, and the sensing insulation layers 501, 510, and 511 are sequentially disposed thereon. The encapsulation layer 400 may have a triple-layer structure sequentially including an inorganic encapsulation layer, an organic encapsulation layer, and an inorganic encapsulation layer. The sensing insulation layers 501, 510, and 511 may be inorganic insulation layers.

The step-removing organic layer 240 and the planarization layer 550 may be disposed on the sensing insulation layers 501, 510, and 511.

The metal layer, the first semiconductor layer, the first gate conductive layer, the second gate conductive layer, the oxide semiconductor layer, the third gate conductive layer, the first data conductive layer, the second data conductive layer, and the anode are not disposed in the first component area EA1. The light emitting layer EML and the sensing electrodes 540 and 541 are not formed.

The additional openings OP-1, OPSL-1, and OPCF-1 may be formed in the pixel defining layer 380, the scattering layer 210, and the light blocking region of the color filter in the first photosensor region OPS1 of the first component area EA1, so the pixel defining layer 380 and the color filter may not be formed. Thus, light may be transmitted through the first photosensor region OPS1. The second photosensor region OPS2 in the first component area EA1 does not have the additional openings OP-1, OPSL-1, and OPCF-1 disposed therein, so it may overlap the pixel defining layer 380, the scattering layer 210, and the light blocking region of the color filter, and light may not be transmitted and may not be scattered.

The example embodiment including the step-removing organic layer 240 has been described with reference to FIG. 20 to FIG. 28. Meanwhile, the example embodiments shown in FIG. 7 to FIG. 19 show some examples in which the scattering layer 210 and the light emitting layer EML exposed by the openings OPr, OPg, and OPb of the pixel defining layer 380 overlap is formed differently for each color. These two example embodiments may be applied together. The gaps where the light emitting layer EML exposed by the opening OP of the pixel defining layer 380 overlaps the scattering layer 210 in a plan view may be the same in the three-color subpixel as shown in FIG. 20 and FIG. 21, which includes the step-removing organic layer 240, and the gaps where the light emitting layer EML exposed by the opening OP of the pixel defining layer 380 overlaps the scattering layer 210 in a plan view may be different from each other in the three-color subpixel as shown in FIG. 7.

An example embodiment having a step-removing organic layer 240 and having different gaps where the light emitting layer EML overlaps the scattering layer 210 for each color will now be described.

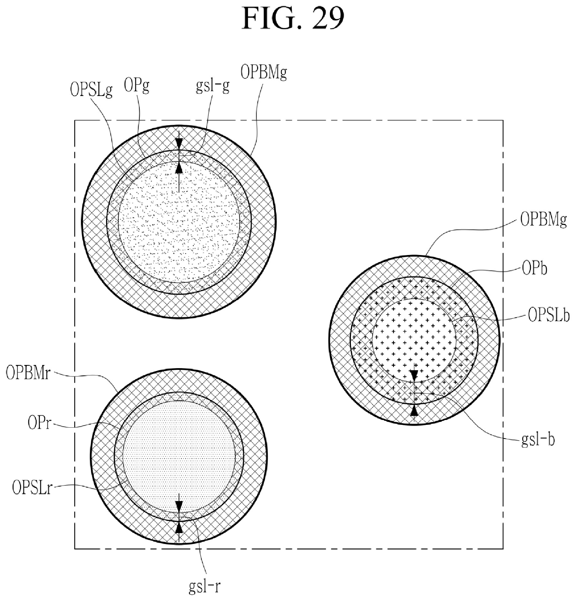

FIG. 29 shows a top plan view illustrating a portion of a display panel according to another example embodiment.

FIG. 29 has the same planar structure as FIG. 7. Referring to FIG. 29, the pixel defining layer 380 is disposed outside the openings OPr, OPg, and OPb of the pixel defining layer 380, the light blocking layer 220 is disposed outside the second openings OPBMr, OPBMg, and OPBMb of the light blocking layer 220, and the scattering layer 210 is disposed outside the openings OPSLr, OPSLg, and OPSLb of the scattering layer 210. FIG. 29 shows the gaps gsl-r, gsl-g, and gsl-b where the openings OPr, OPg, and OPb of the scattering layer 210 and the pixel defining layer 380 overlap in the red, green, and blue subpixels, and the overlapping gaps gsl-r, gsl-g, and gsl-b are shown differently.

The gaps gsl-r, gsl-g, and gsl-b where the scattering layer 210 and the openings OPr, OPg, and OPb of the pixel defining layer 380 overlap are the same, but may be formed in different sizes, depending on the position. In the example embodiment of FIG. 29, all the openings are depicted as circular, but depending on some example embodiment, they may be formed in a planar shape such as an ellipse, a closed curve similar to a circle, or a polygon. The gaps gsl-r, gsl-g, and gsl-b where the scattering layer 210 and the openings OPr, OPg, and OPb of the pixel defining layer 380 overlap may have different values at the subpixels having different colors.

In the example embodiment of FIG. 29, the gap gsl-r where the scattering layer 210 and the opening OPr of the pixel defining layer 380 overlap is the smallest in the red subpixel, the gap gsl-g where the scattering layer 210 and the opening OPg of the pixel defining layer 380 overlap is the next smallest in the green subpixel, and the gap gsl-b where the scattering layer 210 and the opening OPb of the pixel defining layer 380 overlap is the largest in the blue subpixel. However, depending on some example embodiment, the color of the largest one of the gaps gsl-r, gsl-g, or gsl-b where the scattering layer 210 and the openings OPr, OPg, and OPb of the pixel defining layer 380 overlap may be green or red, and the size order may also be formed in various ways, unlike in FIG. 29.

In the example embodiment of FIG. 29, the openings OPSLr, OPSLg, and OPSLb of the scattering layer 210 are formed for subpixels of all colors, but depending on some example embodiment, the openings OPSLr, OPSLg, and OPSLb of the scattering layer 210 may not be formed for one or two colors, and the light emitting layer of the corresponding color may be covered by the scattering layer 210. The arrangement of the openings OPSLr, OPSLg, and OPSLb of the scattering layer 210 may be arranged to have a specific period or may be arranged randomly.

Depending on some example embodiment, the thickness or haze value of the scattering layer 210 may be the same for all colors, and may be formed to have different thickness and haze values, depending on the color.

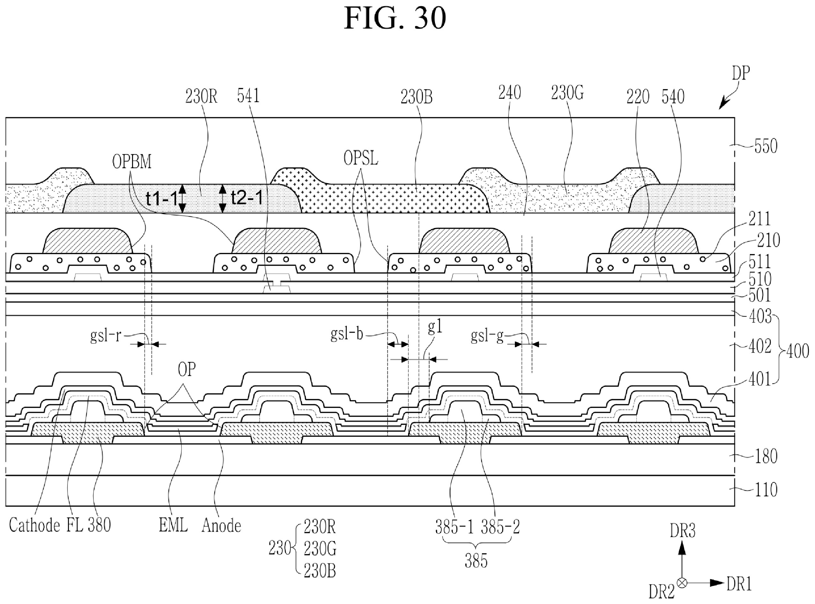

The planar structure has been described with reference to FIG. 29. A stacking structure of the light emitting display panel DP according to an example embodiment will now be described with reference to FIG. 30 to FIG. 34.

FIG. 30 to FIG. 34 show cross-sectional views illustrating a light emitting display device according to an example embodiment of FIG. 29.

First, FIG. 30 is a cross-sectional view that corresponds to FIG. 21. Additionally, the light emitting layer EML exposed by the scattering layer 210 and the opening OP of the pixel defining layer 380 has the characteristic of having different planar overlap gaps gsl-r, gsl-g, and gsl-b.

Therefore, when the gaps gsl-r, gsl-g, and gsl-b where the scattering layer 210 overlaps the light emitting layer EML in a plan view are differently formed for each of the subpixels of the colors and the viewing angles are changed, the color coordinate value white and changes of colors are changed by a desired (or alternatively, predetermined) level or below, so display quality of the light emitting display device may be improved. Further, the thickness t1-1 of the portion of the color filters 230R, 230G, and 230B overlapping the opening OPSL of the scattering layer 210 and the thickness t2-1 of the portion of the color filters 230R, 230G, and 230B overlapping the scattering layer 210 are substantially equivalent to each other, and the color filters 230R, 230G, and 230B transmitting light discharged by the light emitting layer EML have the same thickness, so the displayed images may have improved colors. Substantially the same thickness may indicate generation of the thickness difference of less than 10% when considering processing errors.

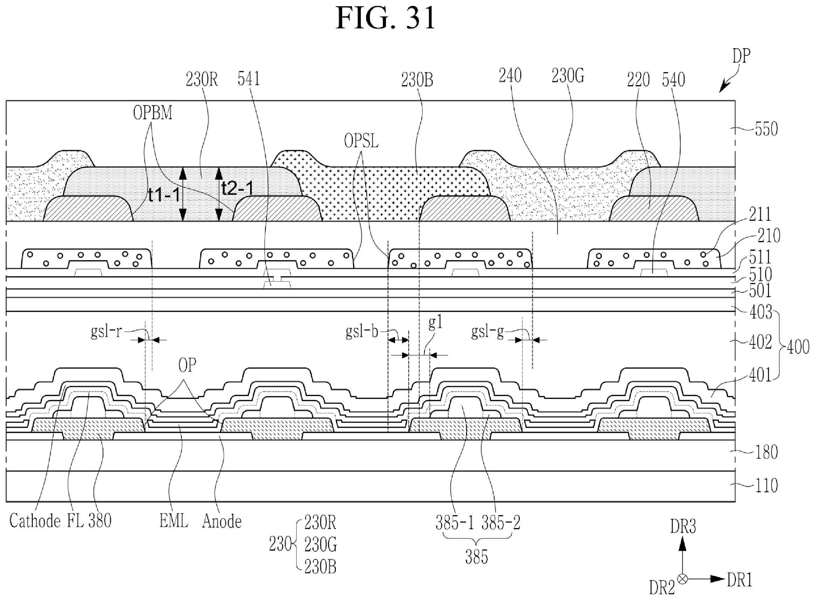

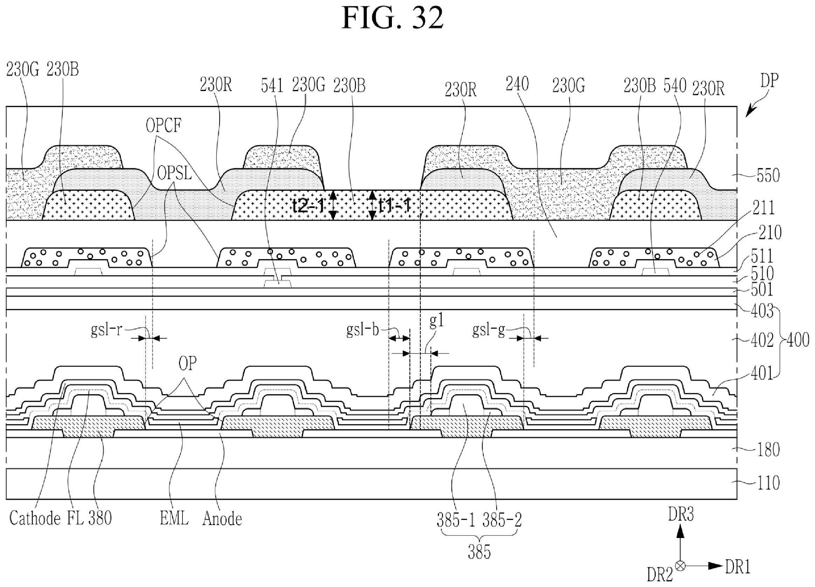

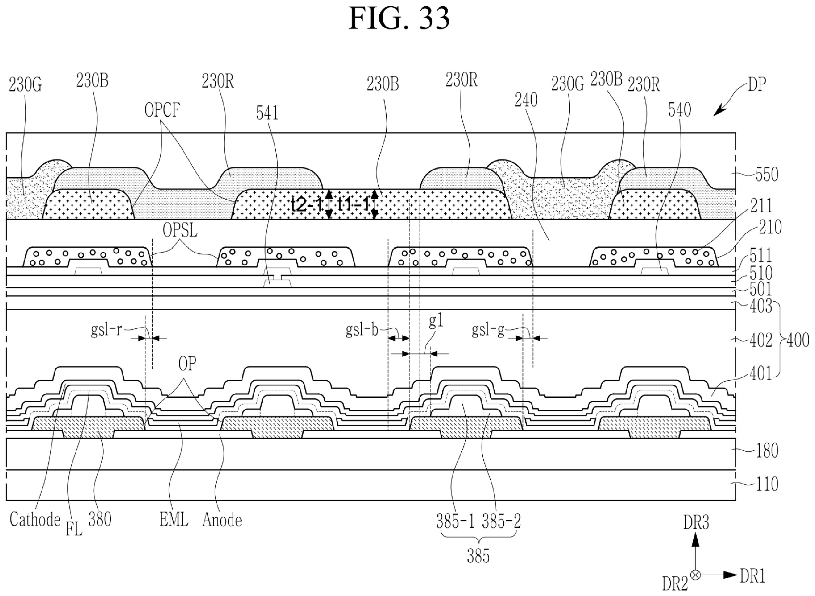

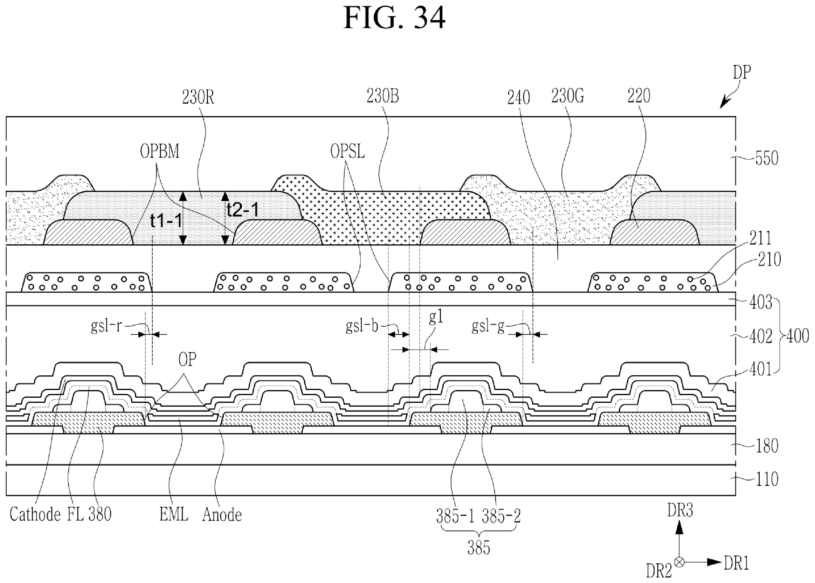

FIG. 31 is a cross-sectional view that corresponds to FIG. 23, FIG. 32 is a cross-sectional view that corresponds to FIG. 24, FIG. 33 is a cross-sectional view that corresponds to FIG. 25, and FIG. 34 is a cross-sectional view that corresponds to FIG. 26. FIG. 31 to FIG. 34 show the characteristic that the gaps gsl-r, gsl-g, and gsl-b where the scattering layer 210 overlaps the light emitting layer EML exposed by the opening OP of the pixel defining layer 380 in a plan view are different from each other.

Therefore, referring to FIG. 31 to FIG. 34, when the gaps gsl-r, gsl-g, and gsl-b where the scattering layer 210 overlaps the light emitting layer EML in a plan view are differently formed for each of the subpixels of the colors and the viewing angles are changed, the color coordinate value of white and changes of colors are changed by a desired (or alternatively, predetermined) level or below, so display quality of the light emitting display device is improved. The thickness t1-1 of the portion of the color filters 230R, 230G, and 230B overlapping the opening OPSL of the scattering layer 210 and the thickness t2-1 of the portion of the color filters 230R, 230G, and 230B overlapping the scattering layer 210 are substantially equivalent to each other, and the color filters 230R, 230G, and 230B transmitting light discharged by the light emitting layer EML have the same thickness, so the displayed images may have improved colors. Substantially the same thickness may indicate generation of the thickness difference of less than 10% when considering processing errors.

Any functional blocks shown in the figures and described above may be implemented in processing circuitry such as hardware including logic circuits, a hardware/software combination such as a processor executing software, or a combination thereof. For example, the processing circuitry more specifically may include, but is not limited to, a central processing unit (CPU), an arithmetic logic unit (ALU), a digital signal processor, a microcomputer, a field programmable gate array (FPGA), a System-on-Chip (SoC), a programmable logic unit, a microprocessor, application-specific integrated circuit (ASIC), etc.

While this disclosure has been described in connection with what is presently considered to be practical example embodiments, it is to be understood that the disclosure is not limited to the disclosed example embodiments, but, on the contrary, is intended to cover various modifications and equivalent arrangements included within the scope of the appended claims.

## Claims

1. A light emitting display device (1000) comprising:
a substrate (110);
an anode on the substrate (110);
a pixel defining layer (380) having a first opening (OP), the first opening (OP) overlapping the anode;
a light emitting layer (EML) within the first opening of the pixel defining layer (380);
a cathode (270) on the light emitting layer (EML) and the pixel defining layer (380);
an encapsulation layer (400) on the cathode (270); and
a scattering layer (210) on the encapsulation layer (400), the scattering layer (210) including scattering particles (211), the scattering layer (210) including a scattering layer opening (OPSL), the scattering layer opening (OPSL) overlapping at least a portion of the first opening (OP) in a plan view,
wherein a gap where the light emitting layer (EML) exposed by the first opening (OP) of the pixel defining layer (380) overlaps the scattering layer (210) in a three-color subpixel.

2. The light emitting display device (1000) of claim 1, wherein
the scattering layer (210) covers a side wall of the pixel defining layer (380) in a plan view.

3. The light emitting display device (1000) of claim 1 or 2, wherein
the scattering layer opening (OPSL) is in the first opening (OP) corresponding thereto in a plan view, and
the first opening corresponding to the scattering layer (210) opening has a same planar shape as the scattering layer (210) opening and a plurality of first openings including the first opening are arranged at regular intervals.

4. The light emitting display device (1000) of any one of the preceding claims, further comprising:
a light blocking layer (220) on the scattering layer (210), the light blocking layer (220) including a second opening (OPBM); and
a color filter (230) within the second opening (OPBM) of the light blocking layer (220).

5. The light emitting display device (1000) of claim 4, further comprising:
a step-removing organic layer (240) below the color filter (230), the step-removing organic layer (240) including a transparent organic material,
wherein the scattering layer opening (OPSL) and the first opening (OP) are within the second opening (OPBM) in a plan view.

6. The light emitting display device (1000) of claim 5,
wherein a first thickness of a first portion of the color filter (230) that overlaps the scattering layer opening (OPSL) in a plan view is equal to a second thickness of a second portion of the color filter (230) that overlaps the first opening (OP) and the scattering layer (210).

7. The light emitting display device (1000) of claims 4 to 6, further comprising
a spacer (385) above the pixel defining layer (380) and below the cathode (270),
wherein the spacer (385) overlaps the light blocking layer (220) in a plan view.

8. The light emitting display device (1000) of any one of the preceding claims, further comprising:
color filters (230B, 230G, 230R) corresponding to different colors, the color filters (230B, 230G, 230R) being on the scattering layer (210),
wherein at least two of the color filters (230B, 230G, 230R) overlap in a light blocking region of the color filters (230B, 230G, 230R), and
one of the color filters (230B, 230G, 230R) is in a second opening (OPCF) of the light blocking region, the second opening (OPCF) overlapping the first opening (OP) in a plan view.

9. The light emitting display device (1000) of claim 8, further comprising:
a step-removing organic layer (240) below the color filters (230B, 230G, 230R), the step-removing organic layer (240) including a transparent organic material,
wherein the scattering layer opening (OPSL) and the first opening (OP) are within the second opening (OPCF) in a plan view.

10. The light emitting display device (1000) of claim 9,
wherein a first thickness of a first portion of each of the color filters (230B, 230G, 230R) that overlaps the scattering layer (210) opening in a plan view and within the second opening (OPCF) is equal to a second thickness of a second portion of each of the color filters (230B, 230G, 230R) that overlaps the first opening (OP) and the scattering layer (210) and is within the second opening (OPCF).

11. The light emitting display device (1000) of claims 8 to 10, further comprising:
a spacer (385) above the pixel defining layer (380) and below the cathode (270),
wherein the spacer (385) overlaps the light blocking region in a plan view.

12. The light emitting display device (1000) of any one of the preceding claims, wherein
a plurality of gaps where the light emitting layer (EML) exposed by the first opening (OP) of the pixel defining layer (380) overlaps the scattering layer (210) in a plan view are same in a three-color subpixel.

13. The light emitting display device (1000) of claims 1 to 12, wherein
a plurality of gaps where the light emitting layer (EML) exposed by the first opening (OP) of the pixel defining layer (380) overlaps the scattering layer (210) in a plan view are different from each other in a three-color subpixel.

14. A light emitting display device (1000) comprising:
a substrate (110);
an anode on the substrate (110);
a pixel defining layer (380) having a first opening (OP), the first opening (OP) overlapping the anode;
a light emitting layer (EML) within the first opening (OP) of the pixel defining layer (380);
a cathode (270) on the light emitting layer (EML) and the pixel defining layer (380);
an encapsulation layer (400) on the cathode (270);
a scattering layer (210) on the encapsulation layer (400), the scattering layer (210) including scattering particles (211), the scattering layer (210) including a scattering layer opening (OPSL), the scattering layer opening (OPSL)overlapping at least a portion of the first opening (OP) in a plan view;
a step-removing organic layer (240) on the scattering layer (210), the step-removing organic layer (240) including a transparent organic material; and
color filters (230) on the step-removing organic layer (240),
wherein a first thickness of a first portion of each of the color filters (230) that overlaps the scattering layer opening (OPSL) in a plan view is equal to a second thickness of a second portion of each of the color filters (230) that overlaps the first opening (OP) and the scattering layer (210) in a plan view.

15. The light emitting display device of claim 14, further comprising
a light blocking layer (220) above the scattering layer (210) and below the color filters (230), the light blocking layer (220) including a second opening (OPBM),
wherein one of the color filters (230) overlaps the second opening (OPBM) of the light blocking layer (220) in a plan view,
the scattering layer opening (OPSL) is within the first opening (OP) in a plan view, and
the scattering layer opening (OPSL) and the first opening (OP) are within the second opening (OPBM) in a plan view.
